# EUROPEAN PATENT APPLICATION

(11) **EP 4 502 009 A1**
(43) Date of publication of application: **05.02.2025**
(21) Application number: 23780074.3
(22) Date of filing: 23.03.2023
(51) Int. Cl.: C08G 73/10, B32B 27/34, C08F 2/44, C08F 283/04, C08F 290/14, G03F 7/004, G03F 7/027, G03F 7/20, G03F 7/40, H01L 21/312

(54) **RESIN COMPOSITION, CURED PRODUCT, LAMINATE, METHOD FOR PRODUCING CURED PRODUCT, METHOD FOR PRODUCING LAMINATE, METHOD FOR PRODUCING SEMICONDUCTOR DEVICE, AND SEMICONDUCTOR DEVICE**

(30) Priority: 29.03.2022 JP 2022053724
(71) Applicant: FUJIFILM Corporation, Tokyo 106-8620 (JP)
(72) Inventor: OOTA, Kazuya, Haibara-gun, Shizuoka 421-0396 (JP); NOZAKI, Atsuyasu, Haibara-gun, Shizuoka 421-0396 (JP); OGAWA, Michihiro, Haibara-gun, Shizuoka 421-0396 (JP); DAIKUHARA, Kenji, Haibara-gun, Shizuoka 421-0396 (JP)
(74) Representative: HGF
(86) International application number: PCT/JP2023/011593
(87) International publication number: WO 2023/190064

(57) **Abstract**

There is provided a resin composition containing a polyimide or a polyimide precursor, where a cured substance obtained from the resin composition satisfies all of the following conditions (i) to (iv), and are provided a cured substance, a laminate, a manufacturing method for a cured substance, a manufacturing method for a laminate, a manufacturing method for a semiconductor device, and a semiconductor device; condition (i): a Young's modulus of the cured substance is 3.5 GPa or more, condition (ii): a coefficient of thermal expansion of the cured substance in a temperature range of 25°C to 125°C is less than 50 ppm/°C, condition (iii): a Tg of the cured substance is 240°C or higher, and condition (iv): a breaking elongation of the cured substance is 40% or more.

## Description

### BACKGROUND OF THE INVENTION

### 1. Field of the Invention

The present invention relates to a resin composition, a cured substance, a laminate, a manufacturing method for a cured substance, a manufacturing method for a laminate, a manufacturing method for a semiconductor device, and a semiconductor device.

### 2. Description of the Related Art

In recent years, a resin material that has been produced from a resin composition containing a resin has been utilized in various fields.

For example, a polyimide is applied to various use applications since it has an excellent heat resistance and insulating properties. The above-described use applications are not particularly limited, and examples thereof in a semiconductor device for mounting include the use as a material of an insulating film or sealing material, or as a protective film. In addition, such a resin can also be used as a base film or a cover lay for a flexible substrate.

For example, in the above-described use applications, the polyimide is used in a form of a resin composition containing a polyimide or a polyimide precursor.

Such a resin composition is applied onto a base material by coating or the like to form a photosensitive film, and then, as necessary, subjected to exposure, development, or heating, whereby a cured substance can be formed on the base material.

The polyimide precursor is cyclized by, for example, heating, and it becomes a polyimide during curing.

Since the resin composition can be applied by a publicly known coating method or the like, it can be said that the resin composition is excellent in the manufacturing adaptability, for example, a high degree of freedom in designing the shape, size, application position of the resin composition to be applied. From the viewpoint of such excellent manufacturing adaptability in addition to the high performance possessed by the polyimide, the industrial application and development of the above-described resin composition are expected increasingly.

JP2021-173787A discloses a resin composition characterized by containing (A) a polyimide precursor, (B) a photopolymerization initiator, (C) a photopolymerizable substance, and (D) a solvent, where the polyimide precursor has a specific structure, the solvent is selected from at least one of γ-butyrolactone, dimethyl sulfoxide, or 3-methoxy-N,N-dimethylpropionamide, and a development time increase rate is 130% or more and less than 200%, where the development time increase rate is represented by the following numerical expression (S1): $Development time increase rate \left(%\right) = \left(DT48/DT2\right) \times 100$ (in the expression, DT2 and DT48 indicate times taken until the resin composition is applied onto a silicon wafer to form a coating film, a baking treatment is carried out at 110°C for 240 seconds, the coating film is subsequently allowed to stand for 2 hours and 48 hours and then completely dissolved at 23°C using cyclopentanone as a developer; it is noted that in the coating film forming step, it is assumed that a film thickness after the baking treatment is 10.5 µm).

### SUMMARY OF THE INVENTION

A resin composition for obtaining a cured substance is required to have excellent thermal cycle test (TCT) crack resistance in a cured substance that is obtained from this composition.

The phrase "excellent in TCT crack resistance" means that cracking is unlikely to occur between a cured substance and a base material even after a severe TCT test (for example, repetition of -55°C and 200°C for 1,000 cycles).

An object of the present invention is to provide a resin composition from which a cured substance having excellent TCT crack resistance can be obtained, a cured substance obtained by curing the resin composition, a laminate including the cured substance, a manufacturing method for the cured substance, a manufacturing method for the laminate, a manufacturing method for a semiconductor device including the manufacturing method for the laminate, and a semiconductor device including the cured substance or the laminate.

Examples of representative embodiments according to the present invention are described below.
<1> A resin composition comprising:
   a polyimide or a polyimide precursor,
   in which a film-shaped cured substance having a thickness of 15 µm, which is obtained by heating the resin composition at 230°C for 3 hours, satisfies all of the following condition (i) to condition (iv),
   condition (i): a Young's modulus of the cured substance is 3.5 GPa or more,
   condition (ii): a coefficient of thermal expansion of the cured substance in a temperature range of 25°C to 125°C is less than 50 ppm/°C,
   condition (iii): a glass transition temperature of the cured substance is 240°C or higher, and
   condition (iv): a breaking elongation of the cured substance is 40% or more.
<2> The resin composition according to <1>, in which the cured substance satisfies all of the following condition (v) to condition (viii),
   condition (v): the Young's modulus of the cured substance is 4.5 GPa or more,
   condition (vi): the coefficient of thermal expansion of the cured substance in a temperature range of 25°C to 125°C is less than 40 ppm/°C,
   condition (vii): the glass transition temperature of the cured substance is 260°C or higher, and
   condition (viii): the breaking elongation of the cured substance is 50% or more.
<3> The resin composition according to <1> or <2>, further comprising:
   a metal complex having a π-conjugated moiety containing a nitrogen atom.
<4> The resin composition according to any one of <1> to <3>, in which the polyimide precursor contains a repeating unit represented by Formula (1), 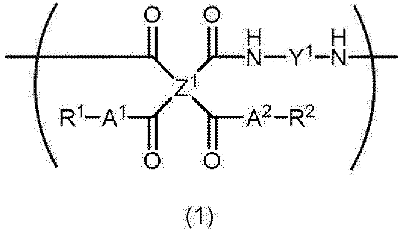 in Formula (1), Z¹ is a tetravalent organic group that includes two or more ether groups and an aromatic ring structure, Y¹ is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.
<5> A resin composition comprising:
   a polyimide precursor containing a repeating unit represented by Formula (1); and
   a metal complex having a π-conjugated moiety containing a nitrogen atom, 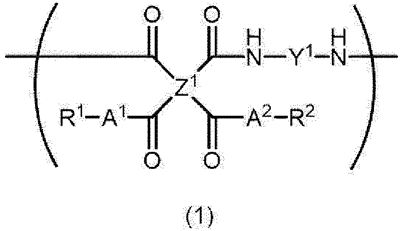 in Formula (1), Z¹ is a tetravalent organic group that includes two or more ether groups and an aromatic ring structure, Y¹ is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.
<6> The resin composition according to <4> or <5>, in which Z¹ in Formula (1) is a group represented by Formula (a) or Formula (b), 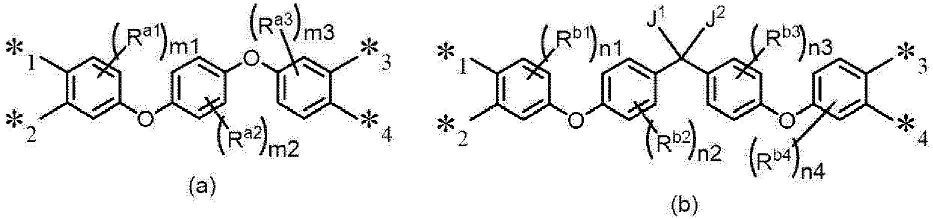
   in Formula (a), R^{a1}'s each independently represent a monovalent group, m1 represents an integer of 0 to 3, R^{a2}'s each independently represent a monovalent group, m2 represents an integer of 0 to 4, R^{a3}'s each independently represent a monovalent group, m3 represents an integer of 0 to 3, and *1 to *4 each represent a bonding site to a carbonyl group in Formula (1),
   in Formula (b), R^{b1}'s each independently represent a monovalent group, n1 represents an integer of 0 to 3, R^{b2}'s each independently represent a monovalent group, n2 represents an integer of 0 to 4, R^{b3}'s each independently represent a monovalent group, n3 represents an integer of 0 to 4, R^{b4}'s each independently represent a monovalent group, n4 represents an integer of 0 to 3, J¹ and J² each independently represent a hydrogen atom, an alkyl group, or a trifluoromethyl group, and *1 to *4 each represent a bonding site to a carbonyl group in Formula (1).
<7> The resin composition according to any one of <4> to <6>, in which Y¹ in Formula (1) is a divalent organic group represented by Formula (Y-1), 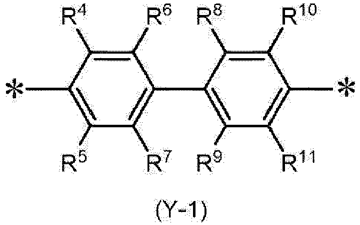 in Formula (Y-1), R⁴ to R¹¹ each independently represent a hydrogen atom or a monovalent group, at least one of R⁴, ..., or R¹¹ is an alkyl group, a fluorine atom, a trifluoromethyl group, or an alkoxy group, R⁶ and R⁸, or R⁷ and R⁹ may be bonded to each other to form a ring structure, and *'s each represent a bonding site to a nitrogen atom in Formula (1).
<8> The resin composition according to <3> or <5>, in which the metal complex includes a partial structure represented by Formula (1-1) as a structure including the π-conjugated moiety containing the nitrogen atom, 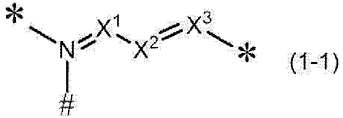 in Formula (1-1), X¹ to X³ each independently represent -C(-*)= or -N=, *'s each represent a bonding site to another structure, and # represents a bonding site to a metal atom.
<9> The resin composition according to any one of <1> to <8>, in which a weight-average molecular weight of the polyimide precursor is 40,000 or more.
<10> The resin composition according to any one of <1> to <9>, further comprising:
   a polymerizable compound; and
   a photopolymerization initiator.
<11> The resin composition according to any one of <1> to <10>, in which the resin composition is used for forming an interlayer insulating film for a re-distribution layer.
<12> A cured substance that is obtained by curing the resin composition according to any one of <1> to <11>.
<13> A laminate comprising:
   two or more layers consisting of the cured substance according to <12>; and
   a metal layer provided between any of the layers consisting of the cured substance.
<14> A manufacturing method for a cured substance, comprising:
   a film forming step of applying the resin composition according to any one of <1> to <11> onto a base material to form a film.
<15> The manufacturing method for a cured substance according to <14>, further comprising:
   an exposure step of selectively exposing the film; and
   a development step of developing the film using a developer to form a pattern.
<16> The manufacturing method for a cured substance according to <14> or <15>, further comprising:
   a heating step of heating the film at 50°C to 450°C.
<17> A manufacturing method for a laminate, comprising:
   the manufacturing method for a cured substance according to any one of <14> to <16>.
<18> A manufacturing method for a semiconductor device, comprising:
   the manufacturing method for a cured substance according to any one of <14> to <16>; or
   the manufacturing method for a laminate according to <17>.
<19> A semiconductor device comprising:
   the cured substance according to <12>; or
   the laminate according to <13>.
<20> A cured substance that satisfies all of the following condition (i) to condition (iv);
   condition (i): a Young's modulus of the cured substance is 3.5 GPa or more,
   condition (ii): a coefficient of thermal expansion of the cured substance in a temperature range of 25°C to 125°C is less than 50 ppm/°C,
   condition (iii): a glass transition temperature of the cured substance is 240°C or higher, and
   condition (iv): a breaking elongation of the cured substance is 40% or more.
<21> A semiconductor device comprising:
   a semiconductor chip; and
   a re-distribution layer,
   in which the re-distribution layer includes a wiring line and an interlayer insulating film for a re-distribution layer, the interlayer insulating film satisfying all of the following condition (i) to condition (iv),
   condition (i): a Young's modulus of the interlayer insulating film for a re-distribution layer is 3.5 GPa or more,
   condition (ii): a coefficient of thermal expansion of the interlayer insulating film for a re-distribution layer in a temperature range of 25°C to 125°C is less than 50 ppm/°C,
   condition (iii): a glass transition temperature of the interlayer insulating film for a re-distribution layer is 240°C or higher, and
   condition (iv): a breaking elongation of the interlayer insulating film for a re-distribution layer is 40% or more.
<22> The semiconductor device according to <21>, further comprising:
   a sealing material that covers the semiconductor chip,
   in which an area of the re-distribution layer in planar view is larger than an area of the semiconductor chip.

According to the present invention, there is provided a resin composition from which a cured substance having excellent TCT crack resistance can be obtained, and are provided a cured substance obtained by curing the resin composition, a laminate including the cured substance, a manufacturing method for the cured substance, a manufacturing method for the laminate, a manufacturing method for a semiconductor device including the manufacturing method for the laminate, and a semiconductor device including the cured substance or the laminate.

### BRIEF DESCRIPTION OF THE DRAWINGS

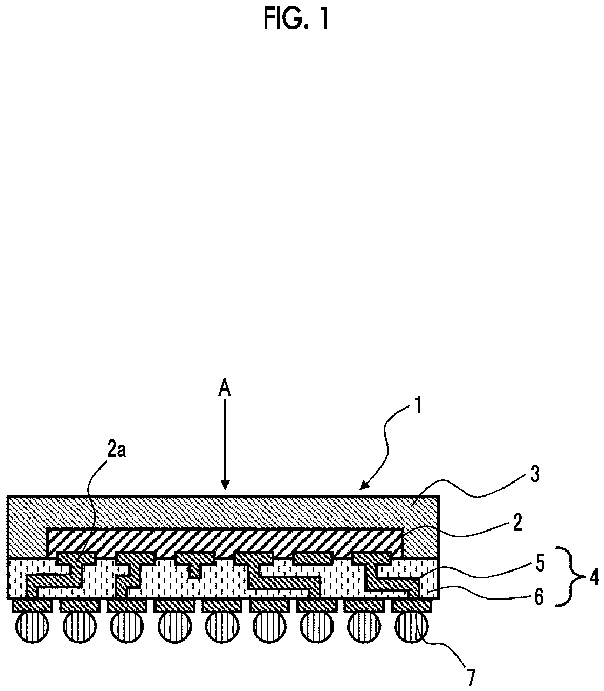

Fig. 1 is an example of a semiconductor device according to a second aspect of the present invention.

### DESCRIPTION OF THE PREFERRED EMBODIMENTS

Hereinafter, the main embodiments of the present invention will be described. However, the present invention is not limited to the specified embodiments.

In the present specification, a numerical value range described by using "to" means a range including numerical values described before and after the preposition "to" as a lower limit value and an upper limit value, respectively.

In the present specification, the term "step" means not only an independent step but also a step that cannot be clearly distinguished from other steps as long as the desired action of the step can be achieved.

In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

In the present specification, the "exposure" includes not only exposure using light but also exposure using corpuscular beams such as an electron beam and an ion beam, unless otherwise specified. In addition, examples of the light that is used for exposure include an actinic ray such as a bright line spectrum of a mercury lamp, a far ultraviolet ray represented by an excimer laser, an extreme ultraviolet ray (EUV light), an X-ray, or an electron beam, and a radioactive ray.

In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".

In the structural formulae of the present specification, Me represents a methyl group, Et represents an ethyl group, Bu represents a butyl group, and Ph represents a phenyl group.

In the present specification, the total solid content refers to the total mass of components excluding a solvent from the entire components of the composition. In addition, in the present specification, the concentration of solid contents is a mass percentage of other components excluding a solvent with respect to the total mass of the composition.

In the present specification, weight-average molecular weight (Mw) and number average molecular weight (Mn) are each a value measured using gel permeation chromatography (GPC) unless otherwise specified, which are defined as a polystyrene equivalent value. In the present specification, the weight-average molecular weight (Mw) and the number average molecular weight (Mn) can be determined, for example, by using HLC-8220 GPC(manufactured by Tosoh Corporation) and using GUARD COLUMN HZ-L, TSKgel Super HZM-M, TSKgel Super HZ4000, TSKgel Super HZ3000, and TSKgel Super HZ2000 (all of which are manufactured by Tosoh Corporation) as a column connected in series. The molecular weights thereof are measured using N-methyl-2-pyrrolidone (NMP) as an eluant unless otherwise specified. In addition, the detection in GPC measurement is carried out using a detector with an ultraviolet ray (a UV ray) of a wavelength of 254 nm unless otherwise specified.

In the present specification, in a case where the positional relationship of respective layers constituting the laminate is described as "upper" or "lower", it suffices that another layer is on the upper side or the lower side of the reference layer among the plurality of layers of interest. That is, a third layer or element may be further interposed between the reference layer and the other layer, and the reference layer and the other layer need not be in contact with each other. Unless otherwise specified, the direction in which the layers are laminated on the base material is referred to as "upward", or in a case where a resin composition layer is present, the direction from the base material to the resin composition layer is referred to as "upper". The opposite direction thereof is referred to as "downward". Furthermore, such a setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise specified. The content of each component in the composition means the total content of all the compounds corresponding to the component unless otherwise specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

### (Resin composition)

A resin composition according to a first aspect of the present invention (hereinafter, also referred to as a "first resin composition") is a resin composition containing a polyimide or a polyimide precursor, where a film-shaped cured substance having a thickness of 15 µm, which is obtained by heating the resin composition at 230°C for 3 hours, satisfies all of the following condition (i) to condition (iv).

Condition (i): A Young's modulus of the cured substance is 3.5 GPa or more.

Condition (ii): A coefficient of thermal expansion of the cured substance in a temperature range of 25°C to 125°C is less than 50 ppm/°C.

Condition (iii): A glass transition temperature of the cured substance is 240°C or higher.

Condition (iv): A breaking elongation of the cured substance is 40% or more.

A resin composition according to a second aspect of the present invention (hereinafter, also referred to as a "second resin composition") contains a polyimide precursor containing a repeating unit represented by Formula (1), and a metal complex having a π-conjugated moiety containing a nitrogen atom. 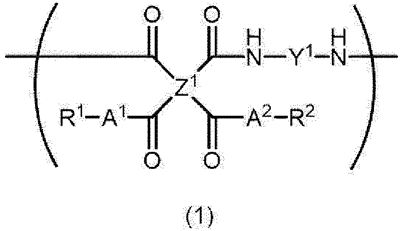 in Formula (1), Z¹ is a tetravalent organic group that includes two or more ether groups and an aromatic ring structure, Y¹ is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.

Hereinafter, the resin composition according to the first aspect of the present invention and the resin composition according to the second aspect of the present invention will be also referred to as "the resin composition according to the embodiment of the present invention" or simply "the resin composition".

The resin composition according to the embodiment of the present invention is preferably used for forming a photosensitive film that is subjected to exposure and development, and it is preferably used for forming a film that is subjected to exposure and development using a developer containing an organic solvent.

The resin composition according to the embodiment of the present invention can be used, for example, for forming an insulating film of a semiconductor device, an interlayer insulating film for a re-distribution layer, or a stress buffer film, and it is preferably used for forming an interlayer insulating film for a re-distribution layer.

In particular, one of the preferred aspects of the present invention is that the resin composition according to the embodiment of the present invention is used for forming an interlayer insulating film for a re-distribution layer.

In addition, the resin composition according to the embodiment of the present invention is preferably used for forming a photosensitive film that is subjected to negative-tone development.

In the present invention, the negative-tone development refers to development in which, in exposure and development, a non-exposed portion is removed by the development, and the positive-tone development means a development in which an exposed portion is removed by the development.

As the exposure method, the developer, and the development method, for example, the following ones in the description of the manufacturing method for a cured substance, which will be described later, are used: an exposure method to be described in the exposure step, and a developer and a development method to be described in the development step.

According to the resin composition according to the embodiment of the present invention, a cured substance having excellent TCT crack resistance can be obtained.

Although the mechanism by which the above effect is obtained is not revealed, it is presumed as follows.

The first resin composition according to the embodiment of the present invention is a composition from which a cured substance satisfying all of a high Young's modulus, a low coefficient of thermal expansion (CTE), a high glass transition temperature (Tg), and a high breaking elongation can be obtained.

It was found that a cured substance obtained from such a first resin composition is excellent in reliability since the occurrence of cracking is suppressed even in a severe TCT test.

In a case where the Young's modulus of the cured substance is high, it is considered that the film hardness itself is high and thus cracking is unlikely to occur.

In a case where the CTE of the cured substance is low, the CTE of the cured substance is close to the CTE of the base material such as silicon or the copper wiring line. Therefore, it is considered that a difference in expansion coefficient with respect to a temperature change is small, and thus cracking is unlikely to occur.

In a case where the Tg of the cured substance is high, a change in the composition of the cured substance due to a temperature change is suppressed, and for example, a component that volatilizes from the cured substance is also unlikely to come out of the cured substance. Therefore, it is considered that the generation of a portion having a weak strength in the cured substance is suppressed, and thus cracking is unlikely to occur.

In a case where the breaking elongation is large, it is considered that the cured substance itself, the base material, the wiring line, and the like are easily followed by deformation due to a temperature change, and thus cracking is unlikely to occur.

That is, it is presumed that a cured substance having excellent TCT crack resistance can be obtained by the synergistic effect of the four conditions of the high Young's modulus, the low CTE, the high Tg, and the high breaking elongation.

In addition, the polyimide precursor contained in the second resin composition has a tetravalent organic group that includes two or more ether groups and an aromatic ring structure at the position of Z¹ in Formula (1). Since the above structure is a flexible structure, it is considered that a cured substance to be obtained has excellent breaking elongation (breaking elongation is large).

Further, the second resin composition contains a metal complex having a π-conjugated moiety containing a nitrogen atom. As a result, the glass transition temperature of the cured substance is further increased, and the adhesiveness between the film and the base material is improved.

Therefore, it is presumed that a cured substance having excellent TCT crack resistance can be obtained.

Here, neither the first resin composition nor the second resin composition according to the embodiment of the present invention is described in JP2021-173787A.

Hereinafter, the resin composition according to the embodiment of the present invention will be described in detail.

### <Condition (i) to condition (iv)>

A film-shaped cured substance having a thickness of 15 µm, which is obtained by heating the first resin composition according to the embodiment of the present invention at 230°C for 3 hours, satisfies the following condition (i) to condition (iv).

It is preferable that a film-shaped cured substance having a thickness of 15 µm, which is obtained by heating the second resin composition according to the embodiment of the present invention at 230°C for 3 hours, satisfies the following condition (i) to condition (iv).

Condition (i): A Young's modulus of the cured substance is 3.5 GPa or more.

Condition (ii): A coefficient of thermal expansion of the cured substance in a temperature range of 25°C to 125°C is less than 50 ppm/°C.

Condition (iii): A glass transition temperature of the cured substance is 240°C or higher.

Condition (iv): A breaking elongation of the cured substance is 40% or more.

Here, a film-shaped cured substance having a thickness of 15 µm, which is obtained by heating the resin composition according to the embodiment of the present invention at 230°C for 3 hours, is preferably obtained by applying the resin composition according to the embodiment of the present invention onto a base material to form a resin composition layer and then carrying out heating at 230°C for 3 hours.

The above-described base material is preferably a base material that is described in a manufacturing method for a cured substance according to an embodiment of the present invention described later, and examples thereof include a silicon wafer.

Examples of the applying method for the above-described resin composition include an applying method described in a film forming step in the manufacturing method for a cured substance according to the embodiment of the present invention described later, and from the viewpoint that the thickness is easily adjusted and the thickness is easily made to be uniform, a spin coating method or a slit coating method is preferable, and a spin coating method is more preferable. In addition, the applying method may be determined in consideration of the viscosity of the resin composition, physical properties of components to be contained, and the like.

The above-described resin composition layer may be dried before heating. Examples of the drying method include an applying method described in a heating step in the manufacturing method for a cured substance according to the embodiment of the present invention described later.

It is preferable to carry out drying before heating, particularly in a case where the above-described resin composition contains a solvent.

The drying is preferably carried out at a temperature of, for example, 50°C to 150°C. The above-described temperature is more preferably 70°C to 130°C and still more preferably 90°C to 110°C. For example, the drying can be carried out at 100°C.

In addition, the drying may be carried out under reduced pressure; however, it is preferable to carry out the drying under atmospheric pressure.

The drying means is not particularly limited, and for example, a publicly known heating means can be used; however, a hot plate is preferably used.

The above-described resin composition layer becomes a cured substance that is cured by being heated at 230°C for 3 hours. Examples of the heating method include a heating method described in a drying step in the manufacturing method for a cured substance according to the embodiment of the present invention described later.

The temperature rising rate in the heating is such that the heating is preferably carried out at a temperature rising rate of 1 to 12 °C/min. The temperature rising rate is more preferably 2 to 10 °C/min and still more preferably 3 to 10 °C/min. For example, the heating can be carried out at 10°C/min.

The heating can be carried out in an atmosphere having an oxygen concentration of 100 ppm or less by, for example, allowing an inert gas such as nitrogen, helium, or argon to flow, or carrying out the heating under reduced pressure. It can be carried out by setting the oxygen concentration to 100 ppm or less in a nitrogen atmosphere.

The heating means in the heating step is not particularly limited; however, examples thereof include a hot plate, an infrared furnace, an electric heating oven, a hot air oven, and an infrared oven. The heating can be carried out, for example, with an electric heating oven.

In a case where the resin composition according to the embodiment of the present invention is applied onto a base material to form a resin composition layer, it is preferable that the cured substance obtained after the heating is peeled from the base material.

The peeling method is not particularly limited: however, it is preferable to carrying out peeling by immersion in an aqueous solution of an acid. For example, the cured substance and the base material are immersed in a 4.9% by mass aqueous hydrofluoric acid solution to carry out peeling.

The shape and size of the cured substance are not particularly limited: however, the cured substance can have, for example, a dumbbell shape having a specimen width of 2 mm and a specimen length of 35 mm. The dumbbell shape can be set to, for example, a dumbbell-shape No. 7 shape, which is described in JIS K 6251: 2017.

In addition, in order to obtain a cured substance having a specific shape and size, the above-described resin composition may be subjected to exposure and development. The exposure method and the development method may be determined according to the composition; however, examples thereof include an exposure method and a development method, respectively, which are described in an exposure step and a development step in the manufacturing method for a cured substance according to the embodiment of the present invention described later.

In addition, it is also preferable to obtain a cured substance having a desired shape and size by carrying out punching or the like with a puncher or the like.

In the condition (i), the Young's modulus of the cured substance is preferably 4.0 GPa or more and more preferably 4.5 GPa or more. The upper limit of the Young's modulus is not particularly limited; however, it is, for example, preferably 6.5 GPa or less.

The Young's modulus can be measured according to the method of Japanese Industrial Standards (JIS)-K7161-1 (2014).

The Young's modulus can be measured, for example, in an environment of 25°C and a relative humidity (RH) of 65%.

In addition, the Young's modulus can be measured using a publicly known dynamic viscoelasticity measuring device or a device similar to the publicly known dynamic viscoelasticity measuring device. Examples of such a device include DMA850 (TA Instruments).

A test speed (crosshead speed) in a case of measuring the Young's modulus can be set to, for example, 5 mm/min.

In addition, the Young's modulus can be measured, for example, according to a method described in Examples which will be described later.

In the condition (ii), the coefficient of thermal expansion (CTE) of the cured substance in a temperature range of 25°C to 125°C is preferably less than 45 ppm/°C and more preferably less than 40 ppm/°C. The lower limit of the coefficient of thermal expansion is not particularly limited; however, it is preferably, for example, 15 ppm/°C or more.

The coefficient of thermal expansion can be measured using a publicly known thermomechanical analysis device or a measuring device for a coefficient of thermal expansion, or a device similar to the publicly known thermomechanical analysis device or a measuring device for a coefficient of thermal expansion. Examples of such a device include TMA450 (TA Instruments).

The temperature rising and falling conditions at the time of evaluation can be set, for example, as described in the following (1) to (4).
(1) The temperature is raised from room temperature to 130°C at a temperature rising rate of 5 °C/min.
(2) The temperature is allowed to fall from 130°C to 10°C at a temperature-lowering rate of 5 °C/min.
(3) The temperature is raised from 10°C to 220°C at a temperature rising rate of 5 °C/min.
(4) Natural cooling is carried out to room temperature.

In the above-described temperature rising and falling processes (1) to (4), the elongation (displacement) of the specimen is measured, and a calculation is carried out to determine a value obtained by dividing the elongation (displacement) of the specimen at 25°C and 125°C in the process (3) by the temperature, where the value is defined as the coefficient of thermal expansion.

(Example: In a case where the length of the specimen at 25°C is 50 mm, and the length of the specimen at 125°C is 50.2 mm, the displacement is calculated as 0.4% = 4,000 ppm, and the coefficient of thermal expansion is calculated as 4,000/(125 - 25) = 40 ppm/°C.)

In addition, the coefficient of thermal expansion can be measured according to a method described in Examples which will be described later.

In the condition (iii), the glass transition temperature (Tg) of the cured substance is preferably 250°C or higher and more preferably 260°C or higher. The lower limit of the glass transition temperature is not particularly limited; however, it is, for example, preferably 350°C or lower.

The glass transition temperature can be measured using a publicly known thermomechanical analysis device or a measuring device for a coefficient of thermal expansion or a device similar to the publicly known thermomechanical analysis device or a measuring device for a coefficient of thermal expansion. Examples of such a device include DMA850 (TA Instruments).

Specifically, the temperature conditions of the cured substance are changed in the order of the following (1) and (2), and the glass transition temperature is measured.
(1) The temperature is raised from 25°C to 350°C at a rate of 5°C/min.
(2) Cooling is carried out from 350°C to 25°C.

In addition, the glass transition temperature can be measured according to a method described in Examples which will be described later.

In the condition (iv), the breaking elongation of the above-described cured substance is preferably 45% or more and more preferably 50% or more. The upper limit of the temperature is not particularly limited; however, it is, for example, preferably 150% or less.

The breaking elongation rate can be measured according to the method of JIS-K7161-1 (2014).

The breaking elongation can be measured, for example, in an environment of 25°C and a relative humidity (RH) of 65%.

The breaking elongation can be measured using a publicly known tensile tester or a device similar to the publicly tensile tester. Examples of such a device include a tensile tester (manufactured by Instron, model: 5965).

The test speed (crosshead speed) in a case of measuring the breaking elongation can be set to, for example, 5 mm/min.

The breaking elongation is measured according to a method described in Examples, which will be described later.

Here, it is preferable that a film-shaped cured substance having a thickness of 15 µm, which is obtained by heating the resin composition according to the embodiment of the present invention at 230°C for 3 hours, satisfies the following condition (v) to condition (viii).

Condition (v): The Young's modulus of the cured substance is 4.5 GPa or more.

Condition (vi): The coefficient of thermal expansion of the cured substance in a temperature range of 25°C to 125°C is less than 40 ppm/°C.

Condition (vii): The glass transition temperature of the cured substance is 260°C or higher.

Condition (viii): The breaking elongation of the cured substance is 50% or more.

### <Polyimide or polyimide precursor>

The first resin composition according to the embodiment of the present invention contains a polyimide or a polyimide precursor, and preferably contains a polyimide precursor. The polyimide precursor preferably contains a repeating unit represented by Formula (1). In addition, the polyimide preferably contains a repeating unit represented by Formula (P1) described later.

The second resin composition according to the embodiment of the present invention contains a polyimide precursor containing a repeating unit represented by Formula (1).

Hereinafter, the polyimide and the polyimide precursor will be collectively described as a "specific resin". 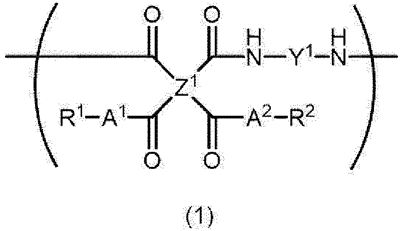 in Formula (1), Z¹ is a tetravalent organic group that includes two or more ether groups and an aromatic ring structure, Y¹ is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.

### [A¹ and A²]

A¹ and A² in Formula (1) each independently represent an oxygen atom or -NR^{Z}-, and an oxygen atom is preferable.

R^{Z} represents a hydrogen atom or a monovalent organic group, and a hydrogen atom is preferable.

In a case where R^{Z} is a monovalent organic group, examples of R^{Z} include a hydrocarbon group.

In addition, in a case where A¹ is -NR^{Z}-, R^{Z} may be bonded to R¹ to form a ring structure. Examples of the ring structure to be formed include a hydrocarbon ring, where an aliphatic hydrocarbon ring is preferable, and a saturated aliphatic hydrocarbon ring is more preferable. In addition, the above-described ring structure is preferably a 5-membered ring or a 6-membered ring.

In a case where A² is -NR^{Z}-, R^{Z} may be bonded to R² to form a ring structure. A preferred aspect of the ring structure to be formed is the same as the preferred aspect of the ring structure that is formed by the bonding of R^{Z} and R¹ described above.

### [R¹ and R²]

In Formula (1), R¹ and R² each independently represent a hydrogen atom or a monovalent organic group, and at least one of R¹ or R² is a monovalent organic group having an ethylenically unsaturated bond.

An aspect in which both R¹ and R² are a monovalent organic group having an ethylenically unsaturated bond is also one of the preferred aspects of the present invention.

The monovalent organic group having an ethylenically unsaturated bond is preferably a vinyl group, an allyl group, an isoallyl group, a 2-methylallyl group, a group (for example, a vinylphenyl group) having an aromatic ring that is directly bonded to a vinyl group, a (meth)acrylamide group, a group having a (meth)acryloyloxy group, or a group represented by Formula (III), and it is more preferably a group having a group represented by Formula (III). In addition, an aspect in which the monovalent organic group having an ethylenically unsaturated bond is a group represented by Formula (III) is also one of the preferred aspects of the present invention.

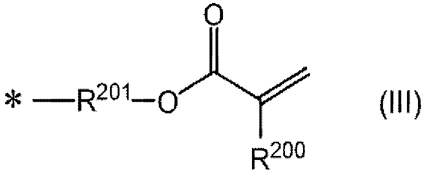

In Formula (III), R²⁰⁰ represents a hydrogen atom, a methyl group, an ethyl group, or a methylol group, where a hydrogen atom or a methyl group is preferable.

In Formula (III), * represents a bonding site to another structure.

In Formula (III), R²⁰¹ represents an alkylene group having 2 to 12 carbon atoms, -CH₂CH(OH)CH₂-, a cycloalkylene group, or a polyalkyleneoxy group.

Suitable examples of R²⁰¹ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, -CH₂CH(OH)CH₂-, and a polyalkyleneoxy group, where an alkylene group such as an ethylene group or a propylene group, -CH₂CH(OH)CH₂-, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a randomly arranged sequence, may be a sequence arranged to have a block, or may be a sequence arranged to have an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even more preferably 2 to 5, even still more preferably 2 to 4, even further still more preferably 2 or 3, and particularly preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polyethyleneoxy group or a polypropyleneoxy group, and still more preferably a polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (1), in a case where R¹ is a hydrogen atom, or in a case where R² is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

In Formula (1), one of R¹ and R² may be a monovalent organic group that does not have an ethylenically unsaturated bond.

The monovalent organic group that does not have an ethylenically unsaturated bond is preferably a hydrocarbon group, a heterocyclic group, or a group represented by a combination of at least one of a hydrocarbon group or a heterocyclic group with -O-, -C(=O)-, -S-, -SO₂-, or -NR^{N}-, more preferably a hydrocarbon group or a group represented by a combination of a hydrocarbon group with -O-, and more preferably an alkyl group, an aromatic hydrocarbon group, or a polyalkyleneoxy group. R^{N} represents a hydrogen atom or a hydrocarbon group, and it is preferably a hydrogen atom or an alkyl group, more preferably a hydrogen atom or a methyl group, and still more preferably a hydrogen atom. R^{N} represents a hydrogen atom or a monovalent organic group, and it is preferably a hydrogen atom, a hydrocarbon group, or an aromatic group, more preferably a hydrogen atom or an alkyl group, and still more preferably a hydrogen atom.

In the present specification, in a case where an alkyl group is simply described, the alkyl group includes a linear alkyl group, a branched alkyl group, and a cyclic alkyl group. The same applies to an alkylene group, an aliphatic hydrocarbon group, and the like.

### [Z¹]

In Formula (1), Z¹ is a tetravalent organic group that includes two or more ether groups and an aromatic ring structure.

Here, the ether group is a divalent group represented by *-O-*, where both *'s are a group that is bonded to a hydrocarbon group.

An aspect in which both ends of the two ether groups in Z¹ are directly bonded to an aromatic ring structure is also one of the preferred aspects of the present invention.

In the present invention, the description that A and B are directly bonded to each other refers to that A and B are bonded to each other without including a linking group between A and B.

The number of ether groups in Z¹ is preferably 2 to 6, more preferably 2 to 4, still more preferably 2 or 3, and particularly preferably 2.

In addition, it is preferable that the above-described ether bond is present on the main chain of the resin.

In the present invention, the term "main chain" represents the relatively longest bonding chain in a resin molecule, and the term "side chain" refers to other bonding chains other r than the main chain. In addition, in the present invention, the description that a certain structure is present on the main chain refers to that the main chain is linked by the certain structure, and the main chain is fragmented in a case where the certain structure is removed.

The aromatic ring structure in Z¹ may be an aromatic hydrocarbon ring structure or an aromatic heterocyclic structure; however, it is preferably an aromatic hydrocarbon ring structure.

The above-described aromatic hydrocarbon ring structure is preferably an aromatic hydrocarbon ring structure having 6 to 20 carbon atoms, more preferably an aromatic hydrocarbon ring structure having 6 to 10 carbon atoms, and still more preferably a benzene ring structure.

The above-described aromatic heterocyclic structure is preferably a 5-membered ring structure, a 6-membered ring structure, or a ring structure represented by a combination thereof, and more preferably a 6-membered ring structure. Examples of the heteroatom in the aromatic heterocyclic structure include an oxygen atom, a nitrogen atom, and a sulfur atom.

In addition, the number of benzene ring structures included in Z¹ is preferably 1 to 6 and more preferably 1 to 4.

It is also preferable that Z¹ has 3 or more benzene ring structures. In the above aspect, the number of benzene ring structures is preferably 3 to 6, more preferably 3 to 5, and still more preferably 3 or 4.

In addition, the aromatic ring structure may have a publicly known substituent. Examples of the substituent include an alkyl group, a halogen atom, and an alkyl group in which a hydrogen atom is substituted with a halogen atom.

In addition, it is preferable that the above-described aromatic ring structure is present on the main chain of the resin.

It is preferable that Z¹ is a structure represented by Formula (a) or Formula (b).

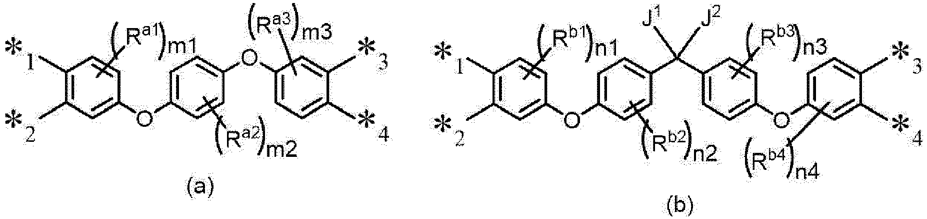

In Formula (a), R^{a1}'s each independently represent a monovalent group, m1 represents an integer of 0 to 3, R^{a2}'s each independently represent a monovalent group, m2 represents an integer of 0 to 4, R^{a3}'s each independently represent a monovalent group, m3 represents an integer of 0 to 3, and * 1 to *4 each represent a bonding site to a carbonyl group in Formula (1).

In Formula (b), R^{b1}'s each independently represent a monovalent group, n1 represents an integer of 0 to 3, R^{b2}'s each independently represent a monovalent group, n2 represents an integer of 0 to 4, R^{b3}'s each independently represent a monovalent group, n3 represents an integer of 0 to 4, R^{b4}'s each independently represent a monovalent group, n4 represents an integer of 0 to 3, J¹ and J² each independently represent a hydrogen atom, an alkyl group, or a trifluoromethyl group, and * 1 to *4 each represent a bonding site to a carbonyl group in Formula (1).

In Formula (a), R^{a1} is preferably a halogen atom, an aliphatic hydrocarbon group, or an aromatic group. The hydrogen atom in the aliphatic hydrocarbon group or the aromatic group may be further substituted with a halogen atom or the like.

In Formula (a), m1 represents an integer of 0 to 3, and it is preferably 0 to 2 and more preferably 0 or 1. In addition, an aspect in which m1 is 0 is also one of the preferred aspects of the present invention.

In Formula (a), preferred aspects of R^{a2} and R^{a3} are the same as the preferred aspect of R^{a1}.

In Formula (a), m2 is preferably 0 to 2, and more preferably 0 or 1. In addition, an aspect in which m2 is 0 is also one of the preferred aspects of the present invention.

In Formula (a), a preferred aspect of m3 is the same as the preferred aspect of m1.

In Formula (a), it is preferable that one of * 1 or *2 is bonded to the carbonyl group that is bonded to A¹ in Formula (1) and the other thereof is bonded to a carbonyl group that is bonded to a structure other than the repeating unit represented by Formula (1), and one of *3 or *4 is bonded to the carbonyl group that is bonded to A² in Formula (1) and the other thereof is bonded to the carbonyl group that is bonded to NH described in Formula (1).

In Formula (b), R^{b1} is preferably a halogen atom, an aliphatic hydrocarbon group, or an aromatic group. The hydrogen atom in the aliphatic hydrocarbon group or the aromatic group may be further substituted with a halogen atom or the like.

In Formula (b), n1 represents an integer of 0 to 3, and it is preferably 0 to 2 and more preferably 0 or 1. In addition, an aspect in which n1 is 0 is also one of the preferred aspects of the present invention.

In Formula (b), preferred aspects of R^{b2}, R^{b3}, and R^{b4} are the same as the preferred aspect of R^{b1}.

In Formula (b), n2 is preferably 0 to 2, and more preferably 0 or 1. In addition, an aspect in which n2 is 0 is also one of the preferred aspects of the present invention.

In Formula (b), a preferred aspect of n3 is the same as the preferred aspect of n2.

In Formula (b), a preferred aspect of n4 is the same as the preferred aspect of n1.

In Formula (b), J¹ and J² each independently represent a hydrogen atom, an alkyl group, or a trifluoromethyl group, and a hydrogen atom, a methyl group, or a trifluoromethyl group is preferable.

In Formula (b), it is preferable that one of * 1 or *2 is bonded to the carbonyl group that is bonded to A¹ in Formula (1) and the other thereof is bonded to a carbonyl group that is bonded to a structure other than the repeating unit represented by Formula (1), and one of *3 or *4 is bonded to the carbonyl group that is bonded to A² in Formula (1) and the other thereof is bonded to the carbonyl group that is bonded to NH described in Formula (1).

### [Y¹]

Y¹ is preferably a divalent organic group represented by Formula (Y-1).

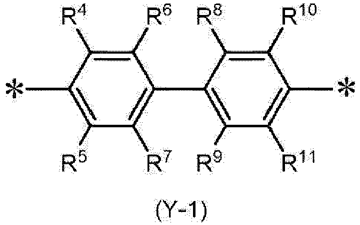

In Formula (Y-1), at least one of R⁴, ..., or R¹¹ is an alkyl group, a fluorine atom, a trifluoromethyl group, or an alkoxy group, R⁶ and R⁸, or R⁷ and R⁹ may be bonded to each other to form a ring structure, and *'s each represent a bonding site to a nitrogen atom in Formula (1).

Due to the fact that high resolution is obtained since solubility in a solvent is excellent and the absorption of i line is small, at least one of R⁴, ..., or R¹¹ is preferably a fluorine atom or a trifluoromethyl group.

In Formula (Y-1), it is preferable that at least two of R⁴ to R¹¹ are an alkyl group, a fluorine atom, or a trifluoromethyl group.

The alkyl group is preferably an alkyl group having 1 to 4 carbon atoms and more preferably a methyl group.

The alkoxy group is preferably an alkoxy group having 1 to 4 carbon atoms, and more preferably a methoxy group.

In addition, in Formula (Y-1), R⁶ and R⁸, or R⁷ and R⁹ may be bonded to each other to form a ring structure. The ring structure to be formed is not particularly limited: however, it is preferably a hydrocarbon ring. In addition, the ring structure to be formed is preferably a 5-membered ring structure or a 6-membered ring structure, and more preferably a 5-membered ring structure.

It is also preferable that Y¹ is a divalent organic group represented by Formula (Y-2).

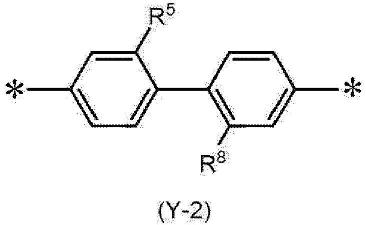

In Formula (Y-2), R⁵ and R⁸ are each independently an alkyl group, a fluorine atom, or a trifluoromethyl group, and *'s each represent a bonding site to a nitrogen atom in Formula (1).

Due to the fact that high resolution is obtained since solubility in a solvent is excellent and the absorption of i line is small, it is preferable that in Formula (Y-2), R⁵ and R⁸ are each independently a fluorine atom, or a trifluoromethyl group.

The alkyl group as R⁵ and R⁸ is preferably an alkyl group having 1 to 4 carbon atoms and more preferably a methyl group.

Specific examples of the divalent organic group represented by Formula (Y-1) include structures represented by the following formulae. However, the present invention is not limited thereto. In the following formulae, * has the same meaning as * in Formula (Y-1).

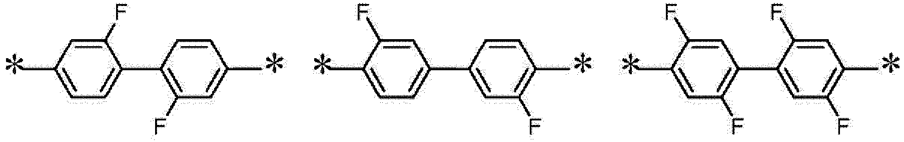

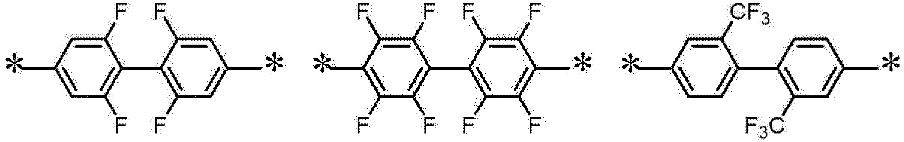

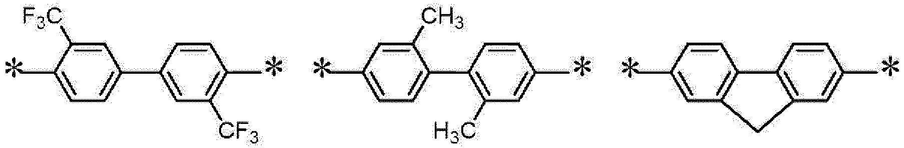

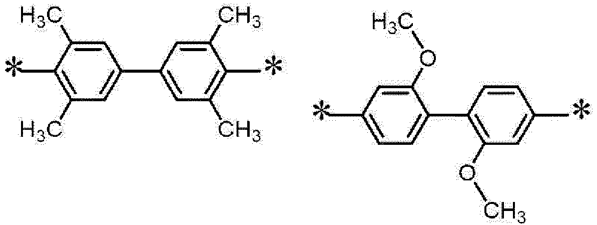

In addition, it is also preferable that Y¹ is a group represented by Formula (Y-3).

Here, examples of the particularly preferred aspect also include an aspect in which the polyimide precursor has a repeating unit represented by Formula (Y-1) and a repeating unit represented by Formula (Y-2).

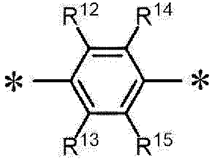

### (Y-3)

In Formula (Y-3), R¹² to R¹⁵ are each independently a hydrogen atom, a halogen atom, or a monovalent organic group, and *'s each represent a bonding site to a nitrogen atom in Formula (1).

An aspect in which all of R¹² to R¹⁵ in Formula (Y-3) are a hydrogen atom is also one of the preferred aspects of the present invention.

In Formula (Y-3), the halogen atom as R¹² to R¹⁵ is preferably a fluorine atom, a chlorine atom, a bromine atom, or an iodine atom, more preferably a fluorine atom or a chlorine atom, and still more preferably a fluorine atom.

In Formula (Y-3), examples of the monovalent organic group as R¹² to R¹⁵ include a hydrocarbon group, an alkoxy group, an aryloxy group, an alkoxycarbonyl group, an aryloxycarbonyl group, an alkylcarbonyloxy group, an arylcarbonyloxy group, a poly(alkylenoxy) group, a poly(aryleneoxy) group, a poly(alkylenoxycarbonyl) group, a poly(arylenoxycarbonyl) group, a hydroxy group, and a cyano group.

In addition, Y¹ may have the same structure as R¹¹¹ in Formula (2) described later.

From the viewpoints of the CTE, the Tg, and the Young's modulus, the polyimide precursor preferably further contains a repeating unit represented by Formula (3).

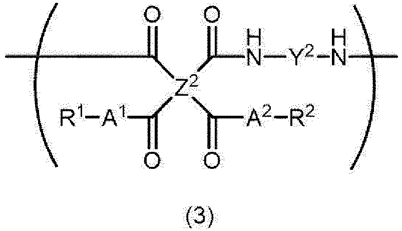

In Formula (3), Z² is a tetravalent organic group represented by any of Formula (2a) to Formula (2d), Y² is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.

Among these, Z² in Formula (3) is preferably a tetravalent organic group represented by Formula (2a) or Formula (2d), and more preferably a tetravalent organic group represented by Formula (2a).

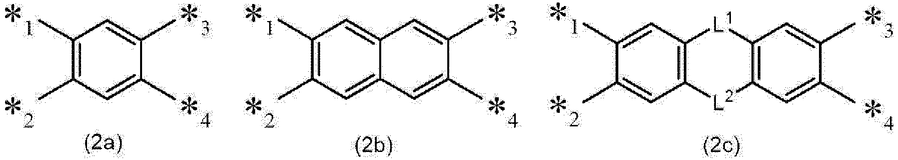

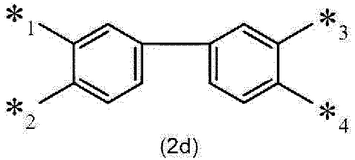

In Formula (2a) to Formula (2d), L¹ and L² are each independently a divalent group which does not conjugate with a benzene ring to which each of L¹ and L² is bonded, or a single bond, and *1 to *4 each represent a bonding site to a carbonyl group in Formula (3).

In Formula (2c), it is preferable that L¹ and L² are each independently -C(R^{C})₂-, -Si(R^{S})₂-, -O-, or a single bond, and it is more preferable that L¹ and L² are each independently -C(R^{C})₂-, -Si(R^{S})₂-, or -O-. In addition, it is preferable that at least one of L¹ or L² is -C(R^{C})₂-or -Si(R^{S})₂-.

R^{C}'s are each independently a hydrogen atom or a hydrocarbon group, and R^{C}'s are preferably an alkyl group, more preferably an alkyl group having 1 to 4 carbon atoms, and still more preferably a methyl group. In addition, two R^{C}'s may be bonded to each other to form a ring structure.

R^{S}'s are each independently a hydrocarbon group, and R^{S}'s are preferably an alkyl group, more preferably an alkyl group having 1 to 4 carbon atoms, and still more preferably a methyl group. In addition, two R^{S}'s may be bonded to each other to form a ring structure.

In Formula (2a) to Formula (2d), it is preferable that one of *1 or *2 is bonded to the carbonyl group that is bonded to A¹ in Formula (3) and the other thereof is bonded to a carbonyl group that is bonded to a structure other than the repeating unit represented by Formula (3), and one of *3 or *4 is bonded to the carbonyl group that is bonded to A² in Formula (3) and the other thereof is bonded to the carbonyl group that is bonded to NH described in Formula (3).

In addition, the hydrogen atom in the ring structure described in Formula (2a) to Formula (2d) may be substituted with a publicly known substituent. Examples of the substituent include an alkyl group, a halogen atom, and an alkyl group in which a hydrogen atom is substituted with a halogen atom.

Specific examples of the group represented by Formula (2a) to Formula (2d) include the following structures; however, the present invention is not limited thereto. In the following structures, *1 to *4 have the same meaning as *1 to *4 in Formula (2a) to Formula (2d), respectively.

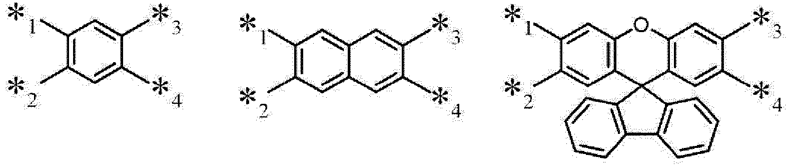

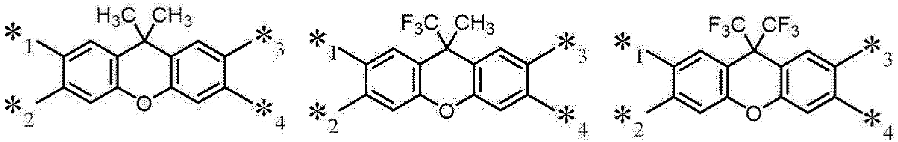

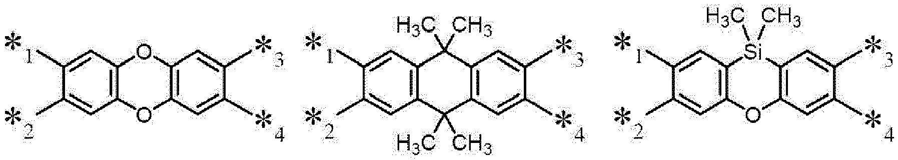

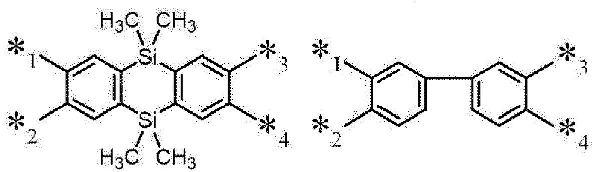

In Formula (3), preferred aspects of Y², A¹, A², R¹, and R² are the same as the preferred aspects of Y¹, A¹, A², R¹, and R² in Formula (1).

The polyimide precursor may further contain a repeating unit represented by Formula (2) as a repeating unit that is different from both the repeating unit represented by Formula (1) and the repeating unit represented by Formula (3). That is, both the repeating unit represented by Formula (1) and the repeating unit represented by formula (3) do not correspond to the repeating unit represented by Formula (2).

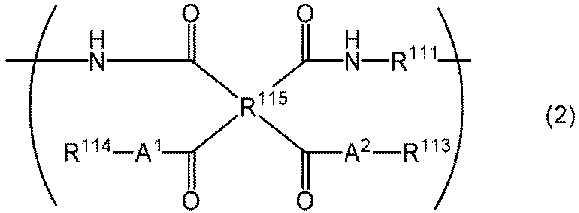

In Formula (2), A¹ and A² each independently represent an oxygen atom or -NR^{Z}-, R¹¹¹ represents a divalent organic group, R¹¹⁵ represents a tetravalent organic group, R¹¹³ and R¹¹⁴ each independently represent a hydrogen atom or a monovalent organic group, and R^{Z} represents a hydrogen atom or a monovalent organic group.

A¹ and A² in Formula (2) each independently represent an oxygen atom or -NR^{Z}-, and an oxygen atom is preferable.

R^{Z} represents a hydrogen atom or a monovalent organic group, and a hydrogen atom is preferable.

R¹¹¹ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of R¹¹¹ in Formula (2) include groups represented by -Ar- and -Ar-L-Ar-, respectively, and a group represented by -Ar-L-Ar- is preferable. However, Ar's are each independently an aromatic group, and L is a single bond or an aliphatic hydrocarbon group having 1 to 10 carbon atoms, which may be substituted with a fluorine atom, -O-, -CO-, -S-, -SO₂-, or -NHCO-, or a group consisting of a combination of two or more of the above. The preferred ranges thereof are as described above.

R¹¹¹ is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, R¹¹¹ is preferably a diamine containing a linear or branched aliphatic group having 2 to 20 carbon atoms, a cyclic aliphatic group having 3 to 20 carbon atoms, an aromatic group having 3 to 20 carbon atoms, or a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

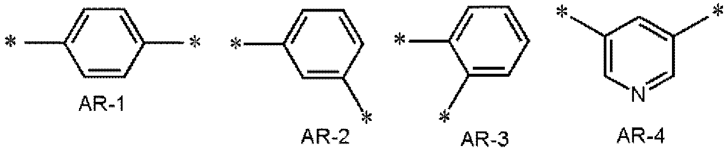

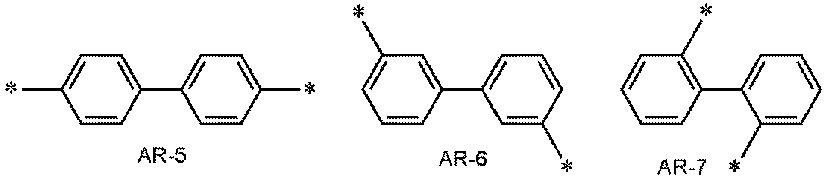

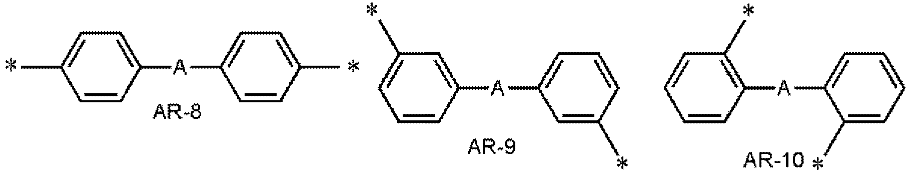

In the formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, -SO₂-, -NHCO-, or a group selected from combinations thereof, more preferably a single bond or a group selected from an alkylene group having 1 to 3 carbon atoms, which may be substituted with a fluorine atom, -O-, -C(=O)-, -S-, or -SO₂-, and still more preferably -CH₂-, -O-, -S-, -SO₂-, -C(CF₃)₂-, or -C(CH₃)₂-.

In the formulae, * represents a bonding site to another structure.

Specific examples of the diamine include 1,2-diaminoethane, 1,2-diaminopropane, 1,3-diaminopropane, 1,4-diaminobutane, or 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, and isophoronediamine; and at least one diamine selected from m- or p-phenylenediamine, diaminotoluene, 4,4'- or 3,3'-diaminobiphenyl, 4,4'-diaminodiphenyl ether, 3,3'-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4'-bis(4-aminophenoxy)biphenyl, bis[4-(4-aminophenoxy)phenyl]sulfone, bis[4-(3 -aminophenoxy)phenyl] sulfone, bis [4-(2-aminophenoxy)phenyl] sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3 -aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- or 2,5-diaminocumen, 2,5-dimethyl-p-phenylenediamine, acetoguanamine, 2,3,5,6-tetramethyl-p-phenylenediamine, 2,4,6-trimethyl-m-phenylenediamine, bis(3-aminopropyl)tetramethyldisiloxane, bis(p-aminophenyl)octamethylpentasiloxane, 2,7-diaminofluorene, 2,5-diaminopyridine, 1,2-bis(4-aminophenyl)ethane, diaminobenzanilide, an ester of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, or 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

R¹¹¹ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, -SO₂-, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or -SO₂-. The aliphatic hydrocarbon group here is preferably an alkylene group.

In addition, from the viewpoint of the i-line transmittance, R¹¹¹ is preferably a divalent organic group represented by Formula (51) or Formula (61) below. In particular, from the viewpoint of the i-line transmittance and ease of availability, a divalent organic group represented by Formula (61) is more preferable.

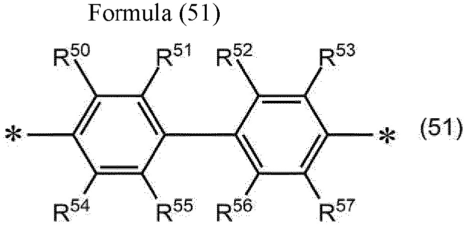

In Formula (51), R⁵¹ to R⁵⁷ each independently represent a hydrogen atom, a fluorine atom, or a monovalent organic group, and at least one of R⁵⁰, ..., or R⁵⁷ represents a fluorine atom, a methyl group, or a trifluoromethyl group, and *'s each independently represent a bonding site to the nitrogen atom in Formula (2).

Examples of the monovalent organic group as R⁵⁰ to R⁵⁷ include an unsubstituted alkyl group having 1 to 10 (preferably 1 to 6 carbon atoms) carbon atoms and a fluorinated alkyl group having 1 to 10 (preferably 1 to 6 carbon atoms) carbon atoms.

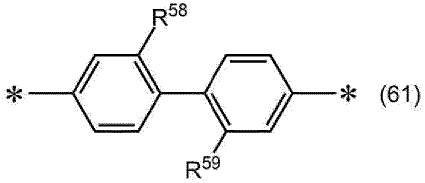

In Formula (61), R⁵⁸ and R⁵⁹ each independently represent a fluorine atom, a methyl group, or a trifluoromethyl group, and *'s each independently represent a bonding site to the nitrogen atom in Formula (2).

Examples of the diamine that provides a structure of Formula (51) or Formula (61), 2,2'-dimethylbenzidine, 2,2'-bis(trifluoromethyl)-4,4'-diaminobiphenyl, 2,2'-bis(fluoro)-4,4'-diaminobiphenyl, and 4,4'-diaminooctafluorobiphenyl. These may be used alone, or two or more kinds thereof may be used in combination.

R¹¹⁵ in Formula (2) represents a tetravalent organic group. The tetravalent organic group is preferably a tetravalent organic group containing an aromatic ring and more preferably a group represented by Formula (5) or Formula (6).

In Formula (5) or Formula (6), *'s each independently represent a bonding site to another structure.

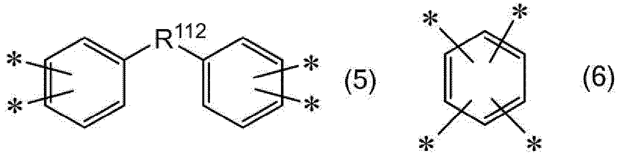

In Formula (5), R¹¹² is a single bond or a divalent linking group. It is preferably a single bond or a group selected from an aliphatic hydrocarbon group having 1 to 10 carbon atoms, which may be substituted with a fluorine atom, -O-, -CO-, -S-, -SO₂-, -NHCO-, or a combination thereof, more preferably a single bond or a group selected from an alkylene group having 1 to 3 carbon atoms, which may be substituted with a fluorine atom, -O-, -CO-, -S-, or -SO₂-, and still more preferably a divalent group selected from the group consisting of -CH₂-, -C(CF₃)₂-, -C(CH₃)₂-, -O-, -CO-, -S-, and -SO₂-.

Specific examples of R¹¹⁵ include a tetracarboxylic acid residue that remains after the removal of the anhydride group from the tetracarboxylic acid dianhydride. The polyimide precursor may contain only one kind of tetracarboxylic acid dianhydride residue or may contain two or more kinds thereof, as a structure corresponding to R¹¹⁵.

The tetracarboxylic acid dianhydride is preferably represented by Formula (O).

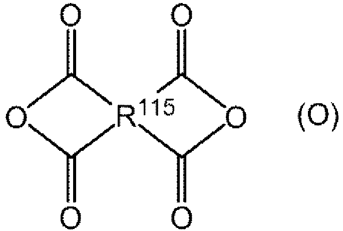

In Formula (O), R¹¹⁵ represents a tetravalent organic group. R¹¹⁵ has the same meaning as R¹¹⁵ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In Formula (2), it is also possible that at least one of R¹¹¹ or R¹¹⁵ has an OH group. More specifically, examples of R¹¹¹ include a residue of a bisaminophenol derivative.

R¹¹³ and R¹¹⁴ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of R¹¹³ or R¹¹⁴ preferably contains a polymerizable group, and more preferably both of them contain a polymerizable group. It is also preferable that at least one of R¹¹³ or R¹¹⁴ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and the group represented by Formula (III) described above, where the group represented by Formula (III) described above is preferable.

In Formula (2), in a case where R¹¹³ is a hydrogen atom, or in a case where R¹¹⁴ is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

The polyimide precursor preferably has a fluorine atom in the structure thereof. The content of fluorine atoms in the polyimide precursor is preferably 10% by mass or more, and it is preferably 20% by mass or less.

In addition, for the purpose of improving adhesiveness to a substrate, the polyimide precursor may be copolymerized with an aliphatic group having a siloxane structure. Specifically, an aspect in which bis(3-aminopropyl)tetramethyldisiloxane, bis(p-aminophenyl)octamethylpentasiloxane, or the like is used as the diamine can be mentioned.

The repeating unit represented by Formula (2) is preferably a repeating unit represented by Formula (2-A). That is, at least one polyimide precursor that is used in the present invention is preferably a precursor having a repeating unit represented by Formula (2-A). In a case where the polyimide precursor contains a repeating unit represented by Formula (2-A), it is possible to further widen the width of the exposure latitude.

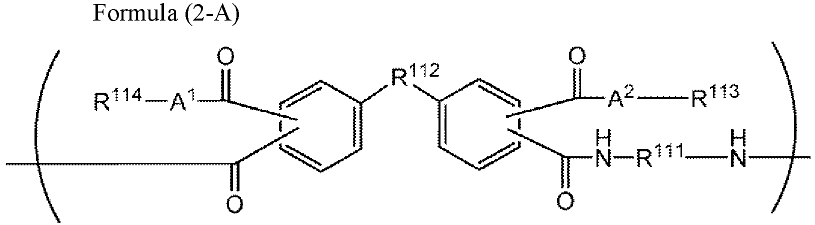

In Formula (2-A), A¹ and A² represent an oxygen atom, R¹¹¹ and R¹¹² each independently represent a divalent organic group, R¹¹³ and R¹¹⁴ each independently represent a hydrogen atom or a monovalent organic group, and at least one of R¹¹³ or R¹¹⁴ is a group containing a polymerizable group, where both of them are preferably a group containing a polymerizable group.

A¹, A², R¹¹¹, R¹¹³, and R¹¹⁴ each independently have the same meaning as A¹, A², R¹¹¹, R¹¹³, and R¹¹⁴ in Formula (2), respectively, and the same applies to the preferred ranges thereof. R¹¹² has the same meaning as R¹¹² in Formula (5), and the same applies to the preferred range thereof.

The polyimide precursor may contain one kind of repeating unit represented by Formula (2) or may contain two or more kinds thereof. In addition, the polyimide precursor may contain structural isomers of the repeating unit represented by Formula (2). The polyimide precursor may also contain another kind of repeating unit in addition to the above repeating unit represented by Formula (2).

The polyimide precursor may further contain another repeating unit that is different from the repeating units represented by Formulae (1) to (3).

Examples of the other repeating unit include a repeating unit represented by Formula (PAI-2).

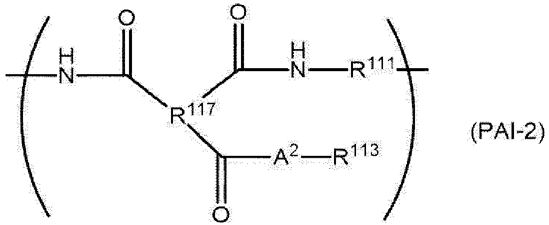

In Formula (PAI-2), R¹¹⁷ represents a trivalent organic group, R¹¹¹ represents a divalent organic group, A² represents an oxygen atom or -NH-, and R¹¹³ represents a hydrogen atom or a monovalent organic group.

In Formula (PAI-2), examples of R¹¹⁷ include a linear or branched aliphatic group, a cyclic aliphatic group, an aromatic group, a heteroaromatic group, and a group obtained by linking two or more of these groups through a single bond or a linking group, where R¹¹⁷ is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and R¹¹⁷ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-,-S(=O)₂-, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, R¹¹⁷ is preferably derived from a tricarboxylic acid compound in which at least one carboxy group may be subjected to halogenation. Here, the halogenation is preferably chlorination.

In the present invention, a compound having three carboxy groups is referred to as a tricarboxylic acid compound.

Two carboxy groups of the three carboxy groups of the tricarboxylic acid compound may be subjected to acid anhydrization.

Examples of the tricarboxylic acid compound which may be halogenated, which is used in the production of the polyamideimide precursor, include a branched aliphatic, cyclic aliphatic, or aromatic tricarboxylic acid compound.

One kind of these tricarboxylic acid compounds may be used alone, or two or more kinds thereof may be used.

Specifically, the tricarboxylic acid compound is preferably a tricarboxylic acid compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a tricarboxylic acid compound containing an aromatic group having 6 to 20 carbon atoms or a group obtained by combining two or more aromatic groups having 6 to 20 carbon atoms through a single bond or a linking group.

Specific examples of the tricarboxylic acid compound include 1,2,3-propanetricarboxylic acid, 1,3,5-pentanetricarboxylic acid, citric acid, trimellitic acid, 2,3,6-naphthalenetricarboxylic acid, and a compound in which phthalic acid (or phthalic anhydride) and benzoic acid are linked through a single bond, -O-, -CH₂-, -C(CH₃)₂-, -C(CF₃)₂-, -SO₂-, or a phenylene group.

These compounds may be a compound (for example, a trimellitic acid anhydride) in which two carboxy groups have been subjected to anhydrization or may be a compound (for example, trimellitic anhydride chloride) in which at least one carboxy group has been halogenated.

In Formula (PAI-2), R¹¹¹, A², and R¹¹³ respectively have the same meanings as R¹¹¹, A², and R¹¹³ in Formula (2) described above, and the same applies to the preferred aspects thereof.

Examples of one embodiment of the polyimide precursor include an aspect in which the content of the repeating unit represented by Formula (1) and the repeating unit represented by Formula (3) are 50% by mole or more of all the repeating units. The above-described total content is more preferably 70% by mole or more, still more preferably 90% by mole or more, and particularly preferably more than 90% by mole. The upper limit of the above-described total content is not particularly limited, and all the repeating units in the polyimide precursor excluding the terminal may be the repeating unit represented by Formula (1) or may be the repeating unit represented by Formula (1) and the repeating unit represented by Formula (3).

In a case where the polyimide precursor contains the repeating unit represented by Formula (1) and the repeating unit represented by Formula (3), the content of the repeating unit represented by Formula (1) is preferably 5% to 50% by mole and more preferably 10% to 40% by mole with respect to the total molar content amount of the repeating unit represented by Formula (1) and the repeating unit represented by Formula (3).

The weight-average molecular weight (Mw) of the polyimide precursor is preferably 5,000 or more, more preferably 10,000 or more, and still more preferably 40,000 or more. The weight-average molecular weight (Mw) of the polyimide precursor is preferably 200,000 or less, more preferably 100,000 or less, and still more preferably 80,000 or less.

The number average molecular weight (Mn) of the polyimide precursor is preferably 2,000 to 100,000, more preferably 3,000 to 50,000, and still more preferably 10,000 to 40,000.

The dispersity of the molecular weight of the polyimide precursor is preferably 4.0 or less, more preferably 3.0 or less, and still more preferably 2.5 or less. The lower limit of the dispersity is not particularly limited and may be 1.0 or more.

In the present specification, the dispersity of the molecular weight is a value obtained by calculating "weight-average molecular weight/number average molecular weight".

In a case where the resin composition contains a plurality of kinds of polyimide precursors, it is preferable that the weight-average molecular weight, the number-average molecular weight, and the dispersity of at least one kind of polyimide precursor are in the above ranges. Further, it is also preferable that the weight-average molecular weight, the number average molecular weight, and the dispersity, calculated by using the plurality of kinds of polyimide precursors as one resin, are within the above ranges.

### [Polyimide]

Examples of the polyimide contained in the first resin composition according to the embodiment of the present invention include a polyimide containing a repeating unit represented by Formula (CR-1).

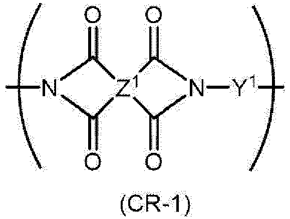

In Formula (CR-1), Z¹ is a tetravalent organic group that includes two or more ether groups and an aromatic ring structure, and Y¹ is a divalent organic group.

In Formula (CR-1), preferred aspects of Z¹ and Y¹ are the same as the preferred aspects of Z¹ and Y¹ in Formula (1) described above.

In addition, the polyimide preferably further contains a repeating unit represented by Formula (CR-3).

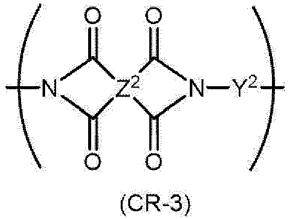

In Formula (CR-3), Z² is the tetravalent organic group represented by any of Formula (2a) to Formula (2d) described above, and Y² is a divalent organic group.

In Formula (CR-3), preferred aspects of Z² and Y² are the same as the preferred aspects of Z² and Y² in Formula (3) described above.

In addition, the polyimide may further contain a repeating unit represented by Formula (CR-2) as a repeating unit that is different from both the repeating unit represented by Formula (CR-1) and the repeating unit represented by Formula (CR-3). That is, both the repeating unit represented by Formula (CR-1) and the repeating unit represented by formula (CR-3) do not correspond to the repeating unit represented by Formula (CR-2).

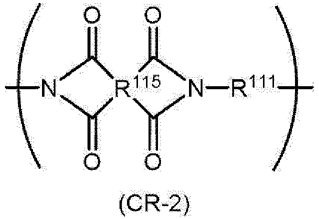

In Formula (CR-2), R¹¹¹ represents a divalent organic group, and R¹¹⁵ represents a tetravalent organic group.

In Formula (CR-2), preferred aspects of R¹¹¹ and R¹¹⁵ are the same as the preferred aspects of R¹¹¹ and R¹¹⁵ in Formula (2) described above.

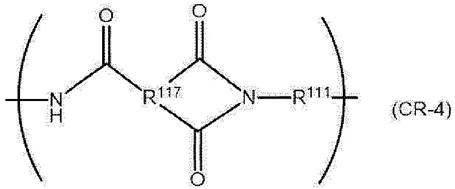

In Formula (CR-4), R¹¹⁷ represents a trivalent organic group, and R¹¹¹ represents a divalent organic group.

In Formula (CR-4), preferred aspects of R¹¹¹ and R¹¹⁷ are the same as the preferred aspects of R¹¹¹ and R¹¹⁷ in Formula (PAI-2) described above.

In addition, it is preferable that the polyimide has a structure in which a polyimide precursor corresponding to the above-described specific resin has been subjected to ring closure.

That is, the polyimide may further contain a repeating unit that has been partially subjected to ring closure, in a repeating unit represented by Formula (1) to Formula (3) or Formula (PAI-1) or a repeating unit represented by Formula (1) to Formula (3), which is contained in the polyimide precursor corresponding to the above-described specific resin.

The ring closure rate of the polyimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured by, for example, the following method.

The infrared absorption spectrum of polyimide is measured, and a peak intensity P1 in the vicinity of 1,377 cm⁻¹, which is the absorption peak derived from the imide structure, is obtained. Next, the polyimide is subjected to a heat treatment at 350°C for 1 hour, and then the infrared absorption spectrum is measured again to obtain a peak intensity P2 in the vicinity of 1,377 cm⁻¹. Using the obtained peak intensities P1 and P2, the imidization rate of the polyimide can be determined based on the following expression.$Imidization rate \left(%\right) = \left(peak intensity P1/peak intensity P2\right) \times 100$

Examples of one embodiment of the polyimide precursor include an aspect in which the content of the repeating unit represented by Formula (CR-1) and the repeating unit represented by Formula (CR-3) is 50% by mole or more of all the repeating units. The above-described total content is more preferably 70% by mole or more, still more preferably 90% by mole or more, and particularly preferably more than 90% by mole. The upper limit of the above-described total content is not particularly limited, and all the repeating units in the polyimide precursor excluding the terminal may be the repeating unit represented by Formula (CR-1) or may be the repeating unit represented by Formula (CR-1) and the repeating unit represented by Formula (CR-3).

In a case where the polyimide precursor contains the repeating unit represented by Formula (CR-1) and the repeating unit represented by Formula (CR-3), the content of the repeating unit represented by Formula (CR-1) is preferably 5% to 50% by mole and more preferably 10% to 40% by mole with respect to the total molar content amount of the repeating unit represented by Formula (CR-1) and the repeating unit represented by Formula (CR-3).

The polyimide preferably contains a fluorine atom.

The amount of fluorine atoms with respect to the total mass of the polyimide is preferably 5% by mass or more, and it is preferably 20% by mass or less.

In addition, the polyimide may contain a silicon atom.

The polyimide also preferably contains a polymerizable group.

The polymerizable group is not particularly limited. However, examples thereof include a group containing an ethylenically unsaturated bond, an epoxy group, an oxetanyl group, a methylol group, and an alkoxymethyl group, where a group containing an ethylenically unsaturated bond is preferable. The ethylenically unsaturated bond preferably has radical polymerizability.

Examples of the group having an ethylenically unsaturated bond include a group having a vinyl group which may be substituted, which is directly bonded to an aromatic ring such as a vinyl group, an allyl group, or a vinylphenyl group, a (meth)acrylamide group, and a (meth)acryloyloxy group.

The polyimide may have an ethylenically unsaturated bond at the terminal of the main chain or the side chain; however, it preferably has an ethylenically unsaturated bond at the side chain.

The polymerizable group can be introduced into, for example, R¹¹¹ or R¹¹⁵ in the repeating unit represented by Formula (CR-2) described above.

The weight-average molecular weight (Mw) of the polyimide is preferably 5,000 or more, more preferably 10,000 or more, and still more preferably 40,000 or more. The weight-average molecular weight (Mw) of the polyimide is preferably 100,000 or less, more preferably 70,000 or less, and still more preferably 50,000 or less.

The number average molecular weight (Mn) of the polyimide is preferably 2,000 to 50,000, more preferably 3,000 to 40,000, and still more preferably 10,000 to 30,000.

The dispersity of the molecular weight of the polyimide is preferably 4.0 or less, more preferably 3.0 or less, and still more preferably 2.5 or less. The lower limit of the dispersity is not particularly limited and may be 1.0 or more.

In the present specification, the dispersity of the molecular weight is a value obtained by calculating "weight-average molecular weight/number average molecular weight".

In a case where the resin composition contains a plurality of kinds of polyimides, it is preferable that the weight-average molecular weight, the number-average molecular weight, and the dispersity of at least one kind of polyimide are in the above ranges. Further, it is also preferable that the weight-average molecular weight, the number average molecular weight, and the dispersity, calculated by using the plurality of kinds of polyimides as one resin, are within the above ranges.

It is also preferable that the polyimide has a fluorine atom in the structure. The content of fluorine atoms in the polyimide is preferably 10% by mass or more, and it is preferably 20% by mass or less.

[Polyimide precursor or production method for polyimide]

The polyimide precursor or the polyimide can be synthesized according to, for example, a method described in Examples which will be described later; however, the method is not limited thereto.

More specifically, it can be obtained by, for example, a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production methods, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.

Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.

Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.

Examples of the halogenating agent include thionyl chloride, oxalyl chloride, and phosphorus oxychloride.

In the production method for a polyimide precursor the like, it is preferable to use an organic solvent in a case of carrying out the reaction. One kind of organic solvent may be used, or two or more kinds thereof may be used.

The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and γ-butyrolactone.

In the production method for a polyimide precursor the like, it is preferable to add a basic compound in a case of carrying out the reaction. One kind of basic compound may be used, or two or more kinds thereof may be used.

The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

### - Terminal blocking agent -

In the production method for a polyimide precursor the like, it is preferable to block the carboxylic acid anhydride, the acid anhydride derivative, or the amino group, remaining at the terminal of the resin such as the polyimide precursor, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecanol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxy quinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid,3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred blocking agent for the amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, benzoic anhydride, and 5-norbornene-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

### - Solid precipitation -

In the production method for a polyimide precursor the like, a step of precipitating a solid may be included. Specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed liquid thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

### [Content]

The content of the specific resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition, the content of the specific resin in the resin composition according to the embodiment of the present invention is preferably 99.5% by mass or less, more preferably 99% by mass or less, still more preferably 98% by mass or less, even still more preferably 97% by mass or less, and even further still more preferably 95% by mass or less, with respect to the total solid content of the resin composition.

The resin composition according to the embodiment of the present invention may contain only one kind of specific resin or may contain two or more kinds thereof. In a case where two or more kinds thereof are contained, the total amount thereof is preferably within the above range.

### <Another resin>

The resin composition according to the embodiment of the present invention may contain the above-described specific resin and another resin (hereinafter, also simply referred to as "the other resin") that is different from the specific resin.

Examples of the other resin include a polybenzoxazole precursor, a polyamideimide precursor, a polyimide, a polybenzoxazole, a polyamideimide, a phenol resin, a polyamide, an epoxy resin, a polysiloxane, a resin including a siloxane structure, a (meth)acrylic resin, a (meth)acrylamide resin, a urethane resin, a butyral resin, a styryl resin, a polyether resin, and a polyester resin.

For example, in a case where a (meth)acrylic resin is further added, it is possible to obtain a resin composition having excellent coatability, and it is possible to obtain a pattern (a cured substance) having excellent solvent resistance.

For example, in a case where a (meth)acrylic resin having a high polymerizable group value and having a weight-average molecular weight of 20,000 or less (for example, a molar content amount of a polymerizable group in 1 g of a resin is 1 × 10⁻³ mol/g or more) is added to the resin composition instead of a polymerizable compound described later or in addition to a polymerizable compound described later, it is possible to improve the coatability of the resin composition, the solvent resistance of the pattern (the cured substance).

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

The content of the other resin in the resin composition according to the embodiment of the present invention is preferably 80% by mass or less, more preferably 75% by mass or less, still more preferably 70% by mass or less, even still more preferably 60% by mass or less, and even further still more preferably 50% by mass or less, with respect to the total solid content of the resin composition.

As the preferred aspect of the resin composition according to the aspect of the present invention, an aspect in which the content of the other resin is a low content can be adopted. In the above aspect, the content of the other resin is preferably 20% by mass or less, more preferably 15% by mass or less, still more preferably 10% by mass or less, even still more preferably 5% by mass or less, and even further still more preferably 1% by mass or less, with respect to the total solid content of the resin composition. The lower limit of the content is not particularly limited, and it may be any content of 0% by mass or more.

The resin composition according to the embodiment of the present invention may contain only one kind of the other resin or may contain two or more kinds thereof. In a case where two or more kinds thereof are contained, the total amount thereof is preferably within the above range.

### <Specific metal complex>

The first resin composition according to the embodiment of the present invention preferably contains a metal complex (also referred to as a "specific metal complex") having a π-conjugated moiety containing a nitrogen atom.

The second resin composition according to the second embodiment of the present invention contains a specific metal complex.

### [Metal atom]

The kind of the metal atom contained in the specific metal complex is not particularly limited; however, it is preferably a Group IV metal atom, more preferably a titanium atom, a zirconium atom, or a hafnium atom, and from the viewpoint of storage stability, still more preferably a titanium atom. This is presumed to be because the titanium atom has a small atomic radius and thus the stability of the compound is improved.

The number of the metal atoms contained in the specific metal complex is not particularly limited; however, it is sufficient to be 1 or more, more preferably 1 to 4, still more preferably 1 or 2, and particularly preferably 1.

In addition, in a case where the specific metal complex contains two or more metal atoms, the kinds of the metal atoms may be the same or different from each other. For example, in a case where the specific metal complex contains two metal atoms, the specific metal complex may contain two titanium atoms or may contain a titanium atom and a zirconium atom.

### [π-Conjugated moiety containing nitrogen atom]

The specific metal complex has a π-conjugated moiety containing a nitrogen atom.

Here, it is preferable that the nitrogen atom is directly bonded to a metal atom in the specific metal complex. The above-described bonding is not particularly limited; however, it is preferably a coordinate bond.

In addition, the π-conjugated moiety may have only one nitrogen atom or may have two or more nitrogen atoms. In a case where two or more nitrogen atoms are contained, it is preferable that one of them is directly bonded to a metal atom in the specific metal complex.

Here, the specific metal complex may have only one π-conjugated moiety containing the nitrogen atom or may have two or more thereof; however, it preferably has one or two thereof.

The π-conjugated moiety containing a nitrogen atom is preferably a structure represented by Formula (1-1).

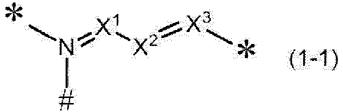

In Formula (1-1), X¹ to X³ each independently represent -C(-*)= or -N=, *'s each represent a bonding site to another structure, and # represents a bonding site to a metal atom.

In Formula (1-1), X¹ to X³ each independently represent -C(-*)= or -N=. It is preferable that at least one thereof represents -C(-*)=, and it is more preferable that at least two thereof represent -C(-*)=.

In Formula (1-1), a structure to be bonded to at least two *'s may be bonded to form a ring structure.

The specific metal complex is preferably a compound having, on the same ligand, the π-conjugated moiety containing the nitrogen atom and at least one group selected from the group consisting of a hydroxy group, a mercapto group, and a carboxy group.

Here, it is preferable that the hydroxy group, the mercapto group, and the carboxy group are bonded to a metal atom as -O-, -S-, and -C(=O)-, respectively.

The specific metal complex may further have another structure that is different from the π-conjugated moiety containing a nitrogen atom.

The other structure is not particularly limited, and a structure consisting of a publicly known ligand can be used. Examples of the ligand include a monodentate alkoxy ligand, a monodentate aryloxy ligand, a polydentate aryloxy ligand, and a cyclopentadienyl ligand, and these ligands may further have a substituent. From the viewpoint of the stability of the specific metal complex, a substituted or unsubstituted cyclopentadienyl ligand is preferable.

The specific metal complex is preferably a compound represented by Formula (2-1).

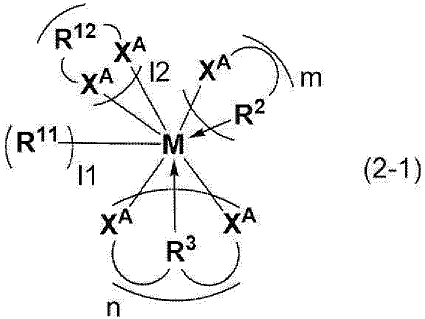

In Formula (2-1), M is titanium, zirconium, or hafnium, l1 is an integer of 0 to 2, 12 is 0 or 1, 11 + l2 × 2 is an integer of 0 to 2, m is an integer of 0 to 4, n is an integer of 0 to 2, 11 + l2 + m + n × 2 = 4 is satisfied, R¹¹'s are each independently a substituted or unsubstituted cyclopentadienyl group, a substituted or unsubstituted alkoxy group, or a substituted or unsubstituted phenoxy group, R¹² is a substituted or unsubstituted hydrocarbon group, R²'s are each independently a group including a structure represented by Formula (2-2), R³'s are each independently a group including a structure represented by Formula (2-2), and X^{A}'s are each independently an oxygen atom or a sulfur atom.

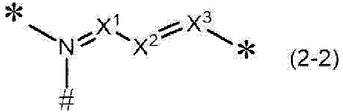

In Formula (2-2), X¹ to X³ each independently represent -C(-*)= or -N=, *'s each represent a bonding site to another structure, and # represents a bonding site to a metal atom.

In Formula (2-1), it is preferable that M represents titanium from the viewpoint of the storage stability of the composition.

An aspect in which l1 and l2 in Formula (2-1) are 0 is also one of the preferred aspects of the present invention.

In Formula (2-1), m is preferably 2 or 4, and more preferably 2.

In Formula (2-1), n is preferably 1 or 2, and more preferably 1.

Here, in Formula (2-1), it is also preferable that 11 and l2 are 0 and m is 0, 2, or 4.

In Formula (2-1), R¹¹ is preferably a substituted or unsubstituted cyclopentadienyl ligand from the viewpoint of the stability of the specific metal complex.

In addition, the cyclopentadienyl group, the alkoxy group, and the phenoxy group as R¹¹ may be substituted; however, an aspect in which these are unsubstituted is also one of the preferred aspects of the present invention.

In Formula (2-1), R¹² is preferably a hydrocarbon group having 1 to 20 carbon atoms and more preferably a hydrocarbon group having 2 to 10 carbon atoms.

The hydrocarbon group as R¹² may be any of an aliphatic hydrocarbon group or an aromatic hydrocarbon group; however, it is preferably an aromatic hydrocarbon group.

The aliphatic hydrocarbon group may be a saturated aliphatic hydrocarbon group or an unsaturated aliphatic hydrocarbon group; however, it is preferably a saturated aliphatic hydrocarbon group.

The aromatic hydrocarbon group is preferably an aromatic hydrocarbon group having 6 to 20 carbon atoms, more preferably an aromatic hydrocarbon group having 6 to 10 carbon atoms, and still more preferably a phenylene group.

The substituent as R¹² is preferably a monovalent substituent, and examples thereof include a halogen atom. In addition, in a case where R¹² is an aromatic hydrocarbon group, it may have an alkyl group as a substituent.

Among these, in Formula (2-1), R¹² is preferably an unsubstituted phenylene group. In addition, the phenylene group as R¹² is preferably a 1,2-phenylene group.

In Formula (2-1), a preferred aspect of the structure represented by Formula (2-2) which is included in R² and R³ is the same as the preferred aspect of Formula (1-1) described above.

In Formula (2-1), in a case where m is 2 or more and two or more R²'s contained, the structures of the two or more R²'s may be the same or different from each other.

In Formula (2-1), in a case where n is 2 or more and two or more R³'s contained, the structures of the two or more R³'s may be the same or different from each other.

Specific examples of R² in Formula (2-1) will be described below; however, the specific examples thereof are not limited thereto. In the following structures, * represents a bonding site to X^{A} in Formula (2-1), and # represents a bonding site to M in Formula (2-1).

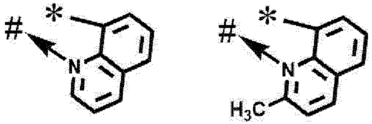

Specific examples of R³ in Formula (2-1) will be described below; however, the specific examples thereof are not limited thereto. In the following structures, *'s each represent a bonding site to X^{A} in Formula (2-1), and # represents a bonding site to M in Formula (2-1).

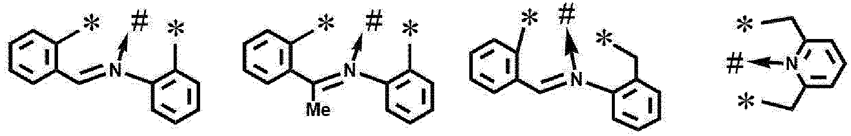

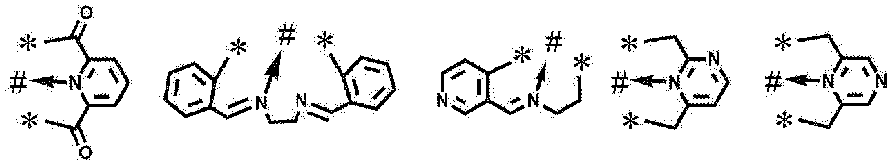

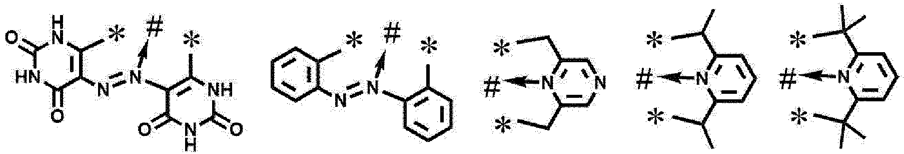

In addition, from the viewpoint of the stability of the specific metal complex, an aspect in which the specific metal complex does not have a monodentate ligand other than cyclopentadienyl is also one of the preferred aspects of the present invention.

The specific metal complex preferably generates an amine by heating at 250°C. The above-described temperature is preferably 230°C, more preferably 200°C, and still more preferably 180°C.

In the present invention, in a case where a solution in which the specific metal complex is dissolved in the same solvent as that of the resin composition according to the embodiment of the present invention at the same concentration as the concentration of the resin composition according to the embodiment of the present invention is prepared and heated at X°C, the specific metal complex is defined as generating an amine at X°C in a case where the amine is generated such that an amount thereof is 10% by mole or more with respect to the total molar amount of the specific metal complex.

In addition, from the viewpoint of the breaking elongation of the cured substance to be obtained, the pKa of the conjugate acid of the amine is preferably 3 or more and more preferably 6 or more. The upper limit of the pKa of the conjugate acid is not particularly limited; however, it is preferably 30 g or less.

Further, from the viewpoint of storage stability, the pKa of the conjugate acid of the specific metal complex itself is preferably less than 3, more preferably -5 or less, and still more preferably -10 or less.

The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is defined as a calculated value according to ACD/ChemSketch (registered trademark).

In a case where the conjugate acid has a plurality of pKa values, at least one of them is preferably within the above range.

Regarding the solubility parameter of the specific metal complex, the solubility parameter (SP) value is preferably 9 or more, and more preferably 10 or more. The upper limit of the SP value is not particularly limited and may be, for example, 30 or less.

It is noted that unless otherwise specified, the SP value in the present specification is determined according to the Hoy method (H. L. Hoy, Journal of Painting, 1970, Vol. 42, 76-118). In addition, the SP value is shown with the unit being omitted; however, the unit thereof is cal^{1/2} cm^{-3/2}.

### [Molecular weight]

The molecular weight of the specific metal complex is preferably 200 to 2,000, more preferably 250 to 1,500, and still more preferably 300 to 1,000.

### [Synthesis method]

The specific metal complex can be synthesized, for example, by reacting a titanium alkoxide with a compound having an alkoxy group or a carboxyl group. In addition, the compound may be synthesized by using a publicly known synthesis method, and the synthesis method is not particularly limited.

Specific examples of the specific metal complex are not particularly limited; however, examples thereof include A-1 to A-43 used in Examples.

The content of the specific metal complex with respect to the total solid content of the resin composition according to the embodiment of the present invention is preferably 0.05% to 20% by mass. The lower limit thereof is more preferably 0.10% by mass or more, still more preferably 0.2% by mass or more, particularly preferably 0.5% by mass or more, and most preferably 1% by mass or more. The upper limit thereof is more preferably 15% by mass or less, still more preferably 10% by mass or less, and particularly preferably 8% by mass or less.

The specific metal complex may be used alone; however, two or more kinds thereof may be used in combination. In a case where two or more kinds thereof are used in combination, the total amount thereof is preferably in the above range.

In addition, the resin composition according to the embodiment of the present invention preferably contains a polymerizable compound and a polymerization initiator, and from the viewpoint of enabling exposure and development, it more preferably contains a polymerizable compound and a photopolymerization initiator.

### <Polymerizable compound>

The resin composition according to the embodiment of the present invention preferably contains a polymerizable compound.

Examples of the polymerizable compound include a radical crosslinking agent and another crosslinking agent.

### [Radical crosslinking agent]

The resin composition according to the embodiment of the present invention preferably contains a radical crosslinking agent.

The radical crosslinking agent is a compound having a radically polymerizable group. The radically polymerizable group is preferably a group containing an ethylenically unsaturated bond. Examples of the group containing an ethylenically unsaturated bond include a vinyl group, an allyl group, a vinylphenyl group, a (meth)acryloyl group, a maleimide group, and a (meth)acrylamide group.

Among these, a (meth)acryloyl group, a (meth)acrylamide group, or a vinylphenyl group is preferable, and from the viewpoint of reactivity, a (meth)acryloyl group is more preferable.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

From the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, where ester between unsaturated carboxylic acids and polyhydric alcohol compounds or amides between unsaturated carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogeno group or a tosyloxy group, with monofunctional or polyfunctional alcohols, amines, or thiols is also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

The radical crosslinking agent is also preferably a compound having a boiling point of 100°C or higher under normal pressure. Examples of the compound having a boiling point of 100°C or higher under normal pressure include the compounds described in paragraph 0203 of WO2021/112189A. The content thereof is incorporated in the present specification.

Examples of the preferred radical crosslinking agent other than those described above include the radically polymerizable compounds described in paragraphs 0204 to 0208 of WO2021/112189A. The content thereof is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, SR-209, 231, and 239 which are a difunctional methacrylate having four ethyleneoxy chains (all of which are manufactured by manufactured by Sartomer Company Inc.), DPCA-60 which is a hexafunctional acrylate having six pentyleneoxy chains and TPA-330 which is a trifunctional acrylate having three isobutylene oxy chains (all of which are manufactured by Nippon Kayaku Co., Ltd.), UAS-10 and UAB-140 which are a urethane oligomer (all of which are manufactured by Nippon Paper Industries Co., Ltd.), NK Ester M-40G, NK Ester 4G, NK Ester M-9300, NK Ester A-9300, and UA-7200 (all of which are manufactured by Shin-Nakamura Chemical Co., Ltd.), DPHA-40H (manufactured by Nippon Kayaku Co., Ltd.), UA-306H, UA-306T, UA-306I, AH-600, T-600, and AI-600 (all of which are manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A (JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. As the radical crosslinking agent, the compounds having an amino structure or a sulfide structure in the molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester between an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

An acid value of the radical crosslinking agent having an acid group is preferably 0.1 to 300 mgKOH/g and more preferably 1 to 100 mgKOH/g. In a case where the acid value of the radical crosslinking agent is within the above-described range, excellent manufacturing handleability is exhibited, and excellent developability is exhibited. In addition, good polymerization properties are exhibited. The acid value is measured in accordance with the description of JIS K 0070: 1992.

It is also preferable that the radical crosslinking agent is a radical crosslinking agent having at least one structure selected from the group consisting of a urea bond, a urethane bond, and an amide bond (hereinafter, also referred to as a "crosslinking agent U").

In the present invention, the urea bond is a bond represented by *-NR^{N}-C(=O)-NR^{N}-*, where R^{N}'s each independently represent a hydrogen atom or a monovalent organic group, *'s each represent a bonding site to a carbon atom, and *'s are each preferably a bonding site to a hydrocarbon group.

In the present invention, the urethane bond is a bond represented by *-O-C(=O)-NR^{N}-*, where R^{N} represents a hydrogen atom or a monovalent organic group, *'s each represent a bonding site to a carbon atom, and *'s are each preferably a bonding site to a hydrocarbon group.

In the present invention, the amide bond is a bond represented by *-C(=O)-NR^{N}-*, where R^{N} represents a hydrogen atom or a monovalent organic group, *'s each represent a bonding site to a carbon atom, and *'s are each preferably a bonding site to a hydrocarbon group.

In a case where the resin composition contains a crosslinking agent U, chemical resistance, resolution, and the like may be improved.

The mechanism by which the above-described effect is obtained is not revealed; however, it is considered that, for example, a part of the crosslinking agent U undergoes thermal decomposition during curing by heating or the like to generate an amine or the like, and the amine or the like accelerates the cyclization of the polyimide precursor.

The crosslinking agent U may have only one urea bond, one urethane bond, or one amide bond, or it may have two or more structures of one or more kinds of bonds selected from the group consisting of a urea bond, a urethane bond, and an amide bond.

The total number of urea bonds, urethane bonds, and amide bonds in the crosslinking agent U is 1 or more, and it is preferably 1 to 10, more preferably 1 to 4, and still more preferably 1 or 2.

The radically polymerizable group in the crosslinking agent U is not particularly limited; however, examples thereof include a vinyl group, an allyl group, a (meth)acryloyl group, a (meth)acryloxy group, a (meth)acrylamide group, a vinylphenyl group, and a maleimide group, where a (meth)acryloxy group, a (meth)acrylamide group, a vinylphenyl group, or a maleimide group is preferable, and a (meth)acryloxy group is more preferable.

In a case where the crosslinking agent U has two or more radically polymerizable groups, the structures of the respective radically polymerizable groups may be the same or different from each other.

The number of radically polymerizable groups in the crosslinking agent U may be only one or may be two or more, and it is preferably 1 to 10, more preferably 1 to 6, and particularly preferably 1 to 4.

The radically polymerizable group value (the mass of the compound per 1 mol of the radically polymerizable group) in the crosslinking agent U is preferably 150 to 400 g/mol.

From the viewpoint of the chemical resistance of the cured substance, the lower limit of the above-described radically polymerizable group value is more preferably 200 g/mol or more, still more preferably 210 g/mol or more, even more preferably 220 g/mol or more, even still more preferably 230 g/mol or more, even still more preferably 240 g/mol or more, and particularly preferably 250 g/mol or more.

From the viewpoint of developability, the upper limit of the above-described radically polymerizable group value is more preferably 350 g/mol or less, still more preferably 330 g/mol or less, and particularly preferably 300 g/mol or less.

Among the above, the polymerizable group value of the crosslinking agent U is preferably 210 to 400 g/mol and more preferably 220 to 400 g/mol.

The crosslinking agent U has preferably, for example, a structure represented by Formula (U-1).

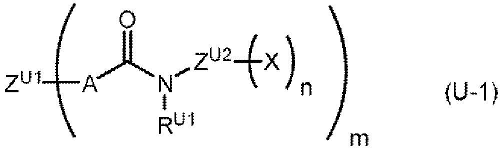

In Formula (U-1), R^{U1} is a hydrogen atom or a monovalent organic group, A is a single bond, -O-, or -NR^{N}-, R^{N} is a hydrogen atom or a monovalent organic group, Z^{U1} is an m-valent organic group, Z^{U2} is a single bond or an (n+1)-valent organic group, X is a radically polymerizable group, n is an integer of 1 or more, and m is an integer of 1 or more.

R^{U1} is preferably a hydrogen atom, an alkyl group, or an aromatic hydrocarbon group, and more preferably a hydrogen atom.

R^{N} is preferably a hydrogen atom, an alkyl group, or an aromatic hydrocarbon group, and more preferably a hydrogen atom.

Z^{U1} is preferably a hydrocarbon group, -O-, -C(=O)-, -S-, -S(=O)₂-, -NR^{N}-, or a group in which two or more of these are bonded, and more preferably a hydrocarbon group or a group in which a hydrocarbon group is bonded to at least one group selected from the group consisting of -O-, -C(=O)-, -S-, -S(=O)₂-, and -NR^{N}-.

In addition, the bonding site of A in Z^{U1} is preferably a hydrocarbon group.

As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. Examples of the above-described hydrocarbon group include a saturated aliphatic hydrocarbon group, an aromatic hydrocarbon group, and a group obtained by bonding of these groups. R^{N} represents a hydrogen atom or a monovalent organic group, and it is preferably a hydrogen atom or a hydrocarbon group, more preferably a hydrogen atom or an alkyl group, and still more preferably a hydrogen atom or a methyl group.

Z^{U2} is preferably a hydrocarbon group, -O-, -C(=O)-, -S-, -S(=O)₂-, -NR^{N}-, or a group in which two or more of these are bonded, and more preferably a hydrocarbon group or a group in which a hydrocarbon group is bonded to at least one group selected from the group consisting of -O-, -C(=O)-, -S-, -S(=O)₂-, and -NR^{N}-.

Examples of the hydrocarbon group include the same ones as those exemplified as Z^{U1}, and the same applies to the preferred aspect thereof.

X is not particularly limited; however, examples thereof include a vinyl group, an allyl group, a (meth)acryloyl group, a (meth)acryloxy group, a (meth)acrylamide group, a vinylphenyl group, and a maleimide group, where a (meth)acryloxy group, a (meth)acrylamide group, a vinylphenyl group, or a maleimide group is preferable, and a (meth)acryloxy group is more preferable.

n is preferably an integer of 1 to 10, more preferably an integer of 1 to 4, still more preferably 1 or 2, and particularly preferably 1.

m is preferably an integer of 1 to 10, more preferably an integer of 1 to 4, and still more preferably 1 or 2.

It is also preferable that the crosslinking agent U has at least one of a hydroxy group, an alkyleneoxy group, or a cyano group.

From the viewpoint of the chemical resistance of the cured film to be obtained, the hydroxy group may be an alcoholic hydroxy group or a phenolic hydroxy group; however, it is preferably an alcoholic hydroxy group.

From the viewpoint of the chemical resistance of the cured film to be obtained, the alkyleneoxy group is preferably an alkyleneoxy group having 2 to 20 carbon atoms, more preferably an alkyleneoxy group having 2 to 10 carbon atoms, still more preferably an alkyleneoxy group having 2 to 4 carbon atoms, even still more preferably an ethylene group or a propylene group, and particularly preferably an ethylene group.

The alkyleneoxy group may be contained in the crosslinking agent U as a polyalkyleneoxy group. The number of repetitions of the alkyleneoxy group in this case is preferably 2 to 10 and more preferably 2 to 6.

The crosslinking agent U may have, in the molecule, two or more structures selected from the group consisting of a hydroxy group, an alkyleneoxy group (however, a polyalkyleneoxy group in a case of constituting a polyalkyleneoxy group), and a cyano group; however, an aspect in which only one structure is contained in the molecule is also preferable.

The hydroxy group, the alkyleneoxy group, and the cyano group may be present at any position of the crosslinking agent U. However, from the viewpoint of chemical resistance, it is also preferable that the crosslinking agent U is such that at least one selected from the group consisting of the hydroxy group, the alkyleneoxy group, and the cyano group, and at least one radically polymerizable group contained in the crosslinking agent U are linked by a linking group (hereinafter, also referred to as a "linking group L2-1") containing a urea bond, a urethane bond, or an amide bond.

In particular, in a case where the crosslinking agent U contains only one radically polymerizable group, it is preferable that the radically polymerizable group contained in the crosslinking agent U and at least one selected from the group consisting of a hydroxy group, an alkyleneoxy group, an amide group, and a cyano group are linked by a linking group containing a urea bond, a urethane bond, or a amide bond (hereinafter, also referred to as a "linking group L2-2").

In a case where the crosslinking agent U contains an alkyleneoxy group (however, a polyalkyleneoxy group in a case of constituting a polyalkyleneoxy group) and has the above-described linking group L2-1 or the above-described linking group L2-2, a structure that is bonded to a side of the alkyleneoxy group (however, a polyalkyleneoxy group in a case of constituting a polyalkyleneoxy group) opposite to the linking group L2-1 or the linking group L2-2 is not particularly limited; however, it is preferably a hydrocarbon group, a radically polymerizable group, or a group represented by a combination thereof. As the above-described hydrocarbon group, a hydrocarbon group having 20 or less carbon atoms is preferable, a hydrocarbon group having 18 or less carbon atoms is more preferable, and a hydrocarbon group having 16 or less carbon atoms is still more preferable. Examples of the above-described hydrocarbon group include a saturated aliphatic hydrocarbon group, an aromatic hydrocarbon group, and a group obtained by bonding of these groups. In addition, the preferred aspect of the radically polymerizable group is the same as the preferred aspect of the radically polymerizable group in the above-described crosslinking agent U.

Among these, from the viewpoint of the adhesiveness to the base material, the chemical resistance, and the Cu void suppression, the crosslinking agent U preferably has a hydroxy group.

From the viewpoint of the compatibility with the specific resin and the like, the crosslinking agent U preferably contains an aromatic group.

The aromatic group is preferably directly bonded to a urea bond, a urethane bond, or an amide bond, which is contained in the crosslinking agent U. In a case where the crosslinking agent U contains two or more urea bonds, two or more urethane bonds, or two or more amide bonds, it is preferable that one among the urea bonds, urethane bonds, and the amide bonds is directly bonded to the aromatic group.

The aromatic group may be an aromatic hydrocarbon group or an aromatic heterocyclic group and may have a structure in which these groups form a fused ring; however, an aromatic hydrocarbon group is preferable.

The aromatic hydrocarbon group is preferably an aromatic hydrocarbon group having 6 to 30 carbon atoms, more preferably an aromatic hydrocarbon group having 6 to 20 carbon atoms, and still more preferably a group obtained by removing two or more hydrogen atoms from a benzene ring structure.

The aromatic heterocyclic group is preferably a 5-membered or 6-membered aromatic heterocyclic group. Examples of the aromatic heterocyclic ring in such an aromatic heterocyclic group include pyrrole, imidazole, triazole, tetrazole, pyrazole, furan, thiophene, oxazole, isoxazole, thiazole, pyridine, pyrazine, pyrimidine, pyridazine, and triazine. These rings may be further fused with another ring, for example, as in the case of indole or benzimidazole.

The heteroatom contained in the aromatic heterocyclic group is preferably a nitrogen atom, an oxygen atom, or a sulfur atom.

It is preferable that the aromatic group is included in, for example, a linking group that links two or more radically polymerizable groups and links a linking group having a urea bond, a urethane bond or an amide bond, or at least one selected from the group consisting of a hydroxy group, an alkyleneoxy group, and a cyano group, to at least one radically polymerizable group contained in the crosslinking agent U.

The number of atoms (linking chain length) between the urea bond, urethane bond, or amide bond and the radically polymerizable group in the crosslinking agent U is not particularly limited; however, it is preferably 30 or less, more preferably 2 to 20, and still more preferably 2 to 10.

In a case where the crosslinking agent U contains two or more bonds of the urea bond, the urethane bond, or the amide bond in total, in a case where the crosslinking agent U contains two or more radically polymerizable groups, or in a case where the crosslinking agent U contains two or more bonds of the urea bond, the urethane bond, or the amide bond and contains two or more radically polymerizable groups, the minimum number of atoms (linking chain length) between the urea bond, the urethane bond, or amide bond and the radically polymerizable group is sufficient to be within the above-described range.

In the present specification, the phrase "number of atoms (linking chain length) between the urea bond, urethane bond, or amide bond, and the polymerizable group" refers to the smallest number of atoms (minimum number of atoms) for linking linking targets among the number of atoms for atomic chains on a path that links two atoms or atomic groups between the linking targets. For example, in a structure represented by the following formula, the number of atoms (linking chain length) between the urea bond and the radically polymerizable group (methacryloyloxy group) is 2.

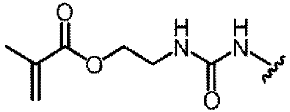

### [Symmetry axis]

It is also preferable that the crosslinking agent U is a compound having a structure which does not have a symmetry axis.

The fact that the crosslinking agent U does not have a symmetry axis refers to that the crosslinking agent U is a left-right asymmetric compound which does not have an axis that generates the same molecule as the original molecule in a case where the entire compound is rotated. In addition, in a case where the structural formula of the crosslinking agent U is shown on the paper surface, the fact that the crosslinking agent U does not have a symmetry axis refers to that the structural formula of the crosslinking agent U cannot be shown in a form having a symmetry axis.

It is considered that the aggregation of the crosslinking agents U is suppressed in the composition film in a case where the crosslinking agent U does not have a symmetry axis.

### [Molecular weight]

The molecular weight of the crosslinking agent U is preferably 100 to 2,000, more preferably 150 to 1,500, and still more preferably 200 to 900.

A manufacturing method for the crosslinking agent U is not particularly limited; however, the crosslinking agent U can be obtained, for example, by reacting a radically polymerizable compound with a compound having an isocyanate group and a compound having at least one of a hydroxy group or an amino group.

Specific examples of the crosslinking agent U include the following compounds; however, the crosslinking agent U is not limited thereto.

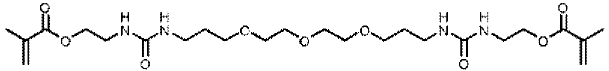

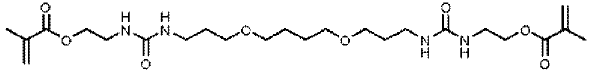

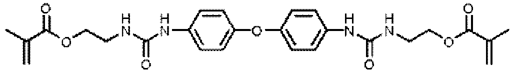

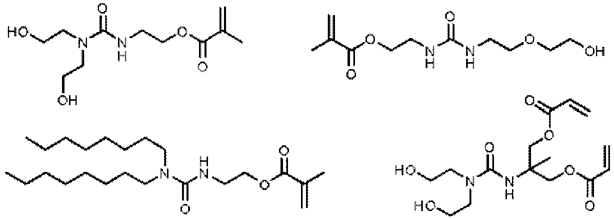

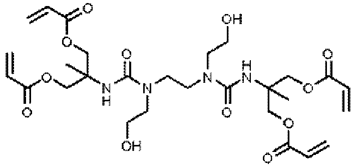

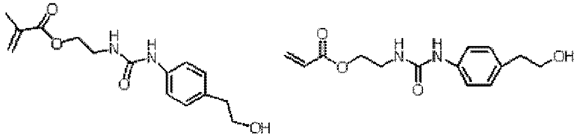

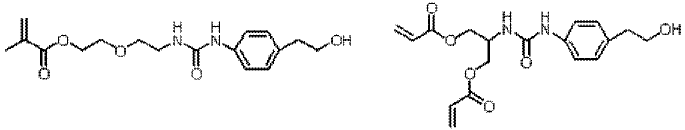

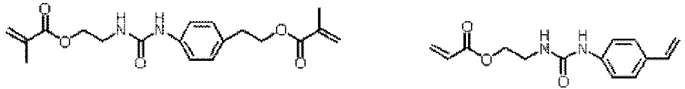

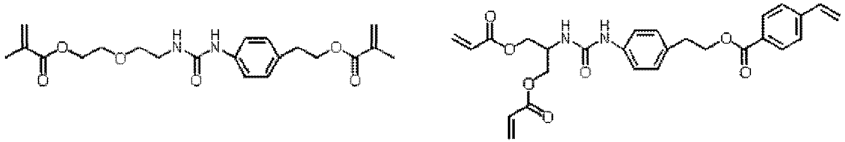

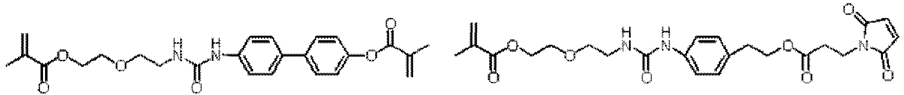

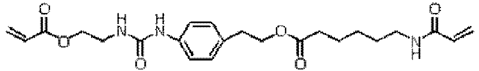

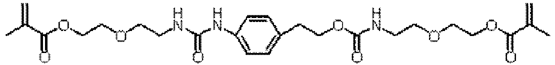

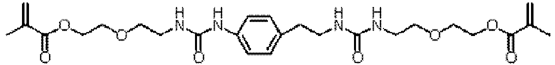

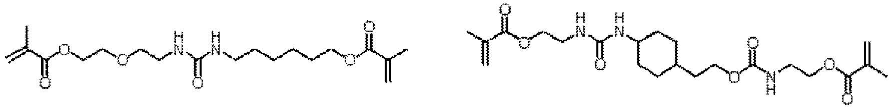

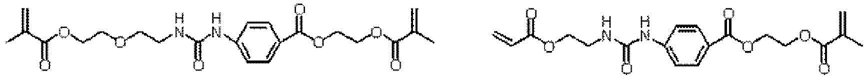

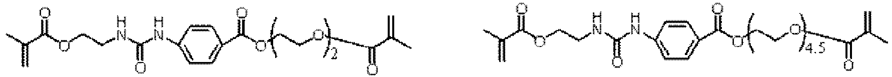

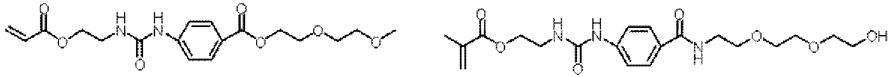

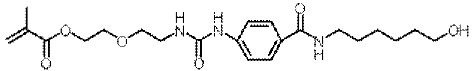

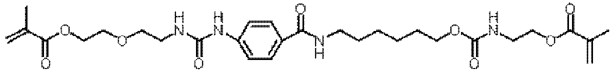

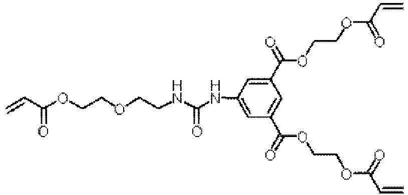

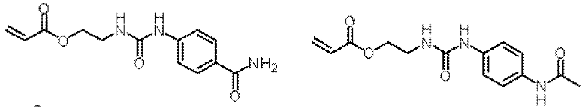

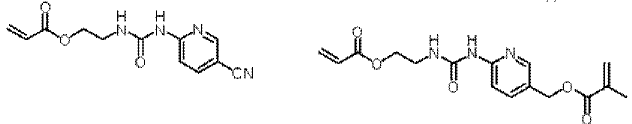

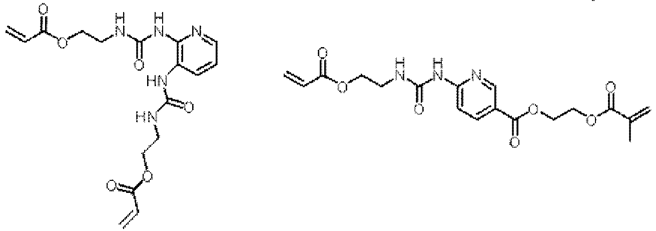

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, and polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, neopentyl glycol diacrylate, neopentyl glycol dimethacrylate, 3-methyl-1, 5-pentanediol diacrylate, 1,6-hexanediol diacrylate, 1,6-hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain formula weight of about 200.

In the photocurable resin composition according to the embodiment of the present invention, a monofunctional radical crosslinking agent can be preferably used as the radical crosslinking agent from the viewpoint of suppressing the warping of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate; butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under normal pressure is also preferable in order to suppress volatilization before exposure.

In addition, examples of the bi- or higher functional radical crosslinking agent include allyl compounds such as diallyl phthalate and triallyl trimellitate.

In a case where a radical crosslinking agent is contained, the content of the radical crosslinking agent is preferably more than 0% by mass and 60% by mass or less with respect to the total solid content of the resin composition. The lower limit thereof is more preferably 5% by mass or more. The upper limit thereof is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

### [Another crosslinking agent]

The photocurable resin composition according to the embodiment of the present invention also preferably contains another crosslinking agent different from the radical crosslinking agent described above.

The other crosslinking agent refers to a crosslinking agent other than the above-described radical crosslinking agent, where it is preferably a compound having a plurality of groups, in the molecule, which accelerates a reaction of forming a covalent bond between other compounds in the composition or reaction products thereof, by the photosensitization of the above-described photoacid generator photobase generator, and it is preferably a compound having a plurality of groups, in the molecule, which accelerates a reaction of forming a covalent bond between other compounds in the composition or reaction products thereof, by the action of the acid or the base.

The acid or the base is preferably an acid or a base, which is generated from a photoacid generator or a photobase generator in the exposure step.

The other crosslinking agent is preferably a compound having at least one group selected from the group consisting of an acyloxymethyl group, a methylol group, an ethylol group, and an alkoxymethyl group, and more preferably a compound having a structure in which at least one group selected from the group consisting of an acyloxymethyl group, a methylol group, an ethylol group, and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with an acyloxymethyl group, a methylol group, an ethylol group, or an alkoxymethyl group. The production method for these compounds is not particularly limited, and any compound having the same structure as the compound produced by the above method may be used. Oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, more preferably 2 or 3 carbon atoms, and still more preferably 2 carbon atoms.

The total number of alkoxymethyl groups and acyloxymethyl groups which are contained in the above compound is preferably 1 to 10, more preferably 2 to 8, and particularly preferably 3 to 6.

The molecular weight of the above compound is preferably 1500 or less, and more preferably 180 to 1200.

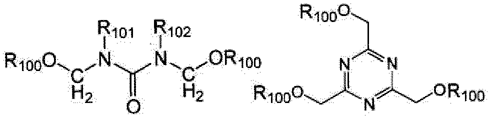

R₁₀₀ represents an alkyl group or an acyl group.

R₁₀₁ and R₁₀₂ each independently represent a monovalent organic group, and they may be bonded to each other to form a ring.

Examples of the compound in which an alkoxymethyl group or an acyloxymethyl group is directly substituted on an aromatic group include compounds such as those represented by the following general formulae.

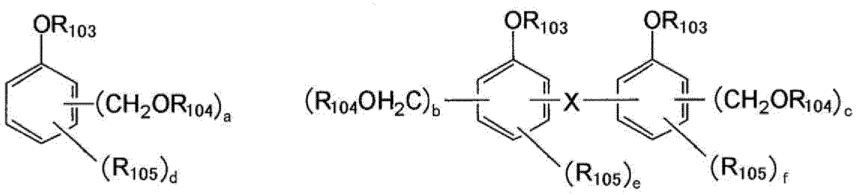

In the formula, X represents a single-bonded or divalent organic group, each R₁₀₄ independently represents an alkyl or acyl group, and R₁₀₃ represents a hydrogen atom, an alkyl group, an alkenyl group, an aryl group, an aralkyl group, or a group that decomposes under the action of acid and generates an alkali-soluble group (for example, a group that is eliminated by under the action of acid, a group represented by -C(R⁴)₂COOR⁵ (each R⁴ independently represents a hydrogen atom or an alkyl group having 1 to 4 carbon atoms, and R⁵ represents a group eliminated under the action of acid)).

Each R₁₀₅ independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less.

Examples of R⁵ in the group that decomposes under the action of an acid to generate an alkali-soluble group, a group that is eliminated under the action of acid, and a group represented by -C(R⁴)₂COOR⁵, include -C(R₃₆)(R₃₇)(R₃₈), -C(R₃₆)(R₃₇)(OR₃₉), and -C(R₀₁)(R₀₂)(OR₃₉).

In the formulae, R₃₆ to R₃₉ each independently represent an alkyl group, a cycloalkyl group, an aryl group, an aralkyl group, or an alkenyl group. R₃₆ and R₃₇ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

These groups may further have a publicly known substituent.

R₀₁ and R₀₂ each independently represent a hydrogen atom, an alkyl group, a cycloalkyl group, an aryl group, an aralkyl group, or an alkenyl group.

The group that decomposes under the action of an acid to generate an alkali-soluble group or the group that is eliminated under the action of an acid is preferably a tertiary alkyl ester group, an acetal group, a cumyl ester group, an enol ester group, or the like. It is more preferably a tertiary alkyl ester group or an acetal group.

In addition, a compound having at least one group selected from the group consisting of a urea bond and a urethane bond is also preferable as the compound having at least one group selected from the group consisting of an acyloxymethyl group, a methylol group, an ethylol group, and an alkoxymethyl group. A preferred aspect of the above compound is the same as the preferred aspect of the crosslinking agent U described above, except that the polymerizable group is not a radically polymerizable group but at least one group selected from the group consisting of an acyloxymethyl group, a methylol group, an ethylol group, and an alkoxymethyl group.

Specific examples of the compound having at least one group selected from the group consisting of an acyloxymethyl group, a methylol group, and an ethylol group include the following structures. Examples of the compound having an acyloxymethyl group include compounds in which the alkoxymethyl group of the following compounds is changed to an acyloxymethyl group. Examples of the compound having an alkoxymethyl group or an acyloxymethyl group in the molecule include such compounds as follows; however, the compound is not limited thereto.

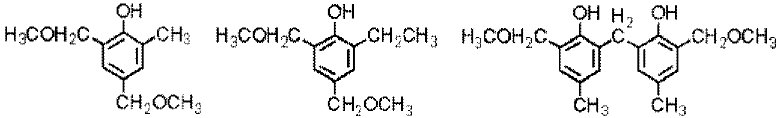

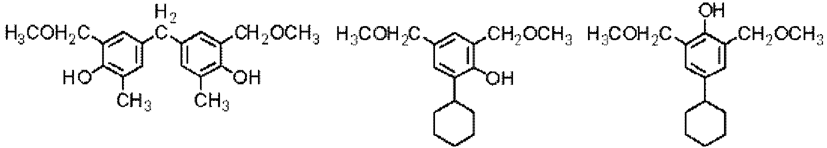

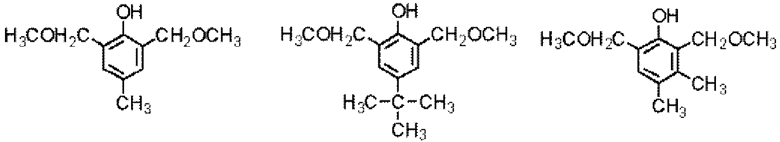

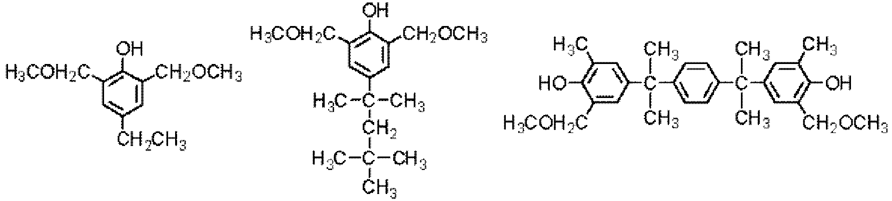

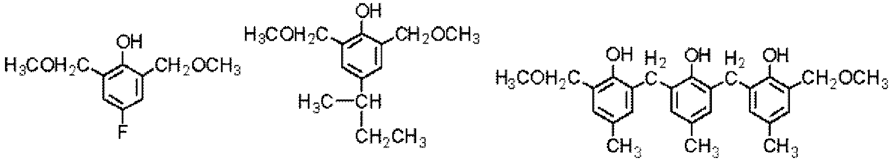

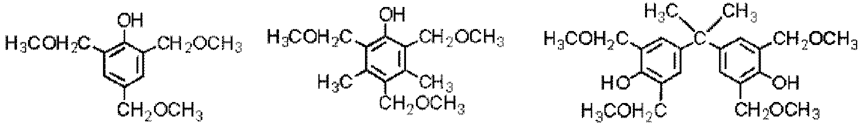

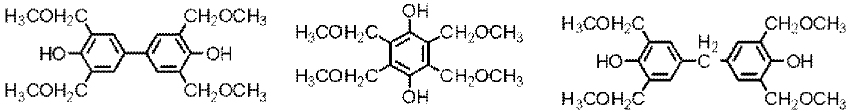

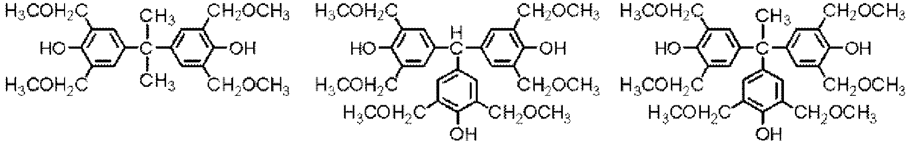

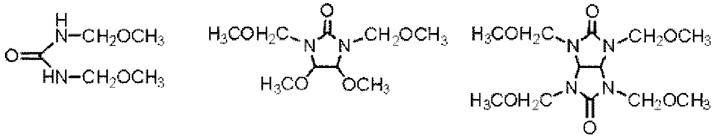

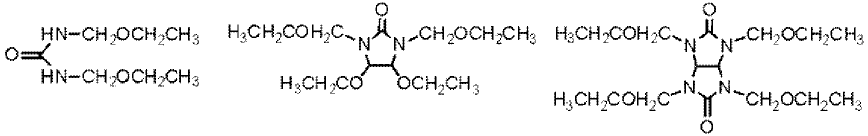

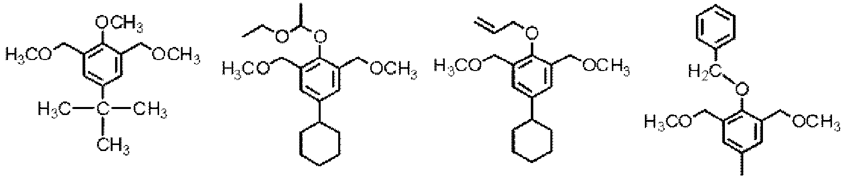

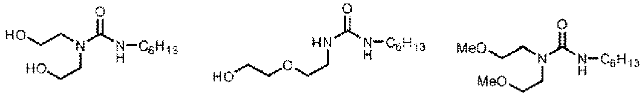

As the compound containing at least one of an alkoxymethyl group and an acyloxymethyl group, a commercially available compound may be used, or a compound synthesized by a publicly known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monoethoxymethylated glycoluril, diethoxymethylated glycoluril, triethoxymethylated glycoluril, tetramethoxymethylated glycoluril, monomethoxymethylated glycoluril, dimethoxymethylated glycoluril, trimethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril,
urea-based crosslinking agents such as bismethoxymethylurea, bisethoxymethylurea, bispropoxymethylurea, and bisbutoxymethylurea,
ethyleneurea-based crosslinking agents such as monohydroxymethylated ethylene urea or dihydroxymethylated ethylene urea, monomethoxymethylated ethylene urea, dimethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, and dibutoxymethylated ethylene urea,
propylene urea-based crosslinking agents such as monohydroxymethylated propylene urea, dihydroxymethylated propylene urea, monomethoxymethylated propylene urea, dimethoxymethylated propylene urea, monoethoxymethylated propylene urea, diethoxymethylated propylene urea, monopropoxymethylated propylene urea, dipropoxymethylated propylene urea, monobutoxymethylated propylene urea, and dibutoxymethylated propylene urea, and
1,3-di(methoxymethyl)-4,5-dihydroxy-2-imidazolidinone, and 1,3-di(methoxymethyl)-4, 5-dimethoxy-2-imidazolidinone.

Specific examples of the benzoguanamine-based crosslinking agent include monohydroxymethylated benzoguanamine, dihydroxymethylated benzoguanamine, trihydroxymethylated benzoguanamine, tetrahydroxymethylated benzoguanamine, monomethoxymethylated benzoguanamine, dimethoxymethylated benzoguanamine, trimethoxymethylated benzoguanamine, tetramethoxymethylated benzoguanamine, monoethoxymethylated benzoguanamine, diethoxymethylated benzoguanamine, triethoxymethylated benzoguanamine, tetraethoxymethylated benzoguanamine, monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether, bis(methoxymethyl)benzophenone, methoxymethylphenyl methoxymethylbenzoate, bis(methoxymethyl)biphenyl, dimethylbis(methoxymethyl)biphenyl, 4,4',4"-ethylidenetris[2,6-bis(methoxymethyl)phenol], 5,5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all of which are manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DMLBisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all of which are manufactured by Honshu Chemical Industry Co., Ltd.), and NIKALAC (registered trademark, the same applies hereinafter) MX-290, NIKALAC MX-280, NIKALAC MX-270, NIKALAC MX-279, NIKALAC MW-100LM, and NIKALAC MX-750LM (all of which are manufactured by Sanwa Chemical Co., Ltd.).

The resin composition according to the embodiment of the present invention preferably contains, as the other crosslinking agent, at least one compound selected from the group consisting of an epoxy compound, an oxetane compound, and a benzoxazine compound.

### - Epoxy compound (compound having epoxy group) -

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the resin composition and the suppression of warping.

The epoxy compound preferably contains a polyethylene oxide group. This makes it possible to further reduce the elastic modulus and suppress the warpage. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trademark, the same applies hereinafter) 850-S, EPICLON HP-4032, EPICLON HP-7200, EPICLON HP-820, EPICLON HP-4700, EPICLON HP-4770, EPICLON EXA-830LVP, EPICLON EXA-8183, EPICLON EXA-8169, EPICLON N-660, EPICLON N-665-EXP-S, and EPICLON N-740 (all of which are trade names, manufactured by DIC Corporation), RIKARESIN (registered trademark, the same applies hereinafter) BEO-20E, RIKARESIN BEO-60E, RIKARESIN HBE-100, RIKARESIN DME-100, and RIKARESIN L-200 (all of which are trade names, manufactured by New Japan Chemical Co., Ltd.), EP-4003S, EP-4000S, EP-4088S, and EP-3950S (all of which are trade names, manufactured by ADEKA Corporation), CELLOXIDE (registered trademark, the same applies hereinafter) 2021P, CELLOXIDE 2081, CELLOXIDE 2000, EHPE3150, EPOLEAD (registered trademark, the same applies hereinafter) GT401, EPOLEAD PB4700, and EPOLEAD PB3600 (all of which are trade names, manufactured by Daicel Corporation), and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BREN-S, and BREN-10S (all of which are trade names, manufactured by Nippon Kayaku Co., Ltd.). In addition, the following compounds are also suitably used.

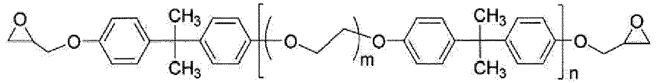

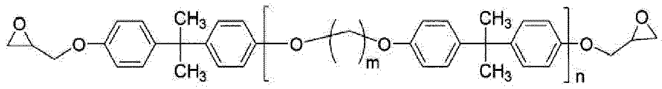

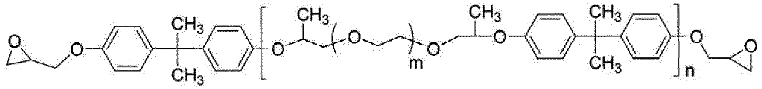

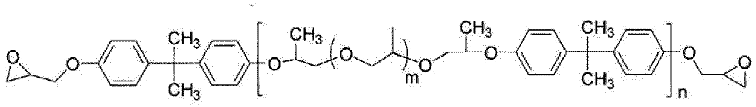

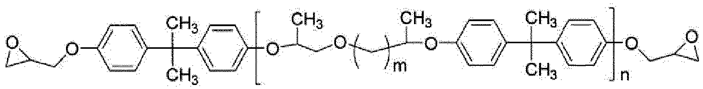

In the formulae, n is an integer of 1 to 5, and m is an integer of 1 to 20.

Among the above structures, n is preferably 1 to 2, and m is preferably 3 to 7 from the viewpoint of achieving both heat resistance and improvement in elongation.

### - Oxetane compound (compound having oxetanyl group) -

Examples of the oxetane compound include a compound having two or more oxetane rings in one molecule, 3-ethyl-3-hydroxymethyloxetane, 1,4-bis{[(3-ethyl-3-oxetanyl)methoxy]methyl}benzene, 3-ethyl-3-(2-ethylhexylmethyl)oxetane, and 1,4-benzenedicarboxylic acid-bis[(3-ethyl-3-oxetanyl)methyl]ester. As specific examples thereof, the ARON OXETANE series (for example, OXT-121 and OXT-221) manufactured by Toagosei Co., Ltd., can be suitably used, and these can be used alone or two or more thereof may be mixedly used.

### - Benzoxazine compound (compound having benzoxazolyl group) -

Due to a crosslinking reaction derived from a ring-opening addition reaction, the benzoxazine compound does not result in degassing during curing and results in decreased thermal contraction, and thus the occurrence of warping is suppressed, which is preferable.

Preferred examples of the benzoxazine compound include P-d type benzoxazine, F-a type benzoxazine (trade names, all of which are manufactured by Shikoku Chemicals Corporation), a benzoxazine adduct of polyhydroxystyrene resin, and a phenol novolac type dihydrobenzoxazine compound. These may be used alone, or two or more thereof may be mixed and used.

The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the resin composition. One kind of the other crosslinking agent may be contained, or two or more kinds thereof may be contained. In a case where two or more kinds of the other crosslinking agents are contained, the total thereof is preferably within the above-described range.

### [Photopolymerization initiator]

The resin composition according to the embodiment of the present invention preferably includes a polymerization initiator. The polymerization initiator may be a thermal polymerization initiator or a photopolymerization initiator; however, it is particularly preferable to contain a photopolymerization initiator.

The photopolymerization initiator is preferably a photoradical polymerization initiator. The photoradical polymerization initiator is not particularly limited and can be appropriately selected from publicly known photoradical polymerization initiators. For example, a photoradical polymerization initiator having photosensitivity to rays ranging from the ultraviolet ray range to the visible light range is preferable. In addition, it may be an activator that acts with a sensitizing agent to generate an active radical.

The photoradical polymerization initiator preferably contains at least one compound having a molar absorption coefficient of at least about 50 L·mol⁻¹·cm⁻¹ within a range of a wavelength of about 240 to 800 nm (preferably 330 to 500 nm). The molar absorption coefficient of a compound can be measured using a well-publicly known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-publicly known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an α-amino ketone compound such as aminoacetophenone, an α-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 of WO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313A, the contents of which are incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodiment of the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in the present specification. In addition, as the acylphosphine oxide, 2,4,6-trimethylbenzoyldiphenylphosphine oxide or the like can also be suitably used. In addition, examples of the commercially available product of the acylphosphine oxide-based initiator include Omnirad TPO and Omnirad TPO-S.

As the α-hydroxy ketone-based initiator, Omnirad 184, Omnirad 1173, Omnirad 2959, Omnirad 127 (all of which manufactured by IGM Resins B.V), IRGACURE 184 (IRGACURE is a registered trademark), DAROCUR 1173, IRGACURE 500, IRGACURE-2959, and IRGACURE 127 (all of which manufactured by BASF SE) can be used.

As the α-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (all of which are manufactured by BASF SE) can be used.

As the aminoacetophenone-based initiator, the acylphosphine oxide-based initiator, and the metallocene compound, it is also possible to suitably use, for example, the compounds described in paragraphs 0161 to 0163 of WO2021/112189A. The content thereof is incorporated in the present specification.

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, and the compounds described in WO2013/167515A, the content of which is incorporated in the present specification.

Preferred examples of the oxime compound include a compound having the following structure, 3-(benzoyloxy(imino))butane-2-one, 3-(acetoxy(imino))butane-2-one, 3-(propionyloxy(imino))butane-2-one, 2-(acetoxy(imino))pentane-3-one, 2-(acetoxy(imino))-1-phenylpropane-1-one, 2-(benzoyloxy(imino))-1-phenylpropane-1-one, 3-((4-toluenesulfonyloxy)imino)butane-2-one, 2-(ethoxycarbonyloxy(imino))-1-phenylpropane-1-one, 5-(4-isopropylphenylthio)-1,2-indandione, and 2-(O-acetyl)oxime. In the resin composition, it is preferable to use an oxime compound, particularly as a photoradical polymerization initiator. The oxime compound as a photoradical polymerization initiator has a linking group of >C=N-O-C(=O)- in the molecule.

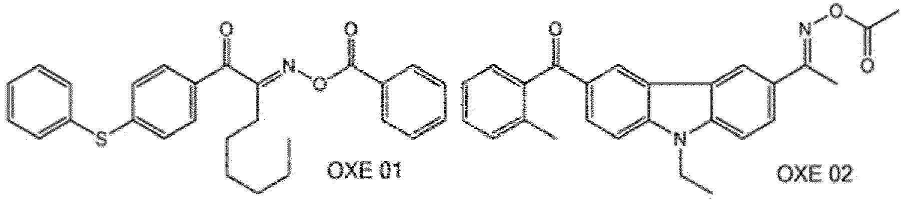

Examples of the commercially available product of the oxime compound include IRGACURE OXE 01, IRGACURE OXE 02, IRGACURE OXE 03, and IRGACURE OXE 04 (all of which are manufactured by BASF SE), Omnirad 1312 and Omnirad 1316 (both of which are manufactured by IGM Resins B.V), ADEKA OPTOMER N-1919 (manufactured by ADEKA Corporation, the photoradical polymerization initiator described in JP2012-014052A), TR-PBG-304, TR-PBG-305, and TR-PBG-3057 (all of which are manufactured by Changzhou Tronly New Electronic Materials Co., Ltd.), ADEKA ARKLS NCI-730, NCI-831, and ADEKA ARKLS NCI-930 (all of which are manufactured by ADEKA Corporation), DFI-091 (manufactured by DAITO CHEMIX Co., Ltd.), and SpeedCure PDO (manufactured by SARTOMER ARKEMA). In addition, oxime compounds having the following structures can also be used.

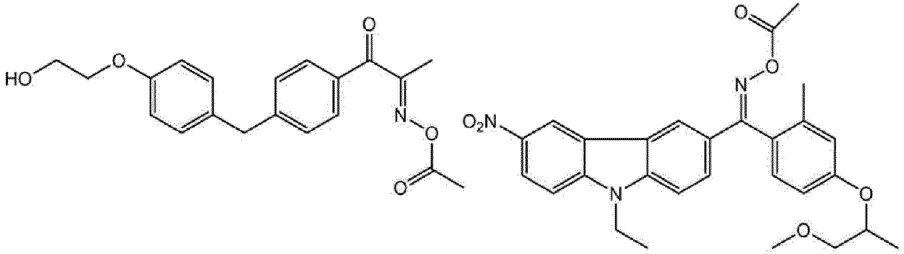

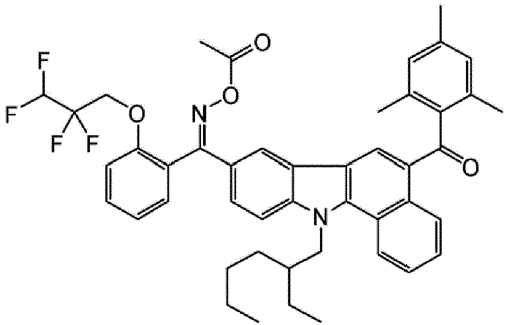

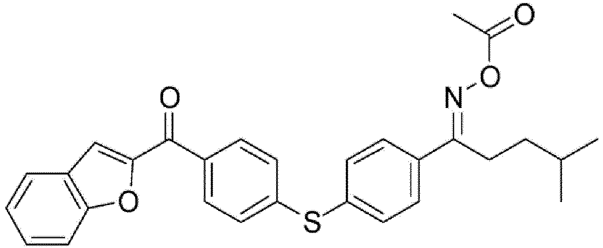

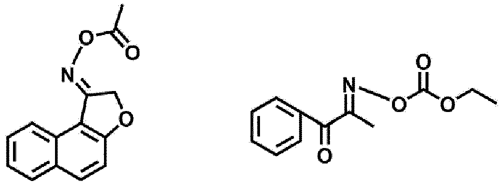

As the photoradical polymerization initiator, it is also possible to use, for example, the oxime compounds having a fluorene ring, which are described in paragraphs 0169 to 0171 of WO2021/112189A, an oxime compound having a skeleton in which at least one benzene ring of a carbazole ring is a naphthalene ring, or an oxime compound having a fluorine atom.

In addition, it is also possible to use the oxime compounds having a nitro group, which are described in paragraphs 0208 to 0210 of WO2021/020359A, an oxime compound having a benzofuran skeleton, or an oxime compound in which a substituent having a hydroxy group is bonded to a carbazole skeleton. The content thereof is incorporated in the present specification.

As the photopolymerization initiator, an oxime compound having an aromatic ring group Ar^{OX1} in which an electron withdrawing group is introduced into an aromatic ring (hereinafter, also referred to as an oxime compound OX) can also be used. Examples of the electron withdrawing group contained in the aromatic ring group Ar^{OX1} include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula (OX¹) or a compound represented by Formula (OX²), and more preferably a compound represented by Formula (OX²).

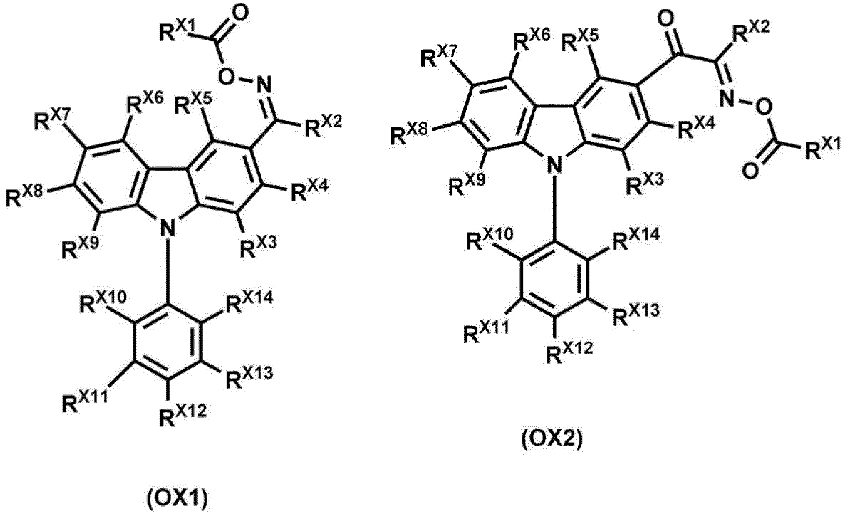

In the formulae, R^{X1} represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group,
R^{X2} represents an alkyl group, an alkenyl group, an alkoxy group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy group, or an amino group, and
R^{X3} to R^{X14} each independently represent a hydrogen atom or a substituent.

However, at least one of R^{X10}, ..., or R^{X14} is an electron withdrawing group.

In the above formulae, it is preferable that R^{X12} is an electron withdrawing group, and R^{X10}, R^{X11}, R^{X13}, and R^{X14} are a hydrogen atom.

Specific examples of the oxime compound OX include the compounds described in paragraph Nos. 0083 to 0105 of JP4600600B, the content of which is incorporated in the present specification.

Examples of the particularly preferred oxime compound include the oxime compound having a specific substituent described in JP2007-269779A and the oxime compound having a thioaryl group described in JP2009-191061A, the contents of which are incorporated in the present specification.

From the viewpoint of exposure sensitivity, the photoradical polymerization initiator is preferably a compound selected from the group consisting of a trihalomethyltriazine compound, a benzyl dimethyl ketal compound, an α-hydroxy ketone compound, an α-aminoketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

In addition, the photoradical polymerization initiator is a trihalomethyltriazine compound, an α-aminoketone compound, an acylphosphine compound, a phosphine oxide compound, a metallocene compound, an oxime compound, a triaryl imidazole dimer, an onium salt compound, a benzophenone compound, or an acetophenone compound. It is more preferably at least one compound selected from the group consisting of a trihalomethyltriazine compound, an α-aminoketone compound, a metallocene compound, an oxime compound, a triaryl imidazole dimer, and a benzophenone compound, and still more preferably a metallocene compound or an oxime compound.

As the photoradical polymerization initiator, the compounds described in paragraphs 0175 to 0179 of WO2021/020359A and the compounds described in paragraphs 0048 to 0055 of WO2015/125469A can also be used, the contents of which are incorporated in the present specification.

As the photoradical polymerization initiator, a photoradical polymerization initiator which is difunctional or tri- or higher functional may be used. In a case where such a photoradical polymerization initiator is used, two or more radicals are generated from one molecule of the photoradical polymerization initiator, and thus good sensitivity is obtained. Further, in a case where a compound having an asymmetric structure is used, the crystallinity is reduced, the solubility in a solvent or the like is improved, and the compound is hardly precipitated over time, which makes it possible to improve the temporal stability of the resin composition. Specific examples of the photoradical polymerization initiator which is difunctional or tri- or higher functional include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A, the compound (E) and compound (G) described in JP2013-522445A, Cmpd 1 to 7 described in WO2016/034963A, the oxime ester photoinitiators described in paragraph No. 0007 of JP2017-523465A, the photoinitiators described in paragraph Nos. 0020 to 0033 of JP2017-167399A, the photopolymerization initiator (A) described in paragraph Nos. 0017 to 0026 of JP2017-151342A, and the oxime ester photoinitiator described in JP6469669B, the contents of which are incorporated in the present specification.

In a case where the resin composition contains a photopolymerization initiator, the content thereof is preferably 0.1% to 30% by mass, more preferably 0.1% to 20% by mass, still more preferably 0.5% to 15% by mass, and even still more preferably 1.0% to 10% by mass with respect to the total solid content of the resin composition with respect to the total solid content of the resin composition. Only one kind of photopolymerization initiator may be contained, or two or more kinds thereof may be contained. In a case where two or more kinds of photopolymerization initiators are contained, the total amount thereof is preferably within the above-described range.

It is noted that since the photopolymerization initiator may also function as a thermal polymerization initiator, crosslinking with the photopolymerization initiator may be further allowed to proceed by heating an oven, a hot plate, or the like.

### [Sensitizing agent]

The resin composition may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based, a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a cyanine-based, a phenothiazine-based, a pyrrolopyrazole azomethine-based, a xanthene-based, a phthalocyanine-based, a benzopyran-based, and an indigo-based compound can be used.

Examples of the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.

In addition, other sensitizing dyes may be used.

For details of the sensitizing dye, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass with respect to the total solid content of the resin composition. One kind of sensitizing agent may be used alone, or two or more kinds thereof may be used in combination.

### [Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, the following compound is used; a group of compounds having -S-S-, -SO₂-S-, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be preferably used.

In addition, as the chain transfer agent, the compounds described in paragraphs 0152 and 0153 of WO2015/199219A can also be used, the content of which is incorporated in the present specification.

In a case where the resin composition has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition. One kind of chain transfer agent may be used, or two or more kinds thereof may be used. In a case where two or more kinds of chain transfer agents are used, the total thereof is preferably within the above-described range.

### <Base generator>

The resin composition according to the embodiment of the present invention may contain a base generator. Here, the base generator is a compound that is capable of generating a base under a physical or chemical action. Examples of the preferred base generator include a thermal base generator and a photobase generator.

In a case where the resin composition contains a thermal-base generator, it is possible to, for example, accelerate the cyclization reaction of the precursor by heating, whereby the mechanical characteristics and chemical resistance of the cured substance are improved and for example, the performance as an interlayer insulating film for a re-distribution layer, included in a semiconductor package, is improved.

The base generator may be an ionic base generator or may be a nonionic base generator. Examples of the base that is generated from the base generator include a secondary amine and a tertiary amine.

The base generator is not particularly limited, and a publicly known base generator can be used. Examples of the publicly known base generator include a carbamoyloxime compound, a carbamoylhydroxylamine compound, a carbamic acid compound, a formamide compound, an acetamide compound, a carbamate compound, a benzylcarbamate compound, a nitrobenzylcarbamate compound, a sulfonamide compound, an imidazole derivative compound, an aminimide compound, a pyridine derivative compound, an α-aminoacetophenone derivative compound, a quaternary ammonium salt derivative compound, an iminium salt, a pyridinium salt, an α-lactone ring derivative compound, a phthalimide derivative compound, and an acyloxyimino compound.

The nonionic base generator is, for example, preferably the compounds represented by Formula (B1) or Formula (B2), which are described in paragraphs 0275 to 0285 of WO2021/112189A, or the compounds represented by Formula (N1), which is described in paragraphs 0102 to 00162 of WO2020/066416A, and the base generators is preferably the thermal-base generators described in paragraphs 0013 to 0041 of WO2020/054226A.

The content thereof is incorporated in the present specification.

Examples of the base generator include the following compounds; however, the base generator is not limited thereto.

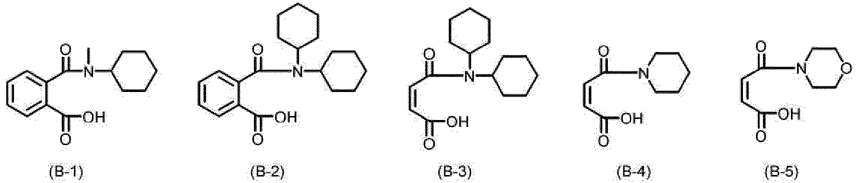

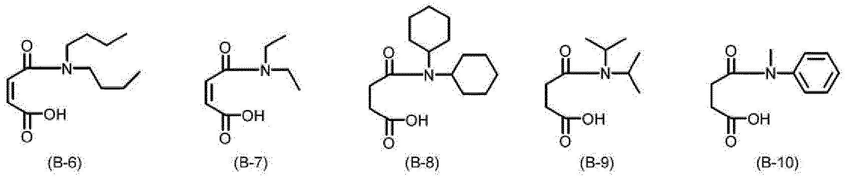

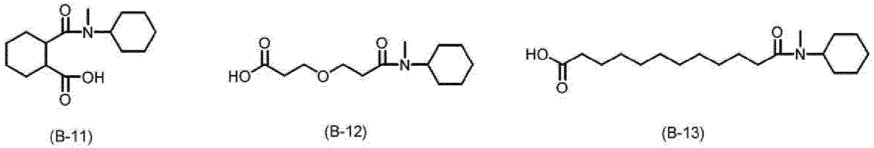

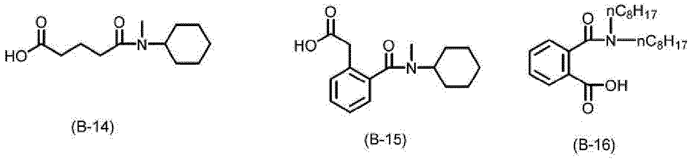

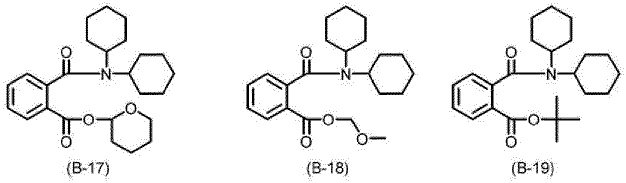

The molecular weight of the nonionic base generator is preferably 800 or less, more preferably 600 or less, and still more preferably 500 or less. The lower limit thereof is preferably 100 or more, more preferably 200 or more, and still more preferably 300 or more.

Examples of the specific preferred compound of the ionic base generator include the compounds described in paragraphs 0148 to 0163 of WO2018/038002A.

Specific examples of the ammonium salt include the following compounds; however, the ammonium salt is not limited thereto.

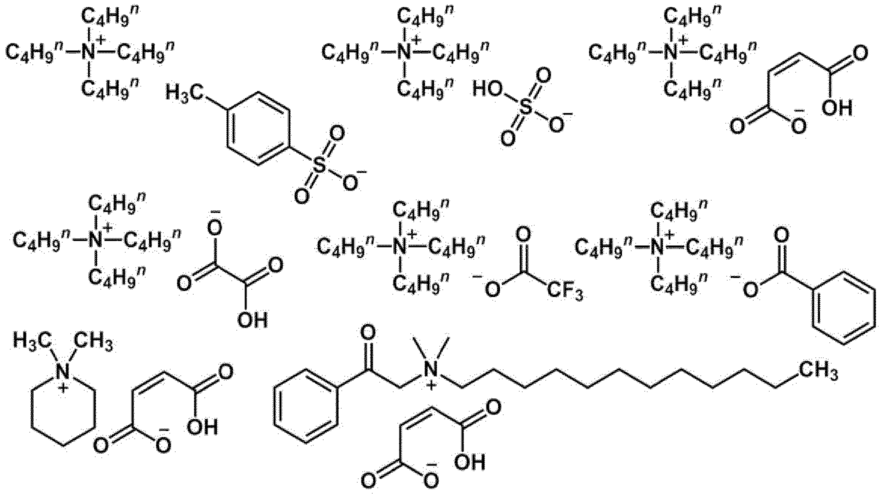

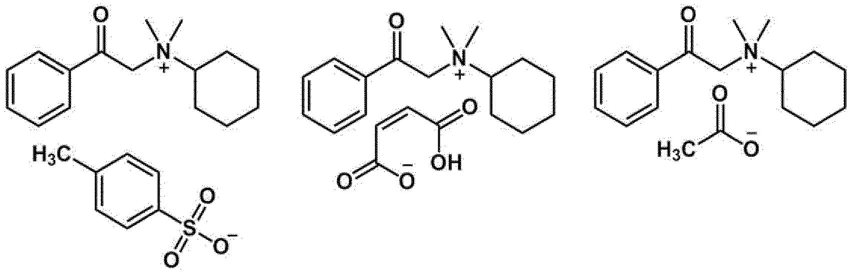

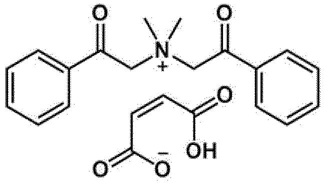

Specific examples of the iminium salt include the following compounds; however, the iminium salt is not limited thereto.

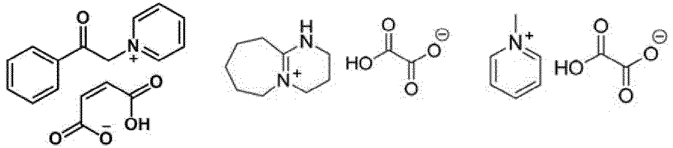

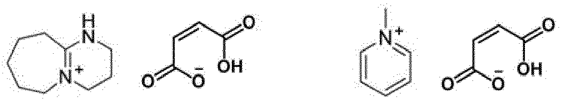

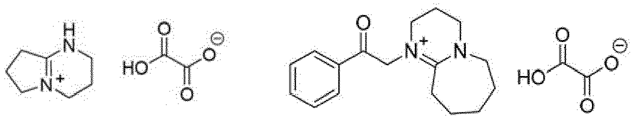

In a case where the resin composition contains a base generator, the content of the base generator is preferably 0.1 to 50 parts by mass with respect to 100 parts by mass of the resin in the resin composition. The lower limit thereof is more preferably 0.3 parts by mass or more and still more preferably 0.5 parts by mass or more. The upper limit thereof is more preferably 30 parts by mass or less, still more preferably 20 parts by mass or less, even still more preferably 10 parts by mass or less, even further still more preferably 5 parts by mass or less, and particularly preferably 4 parts by mass or less.

One kind or two or more kinds of base generators can be used. In a case where two or more kinds thereof are used, the total amount is preferably within the above-described range.

### <Solvent>

The resin composition according to the embodiment of the present invention preferably contains a solvent.

As the solvent, any publicly known solvent can be used. The solvent is preferably an organic solvent. Examples of the organic solvent include compounds such as esters, ethers, ketones, cyclic hydrocarbons, sulfoxides, amides, ureas, and alcohols.

Suitable examples of the esters include ethyl acetate, n-butyl acetate, isobutyl acetate, hexyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate, and dipropylene glycol dimethyl ether.

Suitable examples of the ketones include methyl ethyl ketone, cyclohexanone, cyclopentanone, 2-heptanone, 3-heptanone, 3-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the amide include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropionamide, 3-butoxy-N,N-dimethylpropionamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, N-methyl-2-pyrrolidone, propylene glycol methyl ether, and propylene glycol methyl ether acetate, levoglucosenone, or dihydrolevoglucosenone, or a mixed solvent composed of two or more solvents selected therefrom. It is particularly preferable to use dimethyl sulfoxide and γ-butyrolactone in combination, or N-methyl-2-pyrrolidone and ethyl lactate in combination.

Regarding the content of the solvent, the amount of the solvent is such that, from the viewpoint of coatability, the concentration of the total solid contents of the resin composition according to the embodiment of the present invention is preferably 5% to 80% by mass, more preferably 5% to 75% by mass, still more preferably 10% to 70% by mass, and even still more preferably 20% to 70% by mass. The content of the solvent may be adjusted depending on the desired thickness of the coating film and the coating method. In a case where two or more kinds of solvents are contained, the total thereof is preferably within the above-described range.

### <Metal adhesiveness improving agent>

From the viewpoint of improving adhesiveness to a metal material used for an electrode, a wire, or the like, the resin composition according to the embodiment of the present invention preferably contains a metal adhesiveness improving agent. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

### [Silane coupling agent]

Examples of the silane coupling agent include the compounds described in paragraph 0316 of WO2021/112189A and the compounds described in paragraphs 0067 to 0078 of JP2018-173573A, the contents of which are incorporated in the present specification. In addition, it is also preferable to use two or more kinds of different silane coupling agents as described in paragraphs 0050 to 0058 of JP2011-128358A. It is also preferable to use the following compound as the silane coupling agent. In the following formulae, Me represents a methyl group, and Et represents an ethyl group. In addition, examples of R shown below include a structure derived from a blocking agent in a blocked isocyanate group. The blocking agent may be selected depending on the desorption temperature; however, examples thereof include an alcohol compound, a phenol compound, a pyrazole compound, a triazole compound, a lactam compound, and an active methylene compound. It is preferably caprolactam or the like, for example, from the viewpoint of setting the desorption temperature to 160°C to 180°C. Examples of the commercially available product of such a compound include X-12-1293 (manufactured by Shin-Etsu Chemical Co., Ltd.).

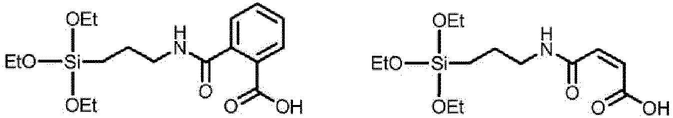

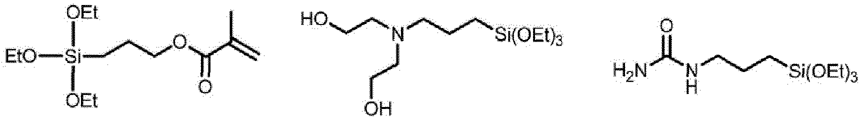

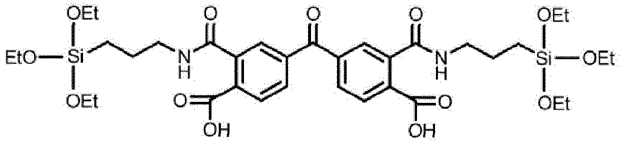

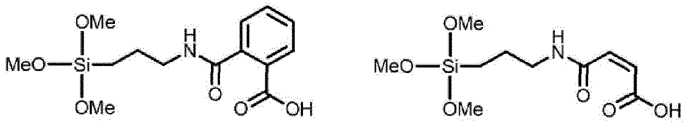

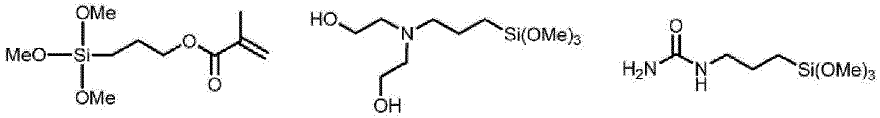

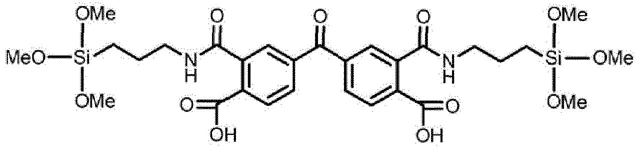

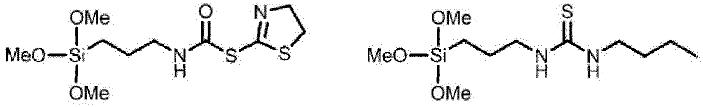

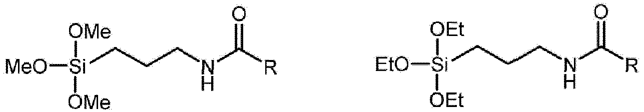

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, tris-(trimethoxysilylpropyl)isocyanurate, 3-ureidopropyltrialkoxysilane, 3-mercaptopropylmethyldimethoxysilane, 3-mercaptopropyltrimethoxysilane, 3-isocyanatepropyltriethoxysilane, and 3-trimethoxysilylpropylsuccinic acid anhydride. These can be used alone or in a combination of two or more thereof.

In addition, an oligomer type compound having a plurality of alkoxysilyl groups can also be used as the silane coupling agent.

Examples of such an oligomer type compound include a compound containing a repeating unit represented by Formula (S-1).

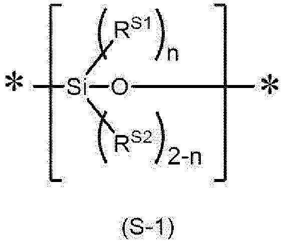

In Formula (S-1), R^{S1} represents a monovalent organic group, R^{S2} represents a hydrogen atom, a hydroxy group, or an alkoxy group, and n represents an integer of 0 to 2.

R^{S1} preferably has a structure including a polymerizable group. Examples of the polymerizable group include a group having an ethylenically unsaturated bond, an epoxy group, an oxetanyl group, a benzoxazolyl group, a blocked isocyanate group, and an amino group. Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, and a (meth)acrylamide group, a (meth)acryloyloxy group, where a vinylphenyl group, a (meth)acrylamide group, or a (meth)acryloyloxy group is preferable, a vinylphenyl group or a (meth)acryloyloxy group is more preferable, and a (meth)acryloyloxy group is still more preferable.

R^{S2} is preferably an alkoxy group, and more preferably a methoxy group or an ethoxy group.

n represents an integer of 0 to 2, and it is preferably 1.

Here, structures of a plurality of repeating units represented by Formula (S-1) may be the same, where the plurality of repeating units are contained in the oligomer type compound.

Here, among a plurality of repeating units represented by Formula (S-1), which are contained in the oligomer type compound, it is preferable that at least one repeating unit has n of 1 or 2, it is more preferable that at least two repeating units have n of 1 or 2, and it is still more preferable that at least two repeating units have n of 1.

As such an oligomer type compound, a commercially available product can be used, and examples thereof include KR-513 (manufactured by Shin-Etsu Chemical Co., Ltd.).

### [Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

As another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably 0.01 to 30 parts by mass, more preferably 0.1 to 10 parts by mass, and still more preferably 0.5 to 5 parts by mass with respect to 100 parts by mass of the specific resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical characteristics are exhibited. One kind of metal adhesiveness improving agent may be used, or two or more kinds thereof may be used. In a case where two or more kinds thereof are used, the total content thereof is preferably within the above-described range.

### <Migration suppressing agent>

The resin composition according to the embodiment of the present invention preferably further contains a migration suppressing agent. For example, in a case where the resin composition is applied to a metal layer (or a metal wiring line) to form a film, it is possible to effectively suppress the migration of metal ions derived from the metal layer (or the metal wiring line) into the film, in a case where a migration suppressing agent is contained.

The migration suppressing agent is not particularly limited; however, examples thereof include a compound having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), a compound having thioureas and a sulfanyl group, a hindered phenol-based compound, a salicylic acid derivative-based compound, and a hydrazide derivative-based compound. In particular, it is possible to preferably use a triazole-based compound such as 1,2,4-triazole, benzotriazole, 3-amino-1,2,4-triazole, or 3,5-diamino-1,2,4-triazole, or a tetrazole-based compound such as 1H-tetrazole, 5-phenyltetrazole or 5-amino-1H-tetrazole.

As the migration suppressing agent, an ion trap agent that captures an anion such as a halogen ion can also be used.

As other migration suppressing agents, for example, the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, the compounds described in paragraph 0166 of WO2015/199219A, or the like can be used, the contents of which are incorporated in the present specification.

Specific examples of the migration suppressing agent include the following compounds.

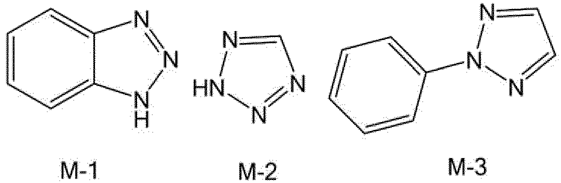

In a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition.

One kind of migration suppressing agent may be used alone, or two or more kinds thereof may be used. In a case where two or more kinds of migration suppressing agents are used, the total thereof is preferably within the above-described range.

### <Polymerization Inhibitor>

The resin composition according to the embodiment of the present invention preferably contains a polymerization inhibitor. Examples of the polymerization inhibitor include a phenol-based compound, a quinone-based compound, an amino-based compound, an N-oxyl-free radical-based compound, a nitro-based compound, a nitroso-based compound, a heteroaromatic ring-based compound, and a metal compound.

Examples of the specific compound of the polymerization inhibitor include the compounds described in paragraph 0310 of WO2021/112189A, p-hydroquinone, o-hydroquinone, 4-hydroxy-2,2,6,6-tetramethylpiperidine 1-oxyl free radical, phenoxazine, and tris(2,6-dimethyl-3-hydroxy-4-tert-butyl-benzyl)isocyanurate. The content thereof is incorporated in the present specification.

In a case where the resin composition according to the embodiment of the present invention has a polymerization inhibitor, the content of the polymerization inhibitor is preferably 0.01% to 20% by mass, more preferably 0.02% to 15% by mass, and still more preferably 0.05% to 10% by mass, with respect to the total solid content of the resin composition.

One kind of polymerization inhibitor may be used, or two or more kinds thereof may be used. In a case where two or more kinds of polymerization inhibitors are used, the total thereof is preferably within the above-described range.

### <Other additives>

The resin composition according to the embodiment of the present invention may contain various additives as necessary, for example, a surfactant, a higher fatty acid derivative, a thermal polymerization initiator, inorganic particles, an ultraviolet absorbing agent, an organic titanium compounds, an antioxidant, an aggregation inhibitor, a phenol-based compound, another polymer compound, a plasticizer, and other auxiliary agents (for example, an anti-foaming agent, and a flame retardant) within the scope in which the effect of the present invention is obtained. By appropriately containing these components, properties such as film properties can be adjusted. The details of the components can be found in, for example, paragraph "0183" and subsequent paragraphs of JP2012-003225A (corresponding to paragraph 0237 of US2013/0034812A) and paragraphs 0101 to 0104 and 0107 to 0109 of JP2008-250074A, the contents of which are incorporated in the present specification. In a case where these additives are blended, the total content thereof is preferably 3% by mass or less of the solid content of the resin composition according to the embodiment of the present invention.

### [Surfactant]

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

In a case where a surfactant is contained in the resin composition according to the embodiment of the present invention, the liquid characteristics (particularly, the fluidity) in a case where a coating liquid composition is prepared are further improved, and thus the uniformity of the coating thickness and the liquid saving property can be further improved. That is, in a case where a film is formed using a coating liquid containing a surfactant is applied, the interfacial tension between a surface to be coated and a coating liquid is reduced, the wettability to the surface to be coated is improved, and thus the coatability to the surface to be coated is improved. Therefore, it is possible to more suitably form a uniform film having a small thickness unevenness.

Examples of the fluorine-based surfactant include the compounds described in paragraph 0328 of WO2021/112189A, the contents of which are incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples thereof include the following compounds.

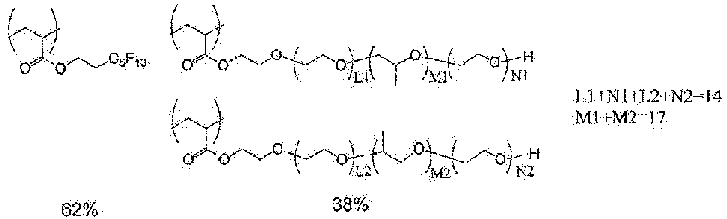

The weight-average molecular weight of the above-described compound is preferably 3,000 to 50,000 and more preferably 5,000 to 30,000.

Regarding the fluorine-based surfactant, a fluorine-containing polymer having an ethylenically unsaturated bond in the side chain can also be used as the fluorine-based surfactant. Specific examples thereof include the compounds described in paragraphs 0050 to 0090 and paragraphs 0289 to 0295 of JP2010-164965A, the content of which is incorporated in the present specification. Further, examples of the commercially available product thereof include MEGAFACE RS-101, RS-102, and RS-718K, all manufactured by DIC Corporation.

The content of fluorine in the fluorine-based surfactant is preferably 3% to 40% by mass, more preferably 5% to 30% by mass, and particularly preferably 7% to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of the silicone-based surfactant, the hydrocarbon-based surfactant, the nonionic surfactant, the cationic surfactant, and the anionic surfactant include the compounds described in paragraphs 0329 to 0334 of WO2021/112189A, the contents of which are incorporated in the present specification.

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

### [Higher fatty acid derivative]

In the resin composition according to the embodiment of the present invention, in order to prevent polymerization inhibition due to oxygen, a higher fatty acid derivative such as behenic acid or behenic acid amide may be added and be caused to be present at a higher density on the surface of the resin composition according to the embodiment of the present invention in the process of drying after coating.

In addition, as the higher fatty acid derivative, the compounds described in paragraph 0155 of WO2015/199219A can also be used, the content of which is incorporated in the present specification.

In a case where the resin composition has a higher fatty acid derivative, the content of the higher fatty acid derivative is preferably 0.1% to 10% by mass with respect to the total solid content of the resin composition. One kind of higher fatty acid derivative may be used, or two or more kinds thereof may be used. In a case where two or more kinds of higher fatty acid derivatives are used, the total thereof is preferably within the above-described range.

### [Thermal polymerization initiator]

Examples of the thermal polymerization initiator include a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and thus the solvent resistance can be further improved. In addition, there is a case where the photopolymerization initiator also has a function of initiating polymerization by heat, and thus there is a case where it can be added as a thermal polymerization initiator.

Specific examples of thermal radical polymerization initiator include compounds described in paragraphs 0074 to 0118 of JP2008-063554A, the content of which is incorporated in the present specification.

In a case where a thermal polymerization initiator is contained, the content thereof is preferably 0.1% to 30% by mass, more preferably 0.1% to 20% by mass, and still more preferably 0.5% to 15% by mass with respect to the total solid content of the resin composition. Only one kind of thermal polymerization initiator may be contained, or two or more kinds thereof may be contained. In a case where two or more kinds of thermal polymerization initiators are contained, the total amount thereof is preferably within the above-described range.

### [Inorganic particle]

Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, and glass.

The average particle diameter of the inorganic particles is preferably 0.01 to 2.0 µm, more preferably 0.02 to 1.5 µm, still more preferably 0.03 to 1.0 µm, and particularly preferably 0.04 to 0.5 µm.

The average particle diameter of the inorganic particles is the primary particle diameter and the volume average particle diameter. The volume average particle diameter can be measured by, for example, a dynamic light scattering method with Nanotrac WAVE II EX-150 (manufactured by Nikkiso Co., Ltd.).

In a case where the above measurement is difficult, the measurement can also be carried out by a centrifugal sedimentation light transmission method, an X-ray transmission method, or a laser diffraction/light scattering method.

### [Ultraviolet absorbing agent]

Examples of the ultraviolet absorbing agent include a salicylate-based ultraviolet absorbing agent, a benzophenone-based ultraviolet absorbing agent, a benzotriazole-based ultraviolet absorbing agent, a substituted acrylonitrile-based ultraviolet absorbing agent, and a triazine-based ultraviolet absorbing agent.

Specific examples of the ultraviolet absorbing agent include the compounds described in paragraphs 0341 and 0342 of WO2021/112189A, the contents of which are incorporated in the present specification.

One kind of the ultraviolet absorbing agent may be used alone, or two or more kinds thereof may be used in combination.

In a case where the resin composition contains an ultraviolet absorbing agent, the content of the ultraviolet absorbing agent is preferably 0.001% by mass or more and 1% by mass or less, and more preferably 0.01% by mass or more and 0.1% by mass or less with respect to the total solid content mass of the resin composition.

### [Organic titanium compound]

In a case where the resin composition contains an organic titanium compound, it is possible to form a resin layer having excellent chemical resistance even in a case where curing is carried out at a low temperature.

Examples of the usable organic titanium compound include those in which an organic group is bonded to a titanium atom through a covalent bond or an ionic bond.

Specific examples of the organic titanium compound are described in I) to VII) below.
I) Titanium chelate compounds: a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).
II) Tetraalkoxytitanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), titanium tetrastearyloxide, and titanium tetrakis[bis{2,2-(aryloxymethyl)butoxide}].
III) Titanocene compounds: examples thereof include pentamethylcyclopentadienyl titanium trimethoxide, bis(η5-2,4-cyclopentadien-1-yl)bis(2,6-difluorophenyl)titanium, and bis(η5-2,4-cyclopentadien-1-yl)bis(2,6-difluoro-3-(1H-pyrrol-1-yl)phenyl)titanium.
IV) Monoalkoxytitanium compounds: examples thereof include titanium tris(dioctyl phosphate)isopropoxide, and titanium tris(dodecylbenzene sulfonate)isopropoxide.
V) Titanium oxide compounds: examples thereof include titanium oxide bis(pentanedionate), titanium oxide bis(tetramethylheptandionate), and phthalocyanine titanium oxide.
VI) Titanium tetraacetylacetonate compounds: examples thereof include titanium tetraacetylacetonate.
VII) Titanate coupling agents: examples thereof include isopropyltridodecylbenzenesulfonyl titanate.

Among these, it is preferable that the organic titanium compound is at least one compound selected from the group consisting of the above-described I) titanium chelate compound, II) tetraalkoxytitanium compound, and III) titanocene compound, from the viewpoint of more favorable chemical resistance. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.

In a case of containing an organic titanium compound, the content thereof is preferably 0.05 to 10 parts by mass and more preferably 0.1 to 2 parts by mass with respect to 100 parts by mass of the specific resin. In a case where the content thereof is 0.05 parts by mass or more, the heat resistance and the chemical resistance of the cured pattern to be obtained are further improved, and in a case where the content thereof is 10 parts by mass or less, the storage stability of the composition is more excellent.

### [Antioxidant]

In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. Specific examples of the antioxidant include the compounds described in paragraphs 0348 to 0357 of WO2021/112189A, the contents of which are incorporated in the present specification.

The content of the antioxidant is preferably 0.1 to 10 parts by mass and more preferably 0.5 to 5 parts by mass with respect to 100% parts by mass of the specific resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

### [Aggregation inhibitor]

Examples of the aggregation inhibitor include sodium polyacrylate.

One kind of the aggregation inhibitor may be used alone, or two or more kinds thereof may be used in combination.

In a case where the resin composition contains an aggregation inhibitor, the content of the aggregation inhibitor is preferably 0.01% by mass or more and 10% by mass or less, and more preferably 0.02% by mass or more and 5% by mass or less with respect to the total solid content mass of the resin composition.

### [Phenol-based compound]

Examples of the phenol-based compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X (all of which are trade names, manufactured by Honshu Chemical Industry Co., Ltd.), BIP-PC, BIR-PC, BIR-PTBP, and BIR-BIPC-F (all of which are trade names, manufactured by ASAHI YUKIZAI Corporation).

One kind of the phenol-based compound may be used alone, or two or more kinds thereof may be used in combination.

In a case where the resin composition contains a phenol-based compound, the content of the phenol-based compound is preferably 0.01% by mass or more and 30% by mass less and more preferably 0.02% by mass or more and 20% by mass or less with respect to the total solid content mass of the resin composition.

### [Other polymer compound A]

Examples of the other polymer compound include a siloxane resin, a (meth)acrylic polymer obtained by copolymerizing (meth)acrylic acid, a novolac resin, a resol resin, a polyhydroxystyrene resin, and a copolymer thereof. The other polymer compound may be a modified product into which a crosslinking group such as a methylol group, an alkoxymethyl group, or an epoxy group has been introduced.

One kind of the other polymer compound may be used alone, or two or more kinds thereof may be used in combination.

In a case where the resin composition contains the other polymer compound, the content of the other polymer compound is preferably 0.01% by mass or more and 30% by mass or less and more preferably 0.02% by mass or more and 20% by mass or less with respect to the total solid content mass of the resin composition.

### <Characteristics of resin composition>

The viscosity of the resin composition according to the embodiment of the present invention can be adjusted by adjusting the concentration of solid contents of the resin composition. From the viewpoint of the coating film thickness, it is preferably 1,000 mm²/s to 12,000 mm²/s, more preferably 2,000 mm²/s to 10,000 mm²/s, and still more preferably 2,500 mm²/s to 8,000 mm²/s. Within the above range, it is easy to obtain a coating film having high uniformity. In a case of being 1,000 mm²/s or more, it is easy to carry out coating at a film thickness to be required as, for example, an insulating film for re-distribution of a wiring line, and in a case of being 12,000 mm²/s or less, a coating film having an excellent coating surface shape is obtained.

### <Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.

Examples of the method of maintaining the moisture content include adjusting the humidity under storage conditions and reducing the void ratio of the storage container during storage.

From the viewpoint of insulating properties, the metal content of the resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.

In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.

In the resin composition according to the embodiment of the present invention, in a case of considering the use application as a semiconductor material, the content of halogen atoms is preferably less than 500 ppm by mass, more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.

Preferred examples of the method of adjusting the content of halogen atoms include ion exchange treatment.

A storage container publicly known in the related art can be used as a storage container for the resin composition according to the embodiment of the present invention. As the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

### <Cured substance of resin composition>

In a case of curing the resin composition according to the embodiment of the present invention, it is possible to obtain a cured substance of the resin composition.

The cured substance according to the first aspect of the present invention is a cured substance that is obtained by curing the resin composition.

The curing of the resin composition is preferably carried out by heating. The heating temperature is more preferably 120°C to 400°C, still more preferably 140°C to 380°C, and particularly preferably 170°C to 350°C. The form of the cured substance of the resin composition is not particularly limited and can be selected depending on the use application, where the form includes a film shape, a rod shape, a spherical shape, a pellet shape, and the like. In the present invention, the cured substance preferably has a film shape. The shape of the cured substance can also be selected depending on the use application by the pattern processing of the resin composition, where the use application includes the formation of a protective film on a wall surface, formation of via holes for conduction, adjustment of impedance, electrostatic capacity, or internal stress, and impartment of heat radiation function. The film thickness of the cured substance (the film consisting of the cured substance) is preferably 0.5 µm or more and 150 µm or less.

The shrinkage ratio of the resin composition according to the embodiment of the present invention after curing is preferably 50% or less, more preferably 45% or less, and still more preferably 40% or less. Here, the shrinkage ratio refers to a percentage of a change in the volume of the resin composition before and after curing, and it can be calculated according to the following expression.$Shrinkage ratio \left[%\right] = 100 - \left(volume after curing/volume before curing\right) \times 100$

The cured substance according to the second aspect of the present invention satisfies all of the following condition (i) to condition (iv).

It is preferable that the cured substance according to the first aspect of the present invention satisfies all of the following condition (i) to condition (iv).

Condition (i): A Young's modulus of the cured substance is 3.5 GPa or more.

Condition (ii): A coefficient of thermal expansion of the cured substance in a temperature range of 25°C to 125°C is less than 50 ppm/°C.

Condition (iii): A glass transition temperature of the cured substance is 240°C or higher.

Condition (iv): A breaking elongation of the cured substance is 40% or more.

Here, the preferred aspects and the measuring methods for the Young's modulus, the coefficient of thermal expansion, the glass transition temperature, and the breaking elongation in the condition (i) to the condition (iv) are the same as the preferred aspects and the measuring methods for the Young's modulus, the coefficient of thermal expansion, the glass transition temperature, and the breaking elongation in the condition (i) to condition (iv) in the above-described resin composition according to the embodiment of the present invention.

In addition, it is preferable that the cured substance according to the embodiment of the present invention satisfies all of the following condition (v) to condition (viii).

Condition (v): The Young's modulus of the cured substance is 4.5 GPa or more.

Condition (vi): The coefficient of thermal expansion of the cured substance in a temperature range of 25°C to 125°C is less than 40 ppm/°C.

Condition (vii): The glass transition temperature of the cured substance is 260°C or higher.

Condition (viii): The breaking elongation of the cured substance is 50% or more.

Hereinafter, the cured substance according to the first aspect of the present invention and the cured substance according to the second aspect of the present invention will be also simply described collectively as "the cured substance according to the present invention" or "the cured substance".

### <Characteristics of cured substance of resin composition>

The imidization reaction rate of the cured substance of the resin composition according to the embodiment of the present invention is preferably 70% or more, more preferably 80% or more, and still more preferably 90% or more. In a case of being 70% or more, a cured substance having excellent mechanical characteristics may be obtained.

### <Preparation of resin composition>

The resin composition according to the embodiment of the present invention can be prepared by mixing the above-described components. The mixing method is not particularly limited, and mixing can be carried out by methods publicly known in the related art.

Examples of the mixing method include mixing with a stirring blade, mixing with a ball mill, and mixing by rotating a tank.

The temperature during the mixing is preferably 10°C to 30°C, and more preferably 15°C to 25°C.

It is preferable to carry out filtration using a filter for the intended purpose of removing foreign substances such as dust and fine particles in the resin composition according to the embodiment of the present invention. The filter pore diameter is, for example, preferably 5 µm or less, more preferably 1 µm or less, still more preferably 0.5 µm or less, and even still more preferably 0.1 µm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore diameters or different materials may be used in combination. Examples of the connection aspect include an aspect in which an HDPE filter having a pore diameter of 1 µm is connected in series as the first stage and an HDPE filter having a pore diameter of 0.2 µm is connected in series as the second stage. In addition, various materials may be filtered a plurality of times. In a case of being filtered a plurality of times, circulation filtration may be used. In addition, filtration may be carried out under pressure. In a case of carrying out pressurization to carry out filtration, the pressure for pressurization is, for example, preferably 0.01 MPa or more and 1.0 MPa or less, more preferably 0.03 MPa or more and 0.9 MPa or less, still more preferably 0.05 MPa or more and 0.7 MPa or less, and even still more preferably 0.05 MPa or more and 0.5 MPa or less.

In addition to filtration using a filter, impurity removal treatment using an adsorbing material may be carried out. The filtration using a filter and the impurity removal treatment using an adsorbing material may be combined. As the adsorbing material, a publicly known adsorbing material can be used. Examples thereof include an inorganic adsorbing material such as silica gel and zeolite and an organic adsorbing material such as activated carbon.

After filtration using a filter, a step of placing a bottle filled with the resin composition under reduced pressure to carry out degassing may be provided.

### (Manufacturing method for cured substance)

The manufacturing method for a cured substance according to the embodiment of the present invention preferably includes a film forming step of applying a resin composition onto a base material to form a film.

The manufacturing method for a cured substance more preferably includes the above-described film forming step, an exposure step of selectively exposing the film formed by the film forming step, and a development step of developing the film exposed by the exposure step with a developer to form a pattern.

It is particularly preferable that the manufacturing method for a cured substance includes the film forming step, the exposure step, the development step, and at least one of a heating step of heating a pattern obtained by the development step or a post-development exposure step of exposing the pattern obtained by the development step.

In addition, it is also preferable that the manufacturing method for a cured substance includes the above-described film forming step and a step of heating the film.

Hereinafter, details of each step will be described.

### <Film forming step>

The resin composition according to the embodiment of the present invention can be applied onto a base material, thereby being used in a film forming step of forming a film.

The manufacturing method for a cured substance according to the embodiment of the present invention preferably includes a film forming step of applying a resin composition onto a base material to form a film.

### [Base material]

The kind of the base material can be appropriately determined depending on the use application and is not particularly limited. Examples of the base material include a base material for semiconductor production, such as silicon, silicon nitride, polysilicon, silicon oxide, or amorphous silicon, quartz, glass, an optical film, a ceramic material, a vapor-deposited film, a magnetic film, a reflective film, a metal base material (for example, it may be any one of a base material formed from a metal or a base material having a metal layer formed by plating, vapor deposition, or the like) such as Ni, Cu, Cr, or Fe, paper, spin-on-glass (SOG), a thin film transistor (TFT) array base material, a mold base material, and an electrode plate of a plasma display panel (PDP). In particular, the base material is preferably a base material for semiconductor production, and more preferably a silicon base material, a Cu base material, or a mold base material.

A layer such as an intimate attachment layer made of hexamethyl disilazane (HMDS) or the like, or an oxide layer may be provided on the surface of these base materials.

The shape of the base material is not particularly limited, and it may be a circular shape or may be a rectangular shape.

In a case where the base material has a circular shape, the size of the base material is, for example, preferably a diameter of 100 to 450 mm and more preferably 200 to 450 mm. In a case of a rectangular shape, the length of the short side is, for example, preferably 100 to 1,000 mm and more preferably 200 to 700 mm.

As the base material, for example, a base material having a plate shape and preferably a base material (a substrate) having a panel shape are used.

In a case where the resin composition is applied to form a film on a surface of a resin layer (for example, a layer consisting of a cured substance) or on a surface of a metal layer, the resin layer or the metal layer serves as the base material.

The means for applying the resin composition onto a base material is preferably coating.

Specific examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of the uniformity of the film thickness, a spin coating method, a slit coating method, a spray coating method, or an ink jet method is more preferable, and from the viewpoint of the uniformity of the film thickness and the viewpoint of productivity, a spin coating method or a slit coating method is more preferable. A film having a desired thickness can be obtained by adjusting the concentration of solid contents of the resin composition and application conditions according to the means to be applied. In addition, the coating method can be appropriately selected depending on the shape of the base material. In a case where a circular base material such as a wafer is used, a spin coating method, a spray coating method, an ink jet method, or the like is preferable, and in a case where a rectangular base material is used, a slit coating method, a spray coating method, an inkjet method, or the like is preferable. For example, the spin coating method can be applied at a rotation speed of 500 to 3,500 rpm for about 10 seconds to 3 minutes.

In addition, it is also possible to apply a method of transferring a coating film formed in advance on a temporary support by the above-described coating method, onto a base material.

Regarding the transfer method, the production methods described in paragraphs 0023 and 0036 to 0051 of JP2006-023696A and paragraphs 0096 to 0108 of JP2006-047592A can also be suitably used.

In addition, a step of removing an unnecessary film at the end part of the base material may be carried out. Examples of such a step include edge bead rinsing (EBR) and back rinsing.

A pre-wetting step of applying various solvents onto the base material before applying the resin composition onto the base material to improve the wettability of the base material and then applying the resin composition may be adopted.

### <Drying Step>

The above film may be subjected to a step (a drying step) of drying the film (or the layer) formed for removing the solvent, after the film forming step (the layer forming step).

That is, the manufacturing method for a cured substance according to the embodiment of the present invention may include a drying step of drying the film formed by the film forming step.

It is preferable that the drying step is carried out after the film forming step and before the exposure step.

The drying temperature of the film in the drying step is preferably 50°C to 150°C, more preferably 70°C to 130°C, and still more preferably 90°C to 110°C. In addition, the drying may be carried out by reducing the pressure. Examples of the drying time include 30 seconds to 20 minutes, and the drying time is preferably 1 minute to 10 minutes and more preferably 2 minutes to 7 minutes.

### <Exposure step>

The film may be subjected to an exposure step of selectively exposing the film.

The manufacturing method for a cured substance may include an exposure step of selectively exposing the film formed by the film forming step.

The selective exposure means that a part of the film is exposed. In addition, by selectively exposing the film, an exposed region (an exposed portion) and an unexposed region (a non-exposed portion) are formed in the film.

The exposure amount is not particularly limited as long as the resin composition according to the embodiment of the present invention can be cured; however, it is, for example, preferably 50 to 10,000 mJ/cm² and more preferably 200 to 8,000 mJ/cm² in terms of conversion of exposure energy at a wavelength of 365 nm.

The exposure wavelength can be appropriately determined in a range of 190 to 1,000 nm and preferably in a range of 240 to 550 nm.

Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an F₂ excimer laser (wavelength: 157 nm); (5) an extreme ultraviolet ray: EUV (wavelength: 13.6 nm); (6) an electron beam; and (7) a second harmonic wave of 532 nm and a third harmonic wave of 355 nm of a YAG laser. Regarding the resin composition according to the embodiment of the present invention, exposure with a high pressure mercury lamp is particularly preferable, and from the viewpoint of exposure sensitivity, exposure with an i-line is more preferable.

The exposure method is not particularly limited as long as at least a part of the film consisting of the resin composition according to the embodiment of the present invention is exposed; however, examples thereof include exposure using a photo mask and exposure by a laser direct imaging method.

### <Post-exposure heating step>

The film may be subjected to a step of carrying out heating after the exposure (a post-exposure heating step).

That is, the manufacturing method for a cured substance according to the embodiment of the present invention may include a post-exposure heating step of heating the film exposed in the exposure step.

The post-exposure heating step can be carried out after the exposure step and before the development step.

The heating temperature in the heating step after the exposure is preferably 50°C to 140°C and more preferably 60°C to 120°C.

The heating time in the post-exposure heating step is preferably 30 seconds to 300 minutes and more preferably 1 minute to 10 minutes.

In the post-exposure heating step, the temperature rising rate from the temperature at the start of heating to the maximum heating temperature is preferably 1 to 12 °C/min, more preferably 2 to 10 °C/min, and still more preferably 3 to 10 °C/min.

In addition, the temperature rising rate may be appropriately changed during heating.

The heating means in the post-exposure heating step is not particularly limited, and a publicly known hot plate, oven, infrared heater, or the like can be used.

In addition, it is also preferable to carry out the heating in an atmosphere having a low oxygen concentration by allowing an inert gas such as nitrogen, helium, argon, or the like to flow.

### <Development Step>

The exposed film may be subjected to a development step of carrying out development using a developer to form a pattern.

That is, the manufacturing method for a cured substance according to the embodiment of the present invention may include a development step of developing the film exposed in the exposure step using a developer to form a pattern.

By carrying out the development, one of the exposed portion and the non-exposed portion of the film is removed, and a pattern is formed.

Here, the development in which the non-exposed portion of the film is removed by the development step is referred to as negative-tone development, and the development in which the exposed portion of the film is removed by the development step is referred to as positive-tone development.

### [Developer]

Examples of the developer that is used in the development step include a developer containing an alkaline aqueous solution or an organic solvent.

In a case where the developer is an alkaline aqueous solution, examples of the basic compound that can be contained in the alkaline aqueous solution include inorganic alkalis, primary amines, secondary amines, tertiary amines, and a quaternary ammonium salt. The basic compound is preferably tetramethylammonium hydroxide (TMAH), potassium hydroxide, sodium carbonate, sodium hydroxide, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and it is more preferably TMAH. The content of the basic compound in the developer is preferably 0.01% to 10% by mass, more preferably 0.1% to 5% by mass, and still more preferably 0.3% to 3% by mass in the total mass of the developer.

In a case where the developer contains an organic solvent, the compounds described in paragraph 0387 of WO2021/112189A can be used as the organic solvent. The content thereof is incorporated in the present specification. In addition, suitable examples of the alcohols include methanol, ethanol, propanol, isopropanol, butanol, pentanol, octanol, diethylene glycol, propylene glycol, methyl isobutyl carbinol, and triethylene glycol, and suitable examples of the amides include N-methylpyrrolidone, N-ethylpyrrolidone, and dimethylformamide.

In a case where the developer contains an organic solvent, one kind of organic solvent can be used, or two or more kinds thereof can be mixedly used. In the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is particularly preferable.

In a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. In addition, the above content may be 100% by mass.

In a case where the developer contains an organic solvent, the developer may further contain at least one of a basic compound or a base generator. In a case where at least one of the basic compound or the base generator in the developer permeates into the pattern, the performance such as the breaking elongation of the pattern may be improved.

The basic compound is preferably an organic base from the viewpoint of the reliability in a case of being remained in the cured film (the adhesiveness to the base material in a case where the cured substance is further heated).

The basic compound is preferably a basic compound having an amino group and preferably a primary amine, a secondary amine, a tertiary amine, an ammonium salt, a tertiary amide, or the like. However, in order to accelerate the imidization reaction, it is preferably a primary amine, a secondary amine, a tertiary amine, or an ammonium salt, more preferably a secondary amine, a tertiary amine, or an ammonium salt, still more preferably a secondary amine or a tertiary amine, and particularly preferably a tertiary amine.

From the viewpoint of mechanical characteristics (the breaking elongation) of the cured substance, it is preferable that the basic compound hardly remains in the cured film (the obtained cured substance), and from the viewpoint of accelerating cyclization, it is preferable that the residual amount of the basic compound hardly decreases due to vaporization or the like before heating.

Therefore, the boiling point of the basic compound is preferably 30°C to 350°C, more preferably 80°C to 270°C, and still more preferably 100°C to 230°C at normal pressure (101,325 Pa).

The boiling point of the basic compound is preferably higher than the temperature obtained by subtracting 20°C from the boiling point of the organic solvent contained in the developer, and it is more preferably higher than the boiling point of the organic solvent contained in the developer.

For example, in a case where the boiling point of the organic solvent is 100°C, the basic compound to be used preferably has a boiling point of 80°C or higher and more preferably a boiling point of 100°C or higher.

The developer may contain only one kind of basic compound having an amide group or may contain two or more kinds thereof.

Specific examples of the basic compound include ethanolamine, diethanolamine, triethanolamine, ethylamine, diethylamine, triethylamine, hexylamine, dodecylamine, cyclohexylamine, cyclohexylmethylamine, cyclohexyldimethylamine, aniline, N-methylaniline, N,N-dimethylaniline, diphenylamine, pyridine, butylamine, isobutylamine, dibutylamine, tributylamine, dicyclohexylamine, diazabicycloundecene (DBU), 1,4-diazabicyclo[2.2.2]octane (DABCO), N,N-diisopropylethylamine, tetramethylammonium hydroxide, tetrabutylammonium hydroxide, ethylenediamine, butanediamine, 1,5-diaminopentane, N-methylhexylamine, N-methyldicyclohexylamine, trioctylamine, N-ethylethylenediamine, N,N-diethylethylenediamine, N,N,N',N'-tetrabutyl-1,6-hexanediamine, spermidine, diaminocyclohexane, bis(2-methoxyethyl)amine, piperidine, methylpiperidine, dimethylpiperidine, piperazine, tropane, N-phenylbenzylamine, 1,2-dianilinoethane, 2-aminoethanol, toluidine, aminophenol, hexylaniline, phenylene diamine, phenylethylamine, dibenzylamine, pyrrole, N-methylpyrrole, N,N,N,N-tetramethylethylenediamine, and N,N,N,N-tetramethyl-1,3-propanediamine.

A preferred aspect of the base generator is the same as the preferred aspect of the base generator contained in the above-described composition. In particular, the base generator is preferably a thermal-base generator.

In a case where the developer contains at least one of a basic compound or a base generator, the content of the basic compound or the base generator is preferably 10% by mass or less, and more preferably 5% by mass or less with respect to the total mass of the developer. The lower limit of the content is not particularly limited; however, it is, for example, preferably 0.1% by mass or more.

In a case where the basic compound or the base generator is a solid in an environment where the developer is used, the content of the basic compound or the base generator is also preferably 70% to 100% by mass with respect to the total solid content of the developer.

The developer may contain only one kind of the basic compound or base generator or may contain two or more kinds thereof. In a case where at least one of the basic compound or the base generator is two or more kinds, the total thereof is preferably within the above-described range.

The developer may further contain another component.

Examples of the other component include a publicly known surfactant and a publicly known anti-foaming agent.

### [Method of supplying developer]

The method of supplying a developer is not particularly limited as long as a desired pattern can be formed, and it includes a method of immersing a base material on which a film has been formed in a developer, puddle development of supplying a developer to a film formed on a base material using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the non-image area, and the manufacturing efficiency, a method of supplying a developer with a straight nozzle or a method of continuously supplying a developer with a spray nozzle is preferable, and from the viewpoint of the permeability of the developer into the image area, a method of supplying a developer with a spray nozzle is more preferable.

In addition, after the continuous supply by a straight nozzle, the base material is spun to remove the developer from the base material, and then the developer is continuously supplied by the straight nozzle again after the spin drying, a step of spinning the base material to remove the developer from the base material may be adopted, and this step may be repeated a plurality of times.

Examples of the method of supplying a developer in the development step include a step of continuously supplying a developer to a base material, a step of keeping a developer in a substantially stationary state on a base material, a step of vibrating a developer on a base material by ultrasonic waves or the like, and a step obtained by combining these steps.

The development time is preferably 10 seconds to 10 minutes and more preferably 20 seconds to 5 minutes. The temperature of the developer during development is not particularly determined; however, it is preferably 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

### [Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.

Examples of the organic solvent in a case where the rinsing liquid contains an organic solvent include the same organic solvents as the organic solvents exemplified in the above-described case where the developer contains an organic solvent.

The organic solvent contained in the rinsing liquid is preferably an organic solvent different from the organic solvent contained in the developer, and it is more preferably an organic solvent having a solubility of the pattern, which is lower than that of the organic solvent contained in the developer.

In a case where the rinsing liquid contains an organic solvent, one kind of organic solvent can be used, or two or more kinds thereof can be mixedly used. The organic solvent is preferably cyclopentanone, γ-butyrolactone, dimethyl sulfoxide, N-methylpyrrolidone, cyclohexanone, PGMEA, or PGME, more preferably cyclopentanone, γ-butyrolactone, dimethyl sulfoxide, PGMEA, or PGME, and still more preferably cyclohexanone or PGMEA.

In a case where the rinsing liquid contains an organic solvent, the organic solvent is preferably 50% by mass or more, more preferably 70% by mass or more, and still more preferably 90% by mass or more with respect to the total mass of the rinsing liquid. In addition, the organic solvent may be 100% by mass with respect to the total mass of the rinsing liquid.

The rinsing liquid may contain at least one of a basic compound or a base generator.

Although not particularly limited, in a case where the developer contains an organic solvent, an aspect in which the rinsing liquid contains at least one of an organic solvent, a basic compound, or a base generator is also one of the preferred aspects of the present invention.

Examples of the basic compound and the base generator which are contained in the rinsing liquid include the compounds exemplified as the basic compound and the base generator which may be contained in a case where the developer contains an organic solvent, and the same applies to the preferred aspects thereof.

The basic compound and the base generator, which are contained in the rinsing liquid, may be selected in consideration of the solubility in the solvent in the rinsing liquid.

In a case where the rinsing liquid contains at least one of a basic compound or a base generator, the content of the basic compound or the base generator is preferably 10% by mass or less, and more preferably 5% by mass or less with respect to the total mass of the rinsing liquid. The lower limit of the content is not particularly limited; however, it is, for example, preferably 0.1% by mass or more.

In a case where the basic compound or the base generator is a solid in an environment where the rinsing liquid is used, the content of the basic compound or the base generator is also preferably 70% to 100% by mass with respect to the total solid content of the rinsing liquid.

In a case where the rinsing liquid contains at least one of a basic compound or a base generator, the rinsing liquid may contain only one kind of the basic compound or base generator or may contain two or more kinds thereof. In a case where at least one of the basic compound or the base generator is two or more kinds, the total thereof is preferably within the above-described range.

The rinsing liquid may further contain another component.

Examples of the other component include a publicly known surfactant and a publicly known anti-foaming agent.

### [Method of supplying rinsing liquid]

The method of supplying a rinsing liquid is not particularly limited as long as a desired pattern can be formed and includes a method of immersing a base material in a rinsing liquid, a method of supplying a rinsing liquid to a base material by liquid filling, a method of supplying a rinsing liquid to a base material with a shower, and a method of continuously supplying a rinsing liquid to a base material by means such as a straight nozzle.

From the viewpoint of the permeability of the rinsing liquid, the removability of non-image area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.

That is, the rinsing step is preferably a step of supplying, with a straight nozzle, or continuously supplying a rinsing liquid to the exposed film, and it is more preferably a step of supplying a rinsing liquid with a spray nozzle.

In the method of supplying a rinsing liquid in the rinsing step, a step of continuously supplying a rinsing liquid to a base material, a step of keeping a rinsing liquid in a substantially stationary state on a base material, a step of vibrating a rinsing liquid on the base material by ultrasonic waves or the like, and a step obtained by combining these steps can be adopted.

The rinsing time is preferably 10 seconds to 10 minutes and more preferably 20 seconds to 5 minutes. The temperature of the rinsing liquid during rinsing is not particularly determined; however, it is preferably 10°C to 45°C and more preferably 18°C to 30°C.

The development step may include a step of bringing the treatment liquid into contact with the pattern after the treatment using the developer or after the pattern is washed with the rinsing liquid. In addition, such a method of supplying a treatment liquid before the developer or rinsing liquid which is in contact with the pattern is completely dried may be adopted.

Examples of the treatment liquid include a treatment liquid containing at least one of water or an organic solvent and at least one of a basic compound or a base generator.

Preferred aspects of the organic solvent and at least one of the basic compound or the base generator are the same as the preferred aspects of the organic solvent and at least one of the basic compound or the base generator, which are used in the above-described rinsing liquid.

As a method of supplying the treatment liquid to the pattern, the same method as the above-described method of supplying the rinsing liquid can be used, and the same applies to the preferred aspect thereof.

The content of the basic compound or the base generator in the treatment liquid is preferably 10% by mass or less and more preferably 5% by mass or less with respect to the total mass of the treatment liquid. The lower limit of the content is not particularly limited; however, it is, for example, preferably 0.1% by mass or more.

In addition, In a case where the basic compound or the base generator is a solid in an environment where the treatment liquid is used, the content of the basic compound or the base generator is also preferably 70% to 100% by mass with respect to the total solid content of the treatment liquid.

In a case where the treatment liquid contains at least one of a basic compound or a base generator, the treatment liquid may contain only one kind of the basic compound or the base generator, or may contain two or more kinds thereof. In a case where at least one of the basic compound or the base generator is two or more kinds, the total thereof is preferably within the above-described range.

### <Heating step>

The pattern obtained by the development step (a pattern after the rinsing in a case where the rinsing step is carried out) may be subjected to a heating step of heating the pattern obtained by the development.

That is, the manufacturing method for a cured substance according to the embodiment of the present invention may include a heating step of heating the pattern obtained by the development step.

In addition, the manufacturing method for a cured substance according to the embodiment of the present invention may include a pattern obtained by another method without carrying out the development step, or a heating step of heating a film obtained by the film forming step.

In the heating step, the resin such as the polyimide precursor is cyclized to become a resin such as polyimide.

In addition, the crosslinking of unreacted crosslinkable groups in the specific resin or a crosslinking agent other than the specific resin also proceeds.

The heating temperature (the maximum heating temperature) in the heating step is preferably 50°C to 450°C, more preferably 150°C to 350°C, still more preferably 150°C to 250°C, even still more preferably 160°C to 250°C, and particularly preferably 160°C to 230°C.

The heating step is preferably a step of accelerating the cyclization reaction of the polyimide precursor in the pattern under the action of the base or the like generated from the base generator by heating.

The heating in the heating step is preferably carried out at a temperature rising rate of 1 to 12°C/min from the temperature at the start of heating to the maximum heating temperature. The temperature rising rate is more preferably 2 to 10 °C/min and still more preferably 3 to 10 °C/min. In a case where the above temperature rising rate is set to 1 °C/min or higher, the excessive volatilization of the acid or solvent can be prevented while securing productivity, and in a case where the above temperature rising rate is to 12 °C/min or lower, the residual stress of the cured substance can be relaxed.

In addition, in a case of an oven that enables rapid heating, the heating is preferably carried out at a temperature rising rate of 1 to 8°C/sec from the temperature at the start of heating to the maximum heating temperature, more preferably 2 to 7 °C/sec, and still more preferably 3 to 6 °C/sec.

The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a base material and then dried, the temperature at the start of heating is the temperature of the film (the layer) after drying, and for example, it is preferable to raise the temperature from a temperature lower by 30°C to 200°C than the boiling point of the solvent contained in the resin composition.

The heating time (the heating time at the maximum heating temperature) is preferably 5 to 360 minutes, more preferably 10 to 300 minutes, and still more preferably 15 to 240 minutes.

In particular, in a case of forming a multilayered laminate, the heating temperature is preferably 30°C or higher, more preferably 80°C or higher, still more preferably 100°C or higher, and particularly preferably 120°C or higher, from the viewpoint of adhesiveness between layers.

The upper limit of the heating temperature is preferably 350°C or lower, more preferably 250°C or lower, and still more preferably 240°C or lower.

The heating may be carried out stepwise. For example, a step in which the temperature is raised from 25°C to 120°C at 3 °C/min, held at 120°C for 60 minutes, raised from 120°C to 180°C at 2 °C/min, and held at 180°C for 120 minutes, may be carried out. In addition, it is also preferable to carry out the treatment while carrying out irradiation with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment step may be carried out as a step of two or more stages, for example, a first stage pretreatment step may be carried out in a range of 100°C to 150°C, and then a second stage pretreatment step may be carried out in a range of 150°C to 200°C.

Further, cooling may be carried out after heating, and the cooling rate, in this case, is preferably 1 to 5 °C/min.

From the viewpoint of preventing the decomposition of the specific resin, it is preferable that the heating step is carried out in an atmosphere of a low oxygen concentration, for example, by allowing an inert gas such as nitrogen, helium, argon, or the like to flow, or carrying out heating under reduced pressure. The oxygen concentration is preferably 50 ppm (volume ratio) or lower, and more preferably 20 ppm (volume ratio) or lower.

The heating means in the heating step is not particularly limited; however, examples thereof include a hot plate, an infrared furnace, an electric heating oven, a hot air oven, and an infrared oven.

### <Post-development exposure step>

The pattern obtained by the development step (a pattern after the rinsing in a case where the rinsing step is carried out) may be subjected to a post-development exposure step of exposing the pattern after the development step, instead of the heating step or in addition to the heating step.

That is, the manufacturing method for a cured substance according to the embodiment of the present invention may include a post-development exposure step of exposing the pattern obtained by the development step. The manufacturing method for a cured substance according to the embodiment of the present invention may include the heating step and the post-development exposure step or may include only one of the heating step and the post-development exposure step.

In the post-development exposure step, it is possible to accelerate, for example, a reaction in which the cyclization of a polyimide precursor or the like proceeds by photosensitization of a photobase generator, a reaction in which the elimination of an acid-decomposable group proceeds by photosensitization of a photoacid generator.

In the post-development exposure step, it is sufficient that at least a part of the pattern obtained in the development step is exposed; however, it is preferable that the whole of the above pattern is exposed.

The exposure amount in the post-development exposure step is preferably 50 to 20,000 mJ/cm² and more preferably 100 to 15,000 mJ/cm² in terms of conversion of exposure energy at the wavelength at which the photosensitive compound has a sensitivity.

The post-development exposure step can be carried out using, for example, the light source in the above-described exposure step, and it is preferable to use broadband light.

### <Metal layer forming step>

The pattern (preferably a pattern that has been subjected to at least one of the heating step or the post-development exposure step) obtained by the development step may be subjected to a metal layer forming step of forming a metal layer on the pattern.

That is, it is preferable that the manufacturing method for a cured substance according to the embodiment of the present invention includes a metal layer forming step of forming a metal layer on the pattern (preferably a pattern that has been subjected to at least one of the heating step or the post-development exposure step) obtained by the development step.

For the metal layer, existing metal kinds can be used without particular limitations. Examples thereof include copper, aluminum, nickel, vanadium, titanium, chromium, cobalt, gold, tungsten, tin, silver, and an alloy including these metals, where copper or aluminum is more preferable, and copper is still more preferable.

The forming method for the metal layer is not particularly limited, and the existing method can be applied. For example, the methods described in JP2007-157879A, JP2001-521288A, JP2004-214501A, JP2004-101850A, US7888181B2, and US9177926B2 can be used. For example, photolithography, physical vapor deposition method (PVD), chemical vapor phase growth method (CVD), lift-off, electrolytic plating, electroless plating, etching, printing, and a method obtained by combining these may be conceivable. More specific examples of the forming method for the metal layer include a patterning method obtained by combining sputtering, photolithography, and etching, and a patterning method combining photolithography and electrolytic plating. Examples of the preferred aspect of the plating include electrolytic plating using a copper sulfate plating liquid or a copper cyanide plating liquid.

The thickness of the metal layer at the thickest portion is preferably 0.01 to 50 µm and more preferably 1 to 10 µm.

### <Use application>

Examples of the field to which the manufacturing method for a cured substance according to the embodiment of the present invention or the cured substance according to the embodiment of the present invention can be applied include an insulating film of an electronic device, an interlayer insulating film for a re-distribution layer, and a stress buffer film. In addition, a sealing film, a substrate material (a base film or cover lay of a flexible print substrate, an interlayer insulating film), or such an insulating film in a use application for mounting as described above, which is patterned by etching, is mentioned. For these use applications, for example, Science & Technology Co., Ltd., "High functionality and applied technology of polyimide" April 2008, Technical library CMC TL "Basics and development of polyimide materials" supervised by Masaaki Kakimoto, published in November 2011, "Latest Polyimide Basics and Applications" edited by Japan Polyimide & Aromatic Polymers Study Group, NTS Inc., August 2010, or the like can be referred to.

The manufacturing method for a cured substance according to the embodiment of the present invention and the cured substance according to the embodiment of the present invention can also be used for the production of board surfaces such as an offset board surface or a screen board surface, for etching of molded parts, for the production of protective lacquers and dielectric layers in electronics, in particular, microelectronics.

### (Laminate and manufacturing method for laminate)

A laminate according to the embodiment of the present invention refers to a structure body having a plurality of layers consisting of the cured substance according to the embodiment of the present invention.

The laminate is a laminate including two or more layers consisting of a cured substance, and it may be a laminate in which three or more layers are laminated.

At least one of the two or more layers consisting of a cured substance, which are included in the laminate, is a layer consisting of the cured substance according to the embodiment of the present invention, and from the viewpoint of suppressing the shrinkage of the cured substance or the deformation of the cured substance due to the shrinkage, it is also preferable that all the layers consisting of a cured substance which are included in the laminate are layers consisting of the cured substance according to the embodiment of the present invention.

That is, it is preferable that the manufacturing method for a laminate according to the embodiment of the present invention includes the manufacturing method for a cured substance according to the embodiment of the present invention, and it is more preferable to include repeating, a plurality of times, the manufacturing method for a cured substance according to the embodiment of the present invention.

In the laminate according to the aspect of the present invention, an aspect in which two or more layers of layers consisting of a cured substance are included and a metal layer is provided between any of the layers consisting of the cured substance is preferable. The metal layer is preferably formed in the metal layer forming step.

That is, it is preferable that the manufacturing method for a laminate according to the embodiment of the present invention further includes a metal layer forming step of forming a metal layer on a layer consisting of the cured substance, between the manufacturing methods for a cured substance which are carried out a plurality of times. The preferred aspect of the metal layer forming step is as described above.

Examples of the preferred laminate include a laminate including at least a layer structure in which three layers of a layer consisting of a first cured substance, a metal layer, and a layer consisting of a second cured substance are laminated in order.

It is preferable that both the layer consisting of the first cured substance and the layer consisting of the second cured substance are layers consisting of the cured substance according to the embodiment of the present invention. The resin composition according to the embodiment of the present invention which is used for forming a layer consisting of the first cured substance and the resin composition according to the embodiment of the present invention which is used for forming a layer consisting of the second cured substance may have the same composition or may have compositions different from each other. The metal layer in the laminate according to the embodiment of the present invention is preferably used as the metal wiring line of the re-distribution layer or the like.

### <Laminating step>

The manufacturing method for a laminate according to the embodiment of the present invention preferably further includes a laminating step.

The laminating step is a series of steps including carrying out again, in the following order on the surface of the pattern (the resin layer) or the metal layer, at least one of (a) the film forming step (the layer forming step), (b) the exposure step, (c) the development step, or (d) the heating step and the post-development exposure step. However, the aspect thereof may be such that at least one of (a) the film forming step or (d) the heating step and the post-development exposure step is repeated. In addition, (e) the metal layer forming step may be included after at least one of the heating step or the post-development exposure step of (d). It is needless to say that the laminating step may further include appropriately the above-described drying step.

In a case where another laminating step is further carried out after the laminating step, a surface activation treatment step may be further carried out after the exposure step, the heating step, or the metal layer forming step. Examples of the surface activation treatment include plasma treatment. Details of the surface activation treatment will be described later.

The laminating step is preferably carried out 2 to 20 times and more preferably 2 to 9 times.

For example, a configuration having resin layers of 2 or more layers and 20 or less layers, such as a resin layer/a metal layer/a resin layer/a metal layer/a resin layer/a metal layer, is preferable, and a configuration having resin layers of 2 or more layers and 9 or less layers is still more preferable.

In the above layers, the compositions, shapes, film thicknesses, and the like may be the same or may be different from each other.

In the present invention, an aspect in which a metal layer is provided, and then furthermore, a cured substance (a resin layer) of the resin composition according to the aspect of the present invention is formed to cover the metal layer is particularly preferable. Specific examples thereof include an aspect in which (a) the film forming step, (b) the exposure step, (c) the development step, (d) at least one of the heating step or the post-development exposure step, (e) the metal layer forming step are repeated in this order, and an aspect in which (a) the film forming step, (d) at least one of the heating step or the post-development exposure step, and (e) the metal layer forming step are repeated in order. By alternately carrying out the laminating step of laminating the resin composition layer (the resin layer) of the present invention and the metal layer forming step, the resin composition layer (the resin layer) according to the embodiment of the present invention and the metal layer can be alternately laminated.

### (Surface activation treatment step)

The manufacturing method for a laminate according to the embodiment of the present invention preferably includes a surface activation treatment step of subjecting at least a part of the metal layer or a part of the resin composition layer to a surface activation treatment.

The surface activation treatment step is usually carried out after the metal layer forming step (preferably, after at least one of the heating step or the post-development exposure step). However, after the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is preferable to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

It is preferable that the surface activation treatment is carried out on a part or whole of the resin composition layer (the resin layer) after the exposure. In a case where a surface of the resin composition layer is subjected to the surface activation treatment in this manner, it is possible to improve the adhesiveness to a metal layer or a resin layer to be provided on the surface that has been subjected to the surface activation treatment. In particular, in a case where the resin composition layer is cured, such as in a case where negative-tone development is carried out, it is less likely to be damaged by the surface treatment, and thus the adhesiveness is likely to be improved.

The surface activation treatment can be carried out, for example, according to the method described in paragraph 0415 of WO2021/112189A. The content thereof is incorporated in the present specification.

### (Semiconductor device and manufacturing method therefor)

A semiconductor device according to the first aspect of the present invention is a semiconductor device including the cured substance according to the embodiment of the present invention or the laminate according to the embodiment of the present invention.

In addition, the present invention also discloses a manufacturing method for a semiconductor device, which includes the manufacturing method for a cured substance according to the embodiment of the present invention or the manufacturing method for a laminate according to the embodiment of the present invention.

As the specific examples of the semiconductor device using the resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

A semiconductor device according to the second aspect of the present invention is a semiconductor device including a semiconductor chip, a re-distribution layer, and an interlayer insulating film for a re-distribution layer, where the interlayer insulating film for a re-distribution layer satisfies all of the following condition (i) to condition (iv).

The semiconductor device including an interlayer insulating film for a re-distribution layer, where the interlayer insulating film for a re-distribution layer satisfies all of the following condition (i) to condition (iv).

Condition (i): A Young's modulus of the interlayer insulating film for a re-distribution layer is 3.5 GPa or more.

Condition (ii): A coefficient of thermal expansion of the interlayer insulating film for a re-distribution layer in a temperature range of 25°C to 125°C is less than 50 ppm/°C.

Condition (iii): A glass transition temperature of the interlayer insulating film for a re-distribution layer is 240°C or higher.

Condition (iv): A breaking elongation of the interlayer insulating film for a re-distribution layer is 40% or more.

Here, the preferred aspects and the measuring methods for the Young's modulus, the coefficient of thermal expansion, the glass transition temperature, and the breaking elongation in the condition (i) to the condition (iv) for the above-described interlayer insulating film for a re-distribution layer are the same as the preferred aspects and the measuring methods for the Young's modulus, the coefficient of thermal expansion, the glass transition temperature, and the breaking elongation in the condition (i) to condition (iv) in the above-described resin composition according to the embodiment of the present invention.

In addition, it is preferable that the interlayer insulating film for a re-distribution layer satisfies all of the following condition (v) to condition (viii).

Condition (v): A Young's modulus of the interlayer insulating film for a re-distribution layer is 4.5 GPa or more.

Condition (vi): A coefficient of thermal expansion of the interlayer insulating film for a re-distribution layer in a temperature range of 25°C to 125°C is less than 40 ppm/°C.

Condition (vii): A glass transition temperature of the interlayer insulating film for a re-distribution layer is 260°C or higher.

Condition (viii): A breaking elongation of the interlayer insulating film for a re-distribution layer is 50% or more.

The interlayer insulating film for a re-distribution layer is preferably a layer formed from the resin composition according to the embodiment of the present invention.

In addition, the interlayer insulating film for a re-distribution layer is preferably the cured substance according to the embodiment of the present invention.

The semiconductor chip in the semiconductor device according to the second aspect is not particularly limited, and a known semiconductor chip can be used. Examples thereof include a chip composed of a semiconductor such as silicon.

The re-distribution layer is a layer including a wiring line and the interlayer insulating film for a re-distribution layer. Here, the wiring line is not particularly limited, and a publicly known wiring line can be used. Examples thereof include a metal wiring line such as a copper wiring line.

The re-distribution layer may be a single layer or may be a laminate consisting of a plurality of layers. In a case of a laminate, each layer included in the laminate may have the same material or materials different from each other.

In addition, it is preferable that the above-described wiring line is electrically connected to a semiconductor chip and is in contact with an interlayer insulating film for a re-distribution layer. In addition, it is preferable that the above-described wiring line is electrically insulated by an interlayer insulating film for a re-distribution layer.

It is preferable that the semiconductor device according to the second aspect of the present invention further includes a sealing material that covers the semiconductor chip, where an area of the re-distribution layer in planar view is larger than an area of the semiconductor chip.

It is preferable that the sealing material is in direct contact with the semiconductor chip and the re-distribution layer.

The composition of the sealing material is not particularly limited: however, it is preferable to contain a resin, and from the viewpoint of heat resistance and adhesiveness, an epoxy resin or the like is preferable.

The sealing material may be a single layer or may be a laminate consisting of a plurality of layers. In a case of a laminate, each layer included in the laminate may have the same material or materials different from each other.

Fig. 1 shows an example of a semiconductor device according to a second aspect of the present invention.

Fig. 1 illustrates a semiconductor chip 2, a sealing material 3 that covers the semiconductor chip 2, and a re-distribution layer 4 that is closely attached to the semiconductor chip 2 and the sealing material 3, and it illustrates a semiconductor device 1 in which the re-distribution layer 4 includes a wiring line 5 and an interlayer insulating film 6 for a re-distribution layer.

As shown in Fig. 1, the sealing material 3 covers the surface of the semiconductor chip 2 and is formed to have an area larger than the region of the semiconductor chip 2 in planar view (indicated by an arrow A).

In the re-distribution layer 4, the space between the wiring lines 5 is filled with the interlayer insulating film 6 for a re-distribution layer.

One end the wiring line 5 is connected to a terminal 2a, and the other end thereof is connected to an external connection terminal 7. The entire surface of the wiring line 5 between the terminal 2a and the external connection terminal 7 is covered by the interlayer insulating film 6 for a re-distribution layer.

In the semiconductor device according to the second aspect of the present invention, the interlayer insulating film 6 for a re-distribution layer satisfies all of the following condition (i) to condition (iv). Therefore, it is considered that cracking is unlikely to occur between the interlayer insulating film 6 for a re-distribution layer and the wiring line 5 even after a severe TCT test.

The semiconductor device illustrated in Fig. 1 is merely an example, and thus it goes without saying that the semiconductor device according to the second aspect of the present invention is not limited thereto.

### Examples

Hereinafter, the present invention will be described in detail using examples. Materials, using amounts, proportions, treatment details, treatment content, and the like shown in the following examples can be appropriately changed without departing from the gist of the present invention. Accordingly, the scope of the present invention is not limited to the following specific examples. Unless otherwise specified, "parts" and "%" are based on mass.

### <Synthesis of polyimide precursor>

### [Synthesis Example A-1: Synthesis of polyimide precursor (A-1)]

10.4 g (47.6 millimoles) of pyromellitic acid anhydride, 10.6 g (20.4 millimoles) of 4,4'-(4,4'-isopropylidenediphenoxy)bis(phthalic acid anhydride), 17.8 g (137 millimoles) of 2-hydroxyethyl methacrylate, 0.05 g of hydroquinone, 22.8 g (289 millimoles) of pyridine, and 75 g of diglyme were mixed and stirred at a temperature of 60°C for 5 hours to produce a diester between each of pyromellitic acid anhydride and 4,4'-(4,4"-isopropylidenediphenoxy)bis(phthalic acid anhydride), and 2-hydroxyethyl methacrylate. Next, the mixture was cooled to -20°C, 17.70 g (141 millimoles) of thionyl chloride was subsequently added dropwise over 90 minutes, and stirring was carried out for 2 hours to obtain a white precipitate of pyridinium hydrochloride.

Next, a solution obtained by dissolving 21.1 g (66.0 millimoles) of 4,4'-diamino-2,2'-bis(trifluoromethyl)biphenyl in 100 mL of N-methyl-2-pyrrolidone (NMP) was added dropwise thereto over 2 hours. Next, 10.0 g (217 millimoles) of ethanol was added, and the mixture was stirred for 2 hours. The polyimide precursor was then precipitated in 4 L of water and the water-polyimide precursor mixture was stirred for 15 minutes at a speed of 500 rpm. The polyimide precursor was acquired by filtration, stirred again in 4 liters of water for 30 minutes, and filtered again. Next, the obtained polyimide precursor was dried at 45°C for 2 days under reduced pressure to obtain a polyimide precursor (A-1). The polyimide precursor (A-1) is a resin having two repeating units represented by Formula (A-1). The structure of the repeating unit was determined from a ¹H-NMR spectrum. A weight-average molecular weight (Mw) of the resin was 50,000.

In addition, the synthesis was carried out by the same method, except that in the above-described synthesis method, the amount of 4,4'-diamino-2,2'-bis(trifluoromethyl)biphenyl was changed to 19.6 g (61.2 millimoles). The Mw of the resin was 35,000. The molecular weight of the A-1 used in the resin composition described below is described in the column of "Mw" in the table.

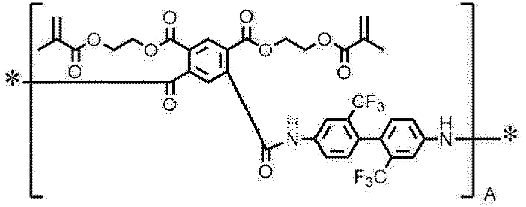

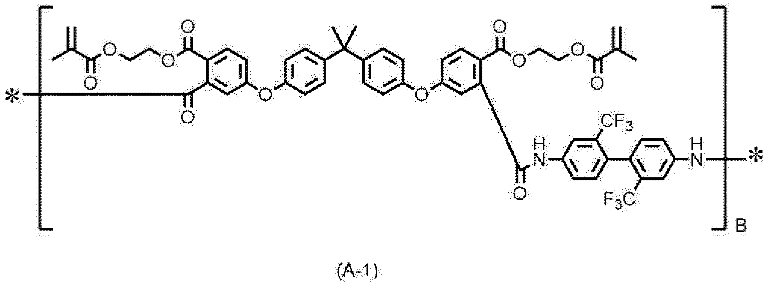

### [Synthesis Examples (A-2) to (A-6): Synthesis of polyimide precursors (A-2) to (A-6)]

Polyimide precursors (A-2) to (A-6) were synthesized by the same method as in the polyimide precursor (A-1), except that the carboxylic acid dianhydride to be used and the diamine to be used were appropriately changed. The polyimide precursors (A-2) to (A-6) are resins having repeating units represented by Formulae (A-2) to (A-6), respectively. The structure of the repeating unit was determined from a ¹H-NMR spectrum. In addition, the compositional ratio (the content molar ratio of the repeating unit) of each of the resins A-1 to A-6 is described in the table below. Here, for example, a description of "A/B = 8/2" regarding the compositional ratio (in terms of molar ratio), means that a repeating unit described as "A" and a repeating unit described as "B" are contained at a molar ratio of 8:2.

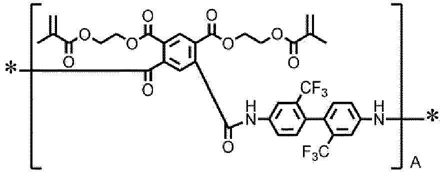

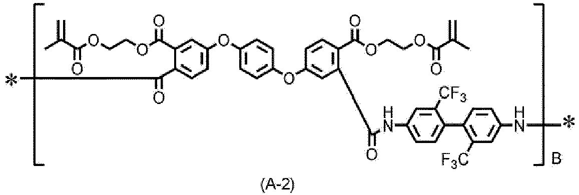

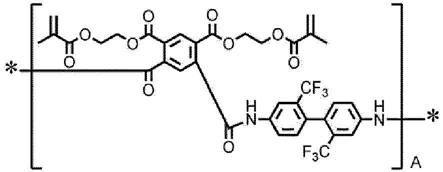

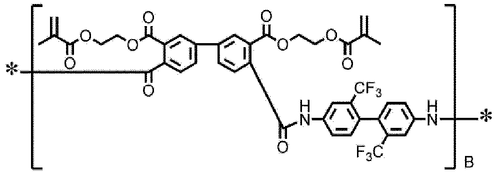

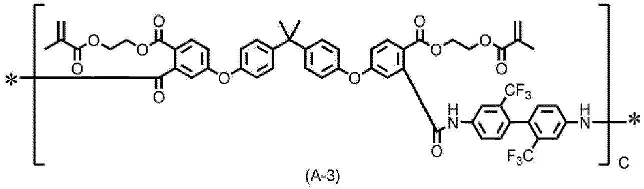

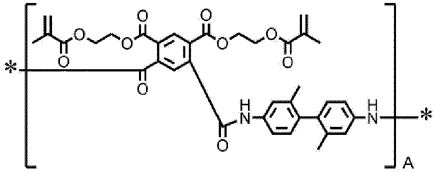

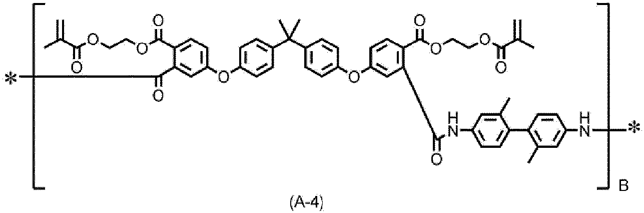

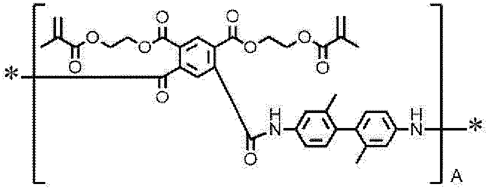

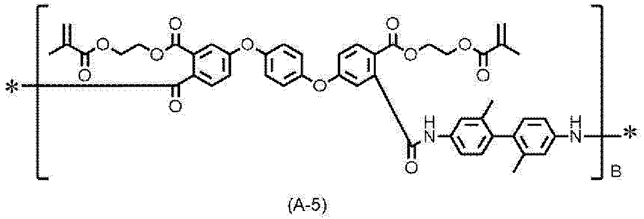

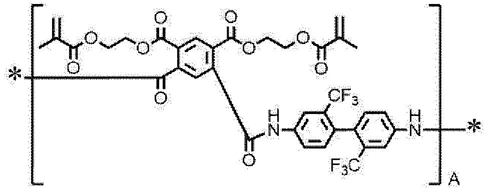

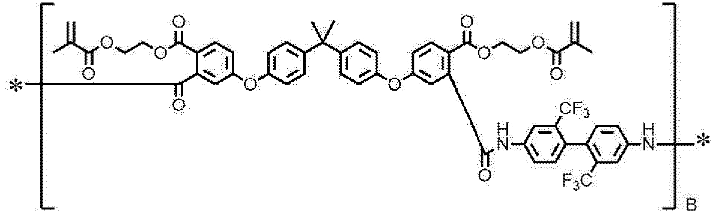

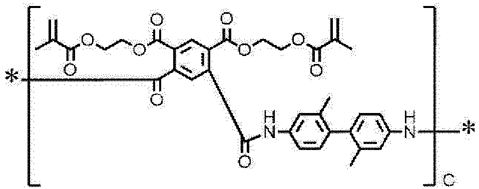

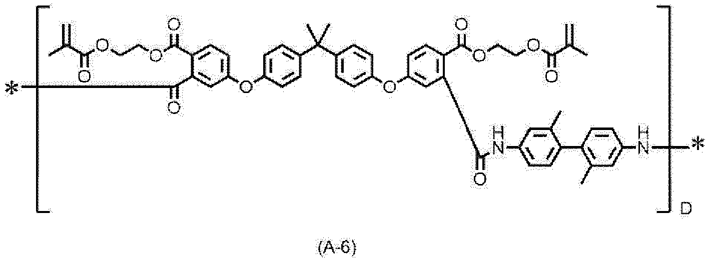

**[Table 1]**

| | Compositional ratio (in terms of molar ratio) |
|---|---|
| A-1 | A/B = 7/3 |
| A-2 | A/B = 8/2 |
| A-3 | A/B/C = 6/1/3 |
| A-4 | A/B = 6/4 |
| A-5 | A/B = 7/3 |
| A-6 | A/B/C/D = 3.5/1.5/3.5/1.5 |

### <Synthesis Example A-7: Synthesis of polyimide precursor A-7>

5.94 g (27.2 millimoles) of pyromellitic acid anhydride, 5.24 g (27.2 millimoles) of trimellitic acid anhydride, 7.08 g (13.6 millimoles) of 4,4'-(4,4'-isopropylidenediphenoxy)bis(phthalic acid anhydride), 17.8 g (137 millimoles) of 2-hydroxyethyl methacrylate, 0.05 g of hydroquinone, 22.8 g (289 millimoles) of pyridine, and 75 g of diglyme were mixed and stirred at a temperature of 60°C for 5 hours to produce a diester between each of pyromellitic acid anhydride and 4,4'-(4,4"-isopropylidenediphenoxy)bis(phthalic acid anhydride), and 2-hydroxyethyl methacrylate. Next, the mixture was cooled to -20°C, 17.70 g (141 millimoles) of thionyl chloride was subsequently added dropwise over 90 minutes, and stirring was carried out for 2 hours to obtain a white precipitate of pyridinium hydrochloride.

Next, a solution obtained by dissolving 21.1 g (66.0 millimoles) of 4,4'-diamino-2,2'-bis(trifluoromethyl)biphenyl in 100 mL of N-methyl-2-pyrrolidone (NMP) was added dropwise thereto over 2 hours. Next, 10.0 g (217 millimoles) of ethanol was added, and the mixture was stirred for 2 hours. The polyimide precursor was then precipitated in 4 L of water and the water-polyimide precursor mixture was stirred for 15 minutes at a speed of 500 rpm. The polyimide precursor was acquired by filtration, stirred again in 4 liters of water for 30 minutes, and filtered again. Next, the obtained polyimide precursor was dried at 45°C for 2 days under reduced pressure to obtain a polyimide precursor (A-7). The polyimide precursor (A-7) is a resin having three repeating units represented by Formula (A-7). The structure of the repeating unit was determined from a ¹H-NMR spectrum.

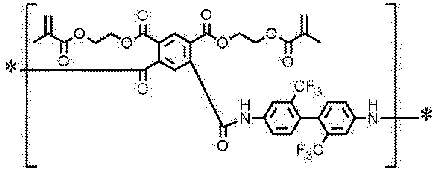

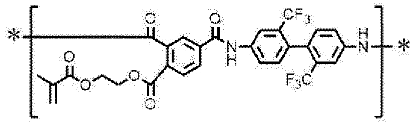

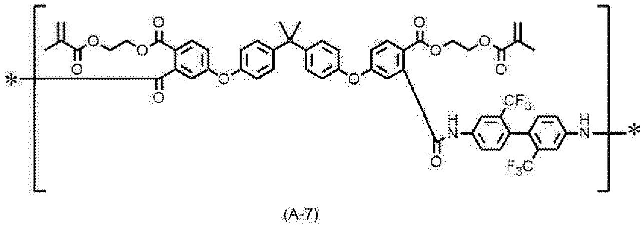

### <Synthesis Examples A-8 and A-9: Synthesis of polyimide precursor (A-8) and (A-9)>

Polyimide precursors (A-8) and (A-9) were synthesized by the same method as in the polyimide precursor (A-7), except that the carboxylic acid dianhydride to be used and the diamine to be used were appropriately changed. The polyimide precursors (A-8) and (A-9) are resins having repeating units represented by Formulae (A-8) and (A-9), respectively. The structure of the repeating unit was determined from a ¹H-NMR spectrum. In addition, the compositional ratio (in terms of molar ratio) of each of the polyimide precursors (A-7) to (A-9) is shown in the table below.

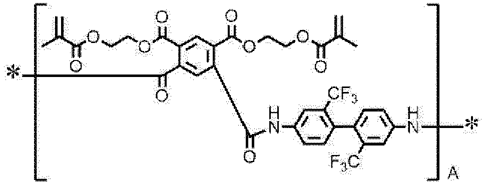

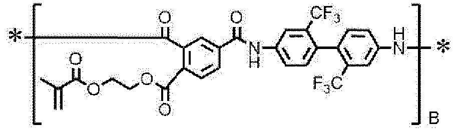

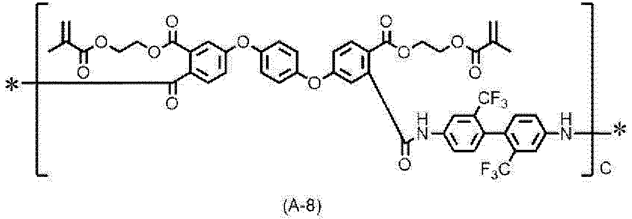

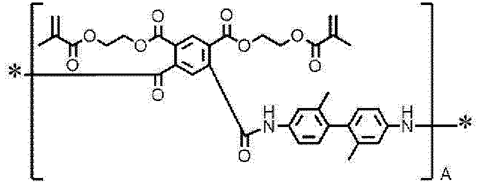

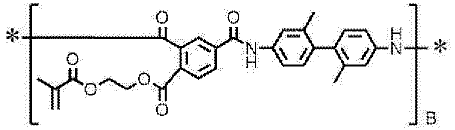

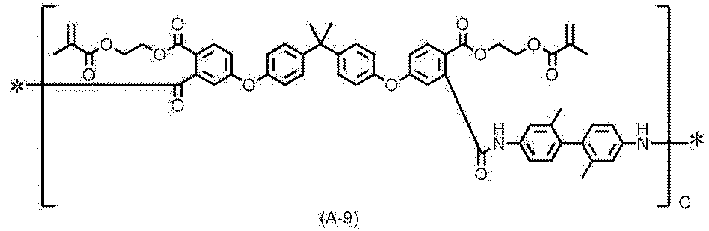

**[Table 2]**

| | Compositional ratio (in terms of molar ratio) |
|---|---|
| A-7 | A/B/C = 4/4/2 |
| A-8 | A/B/C = 4.5/4.5/1 |
| A-9 | A/B/C = 4/4/2 |

### <Synthesis Example A-10: Synthesis of polyimide (A-10)>

In a flask attached with a condenser and a stirrer, 10.4 g (47.6 millimoles) of pyromellitic acid anhydride and 10.6 g (20.4 millimoles) of 4,4'-(4,4'-isopropylidenediphenoxy)bis(phthalic acid anhydride) were dissolved in 125.0 g of N-methylpyrrolidone (NMP) while removing moisture. Next, 21.1 g (66.0 millimoles) of 4,4'-diamino-2,2'-bis(trifluoromethyl)biphenyl was added thereto, stirring was carried out at 25°C for 3 hours, and stirring was further carried out at 45°C for 3 hours. Next, 21.5 g (200 millimoles) of pyridine, 17.4 g (170 millimoles) of anhydrous acetic acid, and 100 g of N-methylpyrrolidone (NMP) were added thereto, stirring was carried out at 80°C for 3 hours, and 50 g of N-methylpyrrolidone (NMP) was added thereto to carry out dilution.

The reaction solution was subjected to precipitation in 1.5 L of methanol, and stirring was carried out at a speed of 3,000 rpm for 15 minutes. The resin was removed by filtration, stirring was carried out again in 1 liter of methanol for 30 minutes, and filtration was carried out again. The obtained resin was dried at 40°C for 1 day under reduced pressure to obtain a polyimide A-10.

The polyimide precursor (A-10) is a resin having a repeating unit represented by Formula (A-10). The structure of the repeating unit was determined from a ¹H-NMR spectrum. Here, the content ratio (in terms of molar ratio) between the respective repeating units is A/B = 7/3.

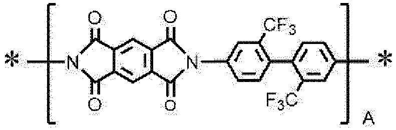

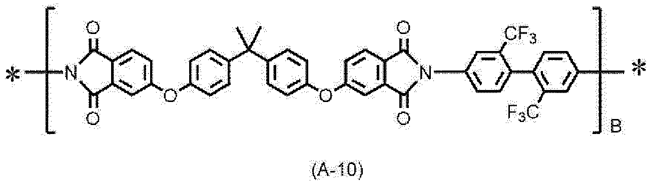

### <Synthesis Example P-1: Synthesis of polyimide precursor (P-1)>

21.2 g of 4,4'-oxydiphthalic acid dianhydride, 18.0 g of 2-hydroxyethyl methacrylate, 23.9 g of pyridine, and 250 mL of diglyme (diethylene glycol dimethyl ether) were mixed and stirred at a temperature of 60°C for 4 hours to synthesize a diester of 4,4'-oxydiphthalic acid and 2-hydroxyethyl methacrylate. Next, the reaction mixture was cooled to -10°C, and 17.0 g of thionyl chloride was added thereto over 60 minutes while maintaining the temperature at -10°C ± 5°C. After dilution with 50 mL of N-methylpyrrolidone, a solution obtained by dissolving 12.6 g of 4,4'-diaminodiphenyl ether in 100 mL of N-methylpyrrolidone was added dropwise to the reaction mixture over 60 minutes at -10 ± 5°C, and the resultant mixture was stirred at room temperature for 2 hours. Then, 10.0 g of ethanol was added thereto, and the resultant mixture was stirred at room temperature for 1 hour.

Next, 6,000 g of water was added to precipitate the polyimide precursor, and the precipitate (a water-polyimide precursor mixture) was stirred for 15 minutes. The precipitate (the solid of the polyimide precursor) after stirring was collected by filtration and dissolved in 500 g of tetrahydrofuran. 6,000 g of water (poor solvent) was added to the obtained solution to precipitate the polyimide precursor, and the precipitate (a water-polyimide precursor mixture) was stirred for 15 minutes. The precipitate (the solid of the polyimide precursor) after stirring was filtered again and dried at 45°C for 3 days under reduced pressure.

After dissolving 46.6 g of the powder after drying in 419.6 g of tetrahydrofuran, 2.3 g of triethylamine was added thereto, and the resultant mixture was stirred at room temperature for 35 minutes. Then, 3,000 g of ethanol was added thereto, and the precipitate was collected by filtration. The obtained precipitate was dissolved in 281.8 g of tetrahydrofuran. 17.1 g of water and 46.6 g of an ion exchange resin UP6040 (manufactured by AmberTec) were added thereto, and the resultant mixture was stirred for 4 hours. Thereafter, the ion exchange resin was removed by filtration, and the obtained polymer solution was added to 5,600 g of water to obtain a precipitate. The precipitate was collected by filtration and dried at 45°C under reduced pressure for 24 hours to obtain 45.1 g of a polyimide precursor (P-1).

The structure of the polyimide precursor (P-1) is a structure represented by Formula (P-1). The structure of the repeating unit was determined from a ¹H-NMR spectrum.

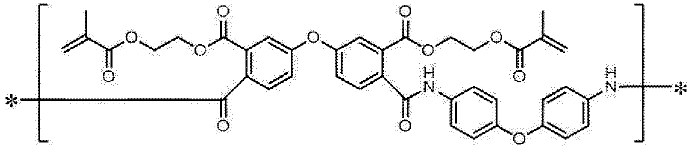

### <Synthesis Examples P-2 and P-4: Synthesis of polyimide precursors (P-2) and (P-4)>

Polyimide precursors (P-2) and (P-4) were synthesized by the same method as in the polyimide precursor (P-1), except that the carboxylic acid dianhydride to be used and the diamine to be used were appropriately changed. It is noted that in the synthesis of P-3, the following compound (AN-1) was used as a carboxylic acid dianhydride. The polyimide precursors (P-2) and (P-4) are resins having repeating units represented by Formulae (P-2) and (P-4), respectively. The structure of the repeating unit was determined from a ¹H-NMR spectrum.

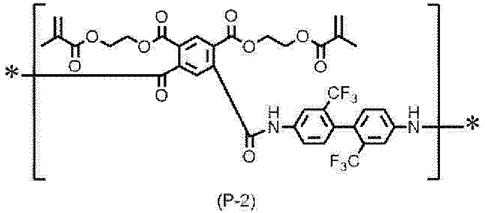

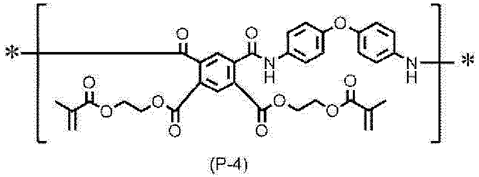

### <Synthesis Example AN-1: Synthesis of anhydride AN-1>

In a flask attached with a condenser, 51.8 g (246 millimoles) of anhydrous trimellitic acid chloride was dissolved in 150 mL of tetrahydrofuran, and cooling was carried out to -10°C. Subsequently, 19.9 g (252 millimoles) of pyridine and 0.73 g (6 millimoles) of 4-dimethylaminopyridine were added thereto. Subsequently, a solution obtained by dissolving 13.1 g (120 millimoles) of 4-aminophenol in 150 mL of tetrahydrofuran was added dropwise thereto over 2 hours using a dropping funnel, and stirring was carried out for 1 hour in a range of -10°C to 0°C. The temperature of the reaction solution was raised to 20°C to 25°C, and the reaction solution was further stirred for 3 hours and then diluted with 200 mL of acetonitrile. Subsequently, the reaction solution was subjected to crystallization in 3 L of a 1 N (mol/L) aqueous hydrochloric acid solution, the resultant crystals were filtered, washed with dilute hydrochloric acid and water, and then the crystals were collected and re-slurried with 500 mL of ethyl acetate. This was filtered and then transferred to a flask, 200 mL of anhydrous acetic acid was added thereto, stirring was carried out at 80°C for 3 hours, and filtration was carried out. Washing was carried out with ethyl acetate, and then vacuum drying was carried out at 60°C to obtain 35 g of an anhydride AN-1. It was confirmed to be AN-1 from a ¹H-NMR spectrum.

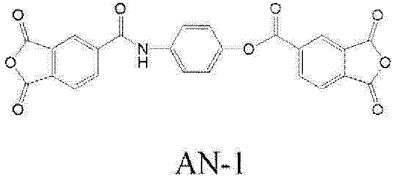

### [Synthesis Example P-3: Synthesis of polyimide precursor (P-3)]

20.5 g (43.6 millimoles) of the anhydride (AN-1) synthesized as described above, 11.5 g (88 millimoles) of 2-hydroxyethyl methacrylate, 0.03 g of hydroquinone, 15.3 g (193 millimoles) of pyridine, and 90 g of diglyme were mixed and stirred at a temperature of 60°C for 5 hours to produce a diester of the anhydride (AN-1) and 2-hydroxyethyl methacrylate. Next, the mixture was cooled to -20°C, 10.6 g (88 millimoles) of thionyl chloride was subsequently added dropwise over 90 minutes, and stirring was carried out for 2 hours to obtain a white precipitate of pyridinium hydrochloride.

Next, a solution obtained by dissolving 12.9 g (40 millimoles) of 4,4'-diamino-2,2'-bis(trifluoromethyl)biphenyl in 90 mL of N-methyl-2-pyrrolidone (NMP) was added dropwise thereto over 2 hours. Next, 10.0 g (217 millimoles) of ethanol was added, and the mixture was stirred for 2 hours. The polyimide precursor was then precipitated in 4 L of water and the water-polyimide precursor mixture was stirred for 15 minutes at a speed of 500 rpm. The polyimide precursor was acquired by filtration, stirred again in 4 liters of water for 30 minutes, and filtered again. Next, the obtained polyimide precursor was dried at 45°C for 2 days under reduced pressure to obtain a polyimide precursor (P-3). The polyimide precursors (P-3) is a resin having repeating unit represented by Formulae (P-3). The structure of the repeating unit was determined from a ¹H-NMR spectrum.

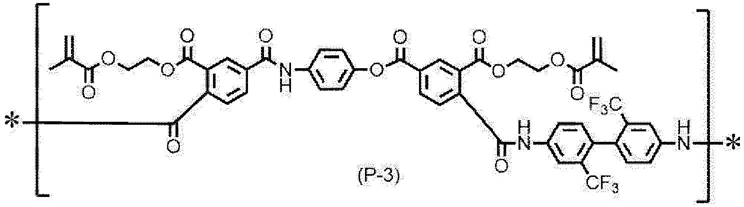

### <Examples and Comparative Examples>

In each of Examples, the components shown in the table below were mixed to obtain each of the resin compositions. Further, in each Comparative Example, components shown in the following table were mixed to obtain each of the comparative compositions.

Specifically, the content of each component described in the table was set to the amount (in terms of parts by mass) described in the column of "Adding amount" of each column of the table.

The obtained resin composition and the comparative composition were filtered under pressure using a filter made of ultra-high-molecular-weight polyethylene (UPE), having a micropore width of 0.2 µm.

In addition, in the table, the description of "-" indicates that the corresponding component is not contained in the composition.

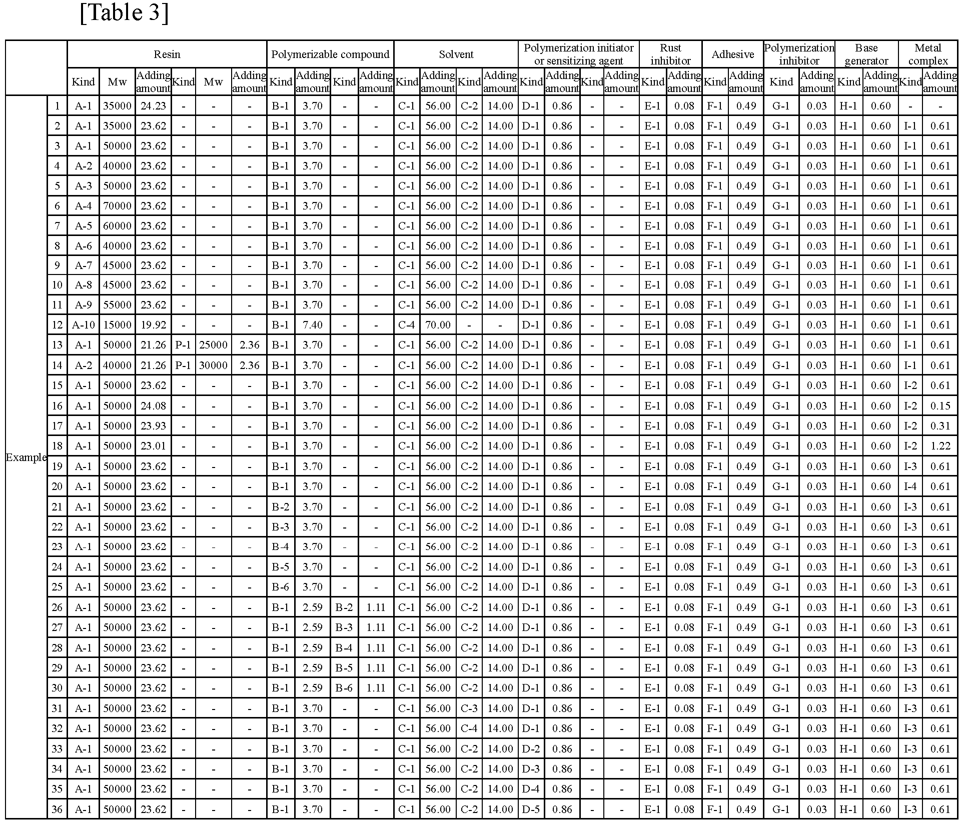

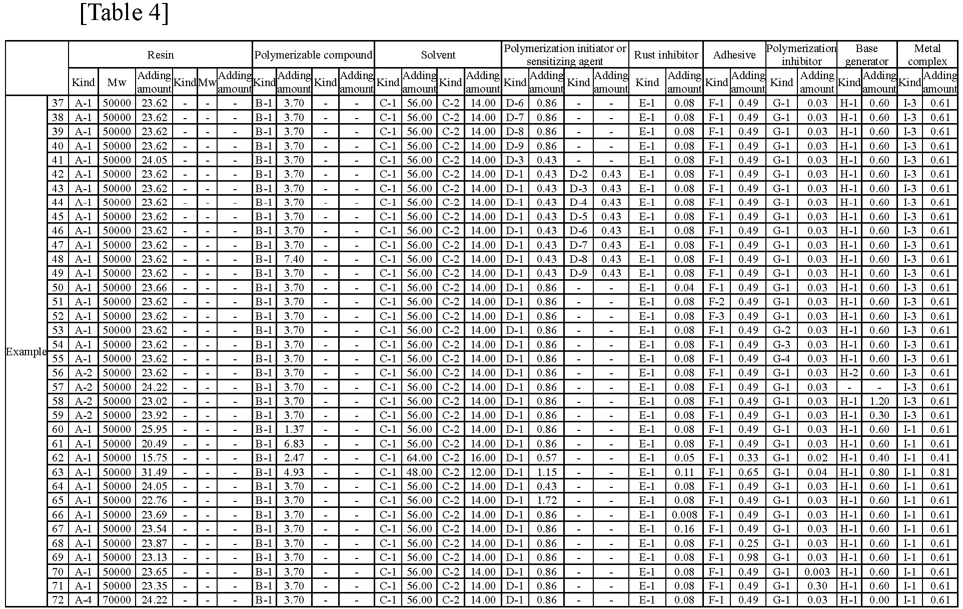

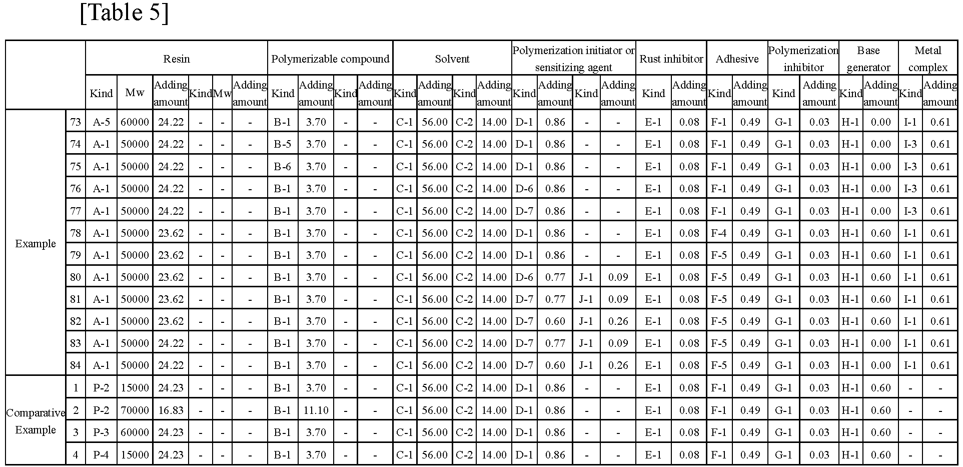

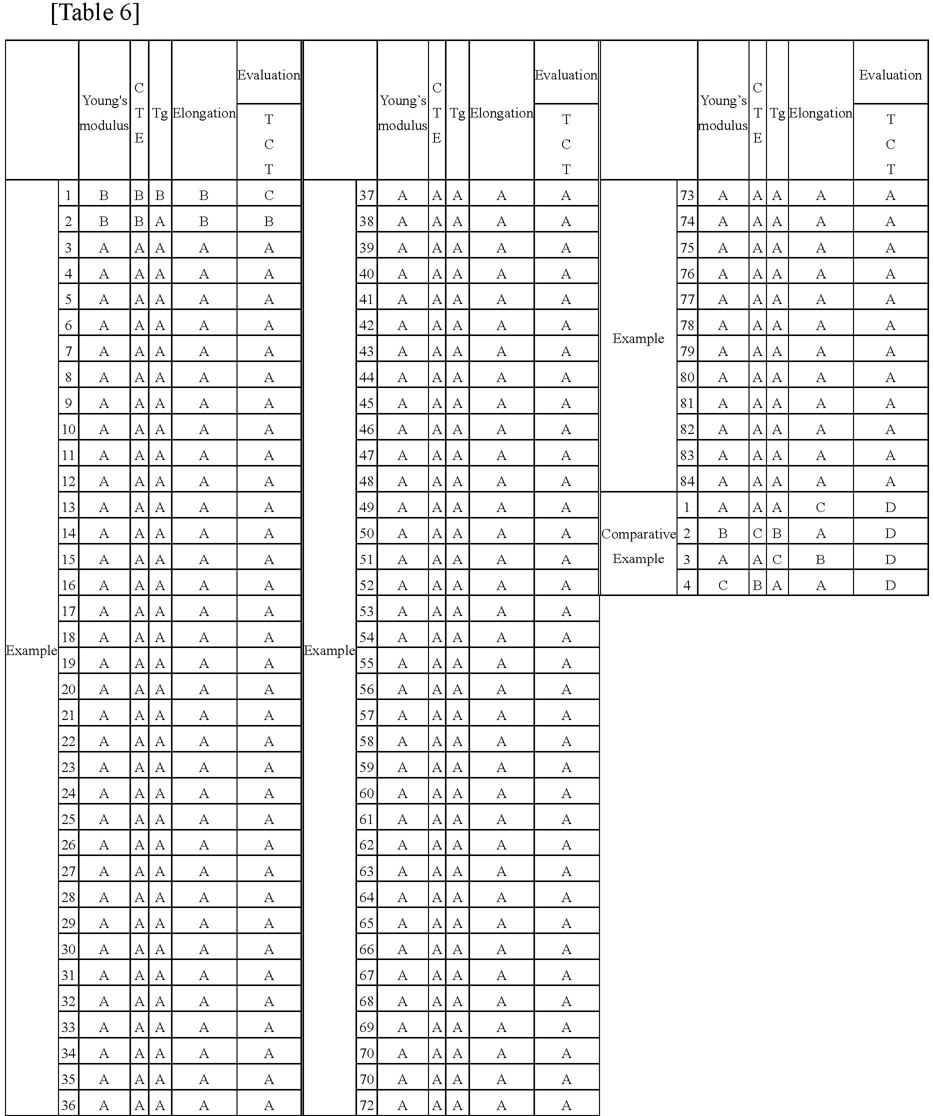

### Details of each of the components listed in the table are as follows.

### [Resin (polyimide precursor or polyimide)]

· A-1 to A-10: Polyimide precursors (A-1) to (A-9) and polyimide (A-10) which are synthesized as described above
· P-1 to P-4: Polyimide precursors (P-1) to (P-4) which are synthesized as described above

### [Polymerizable compound]

· B-1: SR-209 (manufactured by Sartomer Company Inc.)
· B-2: Dipentaerythritol hexaacrylate (manufactured by Shin-Nakamura Chemical Co., Ltd.)
· B-3 to B-6: Compounds having the following structures

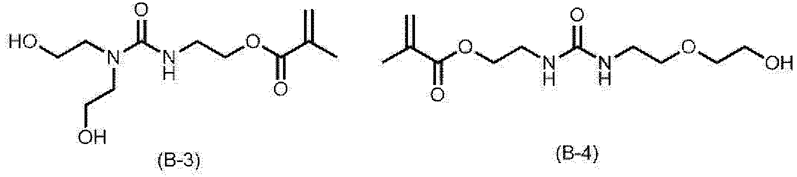

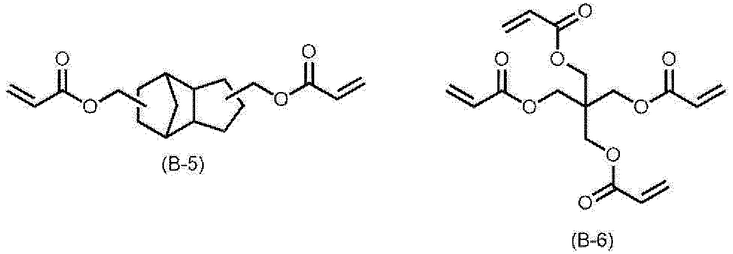

### [Solvent]

C-1: γ-butyrolactone
C-2: Dimethyl sulfoxide
C-3: Ethyl lactate
C-4: NMP

### [Polymerization initiator]

· D-1: IRGACURE OXE 01 (manufactured by BASF SE)
· D-2: IRGACURE OXE 02 (manufactured by BASF SE)
· D-3: Omnirad 1316 (manufactured IGM Resins B. V)
· D-4: Omnirad 1312 (manufactured IGM Resins B.V.)
· D-5: Omnirad TPO-S (manufactured by IGM Resins B.V.)
· D-6: TR-PBG-305 (manufactured by Tronly)
· D-7: TR-PBG-3057 (manufactured by Tronly)
· D-8 and D-9: Compounds having the following structures

The structures of the respective polymerization initiators are as follows.

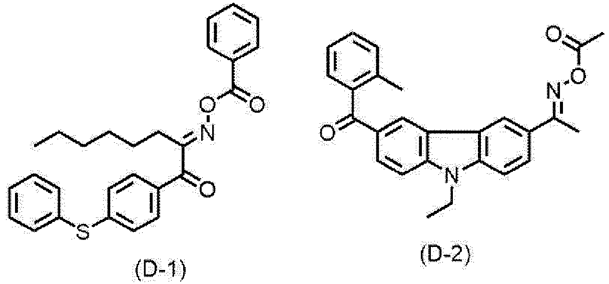

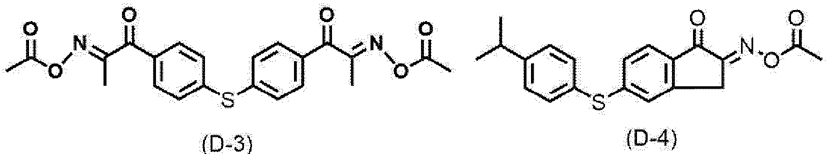

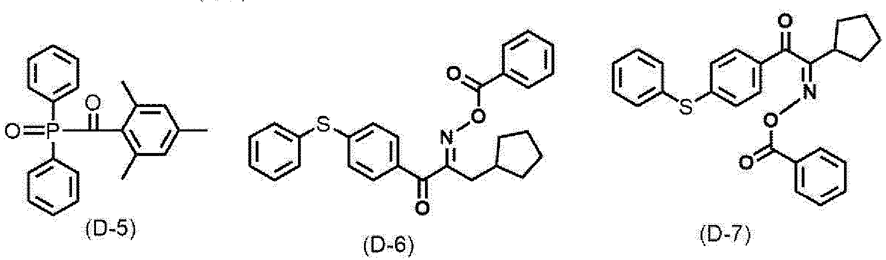

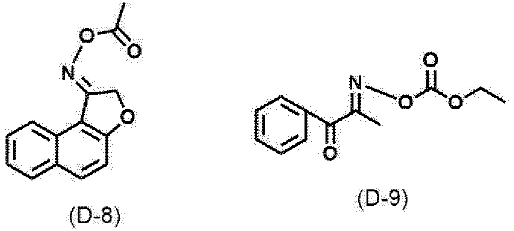

### [Sensitizing agent]

J-1: N-phenyldiethanolamine

### [Rust inhibitor (migration suppressing agent)]

· E-1: A compound having the following structure

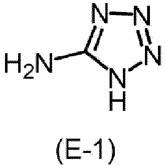

### [Adhesive (metal adhesiveness improving agent)]

· F-1: A compound having the following structure
· F-2: X-12-1293 (manufactured by Shin-Etsu Chemical Co., Ltd.)
· F-3: KR-513 (manufactured by Shin-Etsu Chemical Co., Ltd.)
· F-4 and F-5: Compounds having the following structures

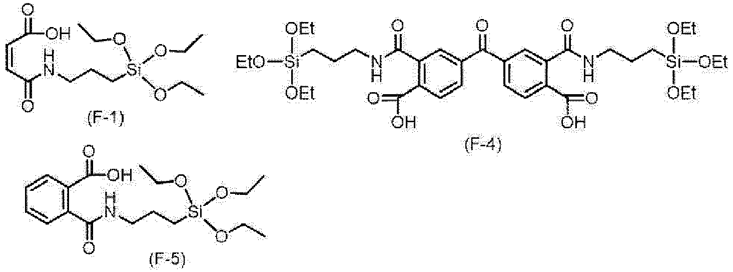

### [Polymerization inhibitor]

· G-1: 1,4-benzoquinone
· G-2: 4-methoxyphenol
· G-3: 1,4-dihydroxybenzene
· G-4: A compound having the following structure

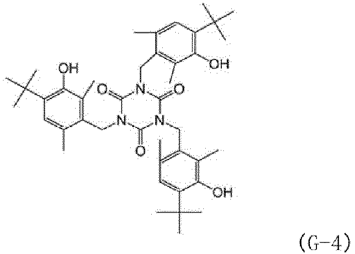

### [Base generator]

· H-1 and H-2: Compounds having the following structures

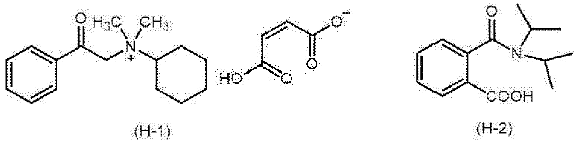

### [Metal complex]

· I-1 to I-4: Compounds having the following structures

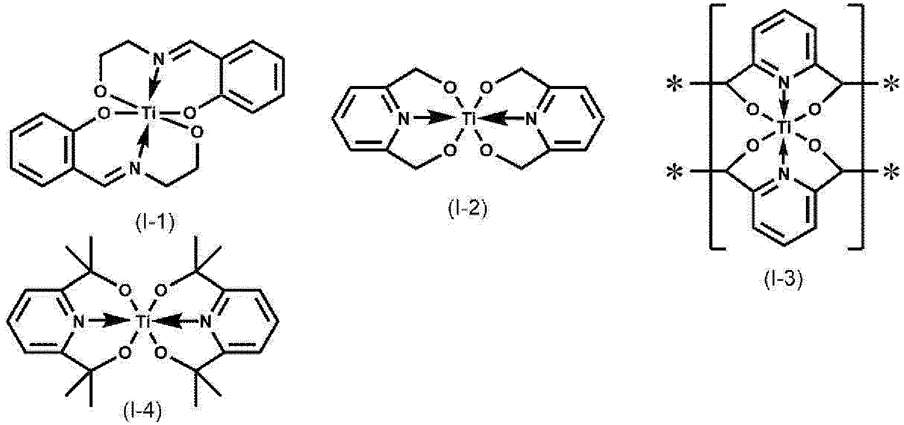

### <Measurement and evaluation>

### [Measurement of elongation (breaking elongation)]

Each of the resin compositions or comparative compositions in Examples and Comparative Examples was applied onto a silicon wafer by a spin coating method to form a resin composition layer. The obtained silicon wafer onto which the resin composition layer had been applied was dried on a hot plate at 100°C for 5 minutes, whereby a resin composition layer in which a film thickness after the film formation on the silicon wafer was a uniform thickness of 15 µm was obtained.

The obtained resin composition layer was exposed with an USHIO exposure machine (light source: 500 W/m², ultra-high pressure mercury lamp) using a dumbbell-shaped mask at an exposure energy of 400 mJ/cm². The dumbbell shape was set to a dumbbell-shape No. 7 shape, which is described in JIS K 6251: 2017.

The resin composition layer (resin layer) after the exposure was developed with cyclopentanone for 2 minutes and rinsed with PGMEA for 30 seconds to remove the non-exposed portion. Further, the temperature was raised at a temperature rising rate of 10 °C/min in a nitrogen atmosphere, and heating was carried out at 230°C for 3 hours. The resin layer (cured substance) after curing was immersed in a 4.9% by mass aqueous hydrofluoric acid solution, and a cured substance (test piece) having a dumbbell shape was peeled off from the silicon wafer (specimen width: 2 mm, specimen length: 35 mm). Regarding the obtained test piece, the elongation of the test piece in the longitudinal direction was measured in accordance with JIS-K7161-1 (2014) in an environment of 25°C and a relative humidity (RH) of 65% using a tensile tester (manufactured by Instron, model: 5965) at a crosshead speed of 5 mm/min. The evaluation was carried out six times for each sample, and the arithmetic average value of the elongation at the time when the test piece was broken was used as an index value. The evaluation was carried out according to the following evaluation standards based on the index value, and the evaluation results are described in the column of "Moldability" in the table.

### - Evaluation standards -

A: The index value was 50% or more.
B: The index value was 40% or more and less than 50%.
C: The index value was less than 40%.

### [Measurement of Young's modulus]

The Young's modulus of the test piece created for the measurement of the elongation was measured in accordance with JIS-K7161-1 (2014) in an environment of 25°C and a relative humidity (RH) of 65% using DMA850 (TA Instruments) at a crosshead speed of 5 mm/min. The obtained Young's modulus was evaluated according to the following evaluation standards, and the evaluation results were described in the column of "Young's modulus" in the table.

### - Evaluation standards -

A: The Young's modulus was 4.5 GPa or more.
B: The Young's modulus was 3.5 GPa or more and less than 4.5 GPa.
C: The Young's modulus was less than 3.5 GPa.

### [Measurement of CTE]

The CTE of the test piece created as described above at 25°C to 125°C was measured with TMA450 (TA Instruments).

The temperature rising and falling conditions at the time of evaluation were set to, for example, the following (1) to (4).
(1) The temperature is raised from room temperature to 130°C at a temperature rising rate of 5 °C/min.
(2) The temperature is allowed to fall from 130°C to 10°C at a temperature-lowering rate of 5 °C/min.
(3) The temperature is raised from 10°C to 220°C at a temperature rising rate of 5 °C/min.
(4) Natural cooling is carried out to room temperature.

In the above-described temperature rising and falling processes (1) to (4), the elongation (displacement) of the specimen was measured, and a calculation was carried out to determine a value obtained by dividing the elongation (displacement) of the specimen at 25°C and 125°C in the process (3) by the temperature, where the value was defined as the coefficient of thermal expansion.

(Example: In a case where the length of the specimen at 25°C was 50 mm, and the length of the specimen at 125°C was 50.2 mm, the displacement was calculated as 0.4% = 4,000 ppm, and the coefficient of thermal expansion was calculated as 4,000/(125 - 25) = 40 ppm/°C,)

The obtained CTE was evaluated according to the following evaluation standards, and the evaluation results were described in the column of "CTE" in the table.

### - Evaluation standards -

A: CTE was less than 40 ppm/°C.
B: CTE was 40 ppm/°C or more and less than 50 ppm/°C.
C: CTE was 50 ppm/°C or more.

### [Measurement of Tg]

The Tg of the test piece created as described above was measured with DMA850 (TA Instruments).

Specifically, the temperature conditions of the cured substance were changed in the order of the following (1) and (2), and the glass transition temperature was measured.
(1) The temperature was raised from 25°C to 350°C at a rate of 5°C/min.
(2) Cooling was carried out from 350°C to 25°C.

The obtained Tg was evaluated according to the following evaluation standards, and the evaluation results were described in the column of "Tg" in the table.

### - Evaluation standards -

A: Tg was 260°C or higher.
B: Tg was 240°C or higher and lower than 260°C.
C: Tg was lower than 240°C.

In the measurement of the elongation, the measurement of the Young's modulus, the measurement of the CTE, and the measurement of the Tg, the above-described exposure and development were omitted, and then each measurement was carried out using a test piece obtained by punching out the test piece having a dumbbell shape from the cured substance after peeling with a puncher. However, all the evaluation results were the same in all Examples and Comparative Examples.

### [Evaluation of TCT crack resistance]

In each of Examples and Comparative Examples, the resin composition or the comparative composition was applied, by a spin coating method, onto a silicon wafer on which a Cu wiring line having a line and space (L/S) of 10 µm was formed, whereby a resin composition layer was formed. The obtained silicon wafer onto which the resin composition layer had been applied was dried on a hot plate at 100°C for 5 minutes, whereby a resin composition layer having a uniform thickness such that a film thickness after the film formation on the silicon wafer was a thickness of 15 µm was obtained.

The obtained resin composition layer on the entire surface of the silicon wafer was exposed with an USHIO exposure machine (light source: 500 W/m², ultra-high pressure mercury lamp) at an exposure energy of 400 mJ/cm².

The temperature of the resin composition layer after the exposure was raised at a temperature rising rate of 10 °C/min in a nitrogen atmosphere and heated at 230°C for 3 hours to obtain a cured substance.

The obtained cured substance was subjected to a TCT test (ES-57L manufactured by Hitachi Global Life Solutions, Inc., repetition of -55°C and 200°C for 1,000 cycles), and the presence or absence of the occurrence of cracking at the interface between the Cu wiring line and the cured substance was observed with a scanning electron microscope (S-4800, manufactured by Hitachi High-Tech Corporation.

### (Evaluation standards)

A: 10 positions were observed, and the occurrence of cracking was observed at 0 positions.
B: 10 positions were observed, and the occurrence of cracking was observed at 1 position.
C: 10 positions were observed, and the occurrence of cracking was observed at 2 or 3 positions.
D: 10 positions were observed, and the occurrence of cracking was observed at all of the 10 portions.

### <Examples 101 to 159>

In Examples 1 to 59, the resin composition layer in the evaluation of the TCT crack resistance was exposed using, as a light source in carrying out exposure, a stepper (FPA-3000 i5 (manufactured by CANON INC.)) or a direct exposure device (ADTEC DE-6UH III) instead of the USHIO exposure machine, and the TCT crack resistance was evaluated without making a change for other test methods. In any of Examples, the same results as those of Examples 1 to 84 were obtained.

### [Evaluation of resolution]

The resin composition used in each Example was applied, in a layer shape by a spin coating method, onto a surface of a thin copper layer of the resin base material having a surface on which the thin copper layer was formed and then dried at 100°C for 5 minutes. A resin composition layer having a film thickness of 7 µm after film formation was formed and then exposed using a stepper (FPA-3000 i5 (manufactured by Canon Inc.)). The exposure was carried out at a wavelength of 365 nm through a hole pattern mask of 7 µm. Subsequently, Development was carried out with cyclopentanone for 2 minutes, rinsing was carried out with PGMEA for 30 seconds, the temperature was raised at a temperature rising rate of 10 °C/min in a nitrogen atmosphere, and heating was carried out at 230°C for 3 hours to obtain a hole pattern of 7 µm.

The resin composition according to the embodiment of the present invention can be used as a high-definition interlayer insulating film having excellent resolution.

Similar results were obtained even in a case where γ-butyrolactone was used instead of cyclopentanone.

From the above results, it can be seen that the film formed from the resin composition according to the embodiment of the present invention is excellent in TCT crack resistance.

In the comparative compositions according to Comparative Examples 1 to 4, one of the Young's modulus, the CTE, the Tg, or the elongation deviates from the definition in the resin composition according to the embodiment of the present invention. It can be seen that these comparative compositions have poor adhesiveness after the TCT.

### [Evaluation of resolution]

The resin composition used in each Example was applied, in a layer shape by a spin coating method, onto a surface of a thin copper layer of the resin base material having a surface on which the thin copper layer was formed and then dried at 100°C for 5 minutes. A resin composition layer having a film thickness of 7 µm after film formation was formed and then exposed using a stepper (FPA-3000 i5 (manufactured by Canon Inc.)). The exposure was carried out at a wavelength of 365 nm through a hole pattern mask of 7 µm. Subsequently, Development was carried out with cyclopentanone for 2 minutes, rinsing was carried out with PGMEA for 30 seconds, the temperature was raised at a temperature rising rate of 10 °C/min in a nitrogen atmosphere, and heating was carried out at 230°C for 3 hours to obtain a hole pattern of 7 µm.

The resin composition according to the embodiment of the present invention can be used as a high-definition interlayer insulating film having excellent resolution.

Similar results were obtained even in a case where γ-butyrolactone was used instead of cyclopentanone.

### Explanation of References

1: semiconductor device
2: semiconductor chip
2a: terminal
3: sealing material
4: re-distribution layer
5: wiring line
6: interlayer insulating film
7: external connection terminal

## Claims

1. A resin composition comprising:
a polyimide or a polyimide precursor,
wherein a film-shaped cured substance having a thickness of 15 µm, which is obtained by heating the resin composition at 230°C for 3 hours, satisfies all of the following condition (i) to condition (iv),
condition (i): a Young's modulus of the cured substance is 3.5 GPa or more,
condition (ii): a coefficient of thermal expansion of the cured substance in a temperature range of 25°C to 125°C is less than 50 ppm/°C,
condition (iii): a glass transition temperature of the cured substance is 240°C or higher, and
condition (iv): a breaking elongation of the cured substance is 40% or more.

2. The resin composition according to claim 1,
wherein the cured substance satisfies all of the following condition (v) to condition (viii),
condition (v): the Young's modulus of the cured substance is 4.5 GPa or more, condition (vi): the coefficient of thermal expansion of the cured substance in a temperature range of 25°C to 125°C is less than 40 ppm/°C,
condition (vii): the glass transition temperature of the cured substance is 260°C or higher, and
condition (viii): the breaking elongation of the cured substance is 50% or more.

3. The resin composition according to claim 1 or 2, further comprising:
a metal complex having a π-conjugated moiety containing a nitrogen atom.

4. The resin composition according to any one of claims 1 to 3,
wherein the polyimide precursor contains a repeating unit represented by Formula (1), 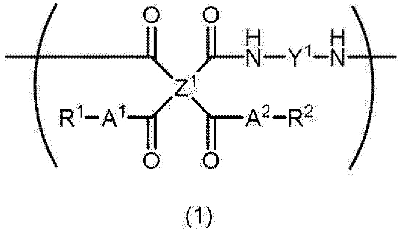 in Formula (1), Z¹ is a tetravalent organic group that includes two or more ether groups and an aromatic ring structure, Y¹ is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.

5. A resin composition comprising:
a polyimide precursor containing a repeating unit represented by Formula (1); and
a metal complex having a π-conjugated moiety containing a nitrogen atom, 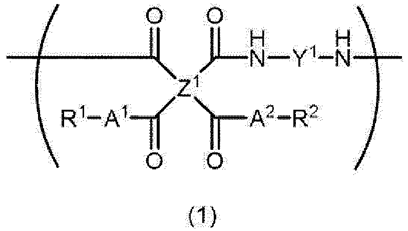 in Formula (1), Z¹ is a tetravalent organic group that includes two or more ether groups and an aromatic ring structure, Y¹ is a divalent organic group, A¹ and A² each independently represent an oxygen atom or -NR^{Z}-, R^{Z} is a hydrogen atom or a monovalent organic group, R¹ and R² each independently represent a hydrogen atom or a monovalent organic group, and at least one of R¹ or R² is a monovalent organic group having an ethylenically unsaturated bond.

6. The resin composition according to claim 4 or 5,
wherein Z¹ in Formula (1) is a group represented by Formula (a) or Formula (b), 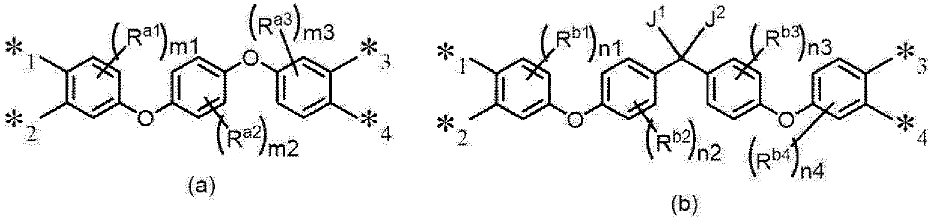
In Formula (a), R^{a1}'s each independently represent a monovalent group, m1 represents an integer of 0 to 3, R^{a2}'s each independently represent a monovalent group, m2 represents an integer of 0 to 4, R^{a3}'s each independently represent a monovalent group, m3 represents an integer of 0 to 3, and *1 to *4 each represent a bonding site to a carbonyl group in Formula (1).
In Formula (b), R^{b1}'s each independently represent a monovalent group, n1 represents an integer of 0 to 3, R^{b2}'s each independently represent a monovalent group, n2 represents an integer of 0 to 4, R^{b3}'s each independently represent a monovalent group, n3 represents an integer of 0 to 4, R^{b4}'s each independently represent a monovalent group, n4 represents an integer of 0 to 3, J¹ and J² each independently represent a hydrogen atom, an alkyl group, or a trifluoromethyl group, and *1 to *4 each represent a bonding site to a carbonyl group in Formula (1).

7. The resin composition according to any one of claims 4 to 6,
wherein Y¹ in Formula (1) is a divalent organic group represented by Formula (Y-1), 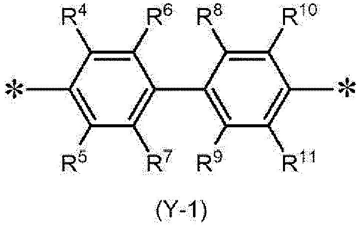 in Formula (Y-1), R⁴ to R¹¹ each independently represent a hydrogen atom or a monovalent group, at least one of R⁴, ..., or R¹¹ is an alkyl group, a fluorine atom, a trifluoromethyl group, or an alkoxy group, R⁶ and R⁸, or R⁷ and R⁹ may be bonded to each other to form a ring structure, and *'s each represent a bonding site to a nitrogen atom in Formula (1).

8. The resin composition according to claim 3 or 5,
wherein the metal complex includes a partial structure represented by Formula (1-1) as a structure including the π-conjugated moiety containing the nitrogen atom, 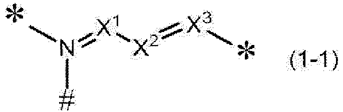 in Formula (1-1), X¹ to X³ each independently represent -C(-*)= or -N=, *'s each represent a bonding site to another structure, and # represents a bonding site to a metal atom.

9. The resin composition according to any one of claims 1 to 8,
wherein a weight-average molecular weight of the polyimide precursor is 40,000 or more.

10. The resin composition according to any one of claims 1 to 9, further comprising:
a polymerizable compound; and
a photopolymerization initiator.

11. The resin composition according to any one of claims 1 to 10,
wherein the resin composition is used for forming an interlayer insulating film for a re-distribution layer.

12. A cured substance that is obtained by curing the resin composition according to any one of claims 1 to 11.

13. A laminate comprising:
two or more layers consisting of the cured substance according to claim 12; and
a metal layer provided between any of the layers consisting of the cured substance.

14. A manufacturing method for a cured substance, comprising:
a film forming step of applying the resin composition according to any one of claims 1 to 11 onto a base material to form a film.

15. The manufacturing method for a cured substance according to claim 14, further comprising:
an exposure step of selectively exposing the film; and
a development step of developing the film using a developer to form a pattern.

16. The manufacturing method for a cured substance according to claim 14 or 15, further comprising:
a heating step of heating the film at 50° to 450°C.

17. A manufacturing method for a laminate, comprising:
the manufacturing method for a cured substance according to any one of claims 14 to 16.

18. A manufacturing method for a semiconductor device, comprising:
the manufacturing method for a cured substance according to any one of claims 14 to 16; or
the manufacturing method for a laminate according to claim 17.

19. A semiconductor device comprising:
the cured substance according to claim 12; or
the laminate according to claim 13.

20. A cured substance that satisfies all of the following condition (i) to condition (iv);
condition (i): a Young's modulus of the cured substance is 3.5 GPa or more, condition (ii): a coefficient of thermal expansion of the cured substance in a temperature range of 25°C to 125°C is less than 50 ppm/°C,
condition (iii): a glass transition temperature of the cured substance is 240°C or higher, and
condition (iv): a breaking elongation of the cured substance is 40% or more.

21. A semiconductor device comprising:
a semiconductor chip; and
a re-distribution layer,
wherein the re-distribution layer includes a wiring line and an interlayer insulating film for a re-distribution layer, the interlayer insulating film satisfying all of the following condition (i) to condition (iv),
condition (i): a Young's modulus of the interlayer insulating film for a re-distribution layer is 3.5 GPa or more,
condition (ii): a coefficient of thermal expansion of the interlayer insulating film for a re-distribution layer in a temperature range of 25°C to 125°C is less than 50 ppm/°C,
condition (iii): a glass transition temperature of the interlayer insulating film for a re-distribution layer is 240°C or higher, and
condition (iv): a breaking elongation of the interlayer insulating film for a re-distribution layer is 40% or more.

22. The semiconductor device according to claim 21, further comprising:
a sealing material that covers the semiconductor chip,
wherein an area of the re-distribution layer in planar view is larger than an area of the semiconductor chip.
